# EUROPEAN PATENT APPLICATION

(11) **EP 2 861 042 A1**
(43) Date of publication of application: **15.04.2015**
(21) Application number: 13804257.7
(22) Date of filing: 12.06.2013
(51) Int. Cl.: H05B 33/06, H01L 51/50, H05B 33/04, H05B 33/26, F21Y 105/00

(54) **ORGANIC ELECTROLUMINESCENCE ELEMENT AND ILLUMINATION DEVICE**

(30) Priority: 12.06.2012 JP 2012133083; 11.09.2012 JP 2012199899
(71) Applicant: Panasonic Intellectual Property Management Co., Ltd., Osaka-shi, Osaka 540-6207 (JP)
(72) Inventor: SATO, Toshihiko, Shiromi 2-chome, Chuo-ku Osaka-shi Osaka 540-6207 (JP); SANAGAWA, Yoshiharu, Shiromi 2-chome, Chuo-ku Osaka-shi Osaka 540-6207 (JP); HOUZUMI, Shingo, Shiromi 2-chome, Chuo-ku Osaka-shi Osaka 540-6207 (JP); KAWAHITO, Keiko, Shiromi 2-chome, Chuo-ku Osaka-shi Osaka 540-6207 (JP); TSUJI, Koji, Shiromi 2-chome, Chuo-ku Osaka-shi Osaka 540-6207 (JP); KIRIHARA, Masao, Shiromi 2-chome, Chuo-ku Osaka-shi Osaka 540-6207 (JP)
(74) Representative: Müller-Boré & Partner Patentanwälte PartG mbB
(86) International application number: PCT/JP2013/003698
(87) International publication number: WO 2013/187065

(57) **Abstract**

The organic electroluminescence element includes: a substrate **1;** an organic light emitter **10** formed on a surface of the substrate **1** and including a first electrode **7,** an organic light emitting layer **8,** and a second electrode **9** in this order; and an enclosing member 2 bonded to the substrate **1** to enclose the organic light emitter **10** by covering it. The element further includes: an extended electrode part **5** electrically connected to the first electrode **7** and/or the second electrode **9** and extending outward across the enclosing member **2** to be on a surface of an end part of the substrate **1;** and an electrode piece **3** serving as an interconnection electrode **11** and provided on an opposite side of the enclosing member **2** from the substrate **1.** The electrode piece **3** includes an extension part fixed to the extended electrode part **5** to make electric connection between the electrode piece **3** and the extended electrode part **5.**

## Description

### Technical Field

The present invention relates to an organic electroluminescence element and an illumination device including the organic electroluminescence element.

### Background Art

Recently, organic electroluminescence elements (hereinafter also referred to as "organic EL elements") have been applied to light emitting panels or the like. As such organic EL elements, an organic EL element in which a light transmissive first electrode (anode), an organic layer constituted by layers including a light emitting layer, and a second electrode (cathode) are stacked on a surface of a light transmissive substrate in this order has been known. In the organic EL element, when a voltage is applied between the anode and the cathode, light is generated in the light emitting layer and emerges outside via the light transmissive layer and the light transmissive substrate.

### Citation List

### Patent Literature

Patent Literature 1 JP 2009-217984 A

### Summary of Invention

### Technical Problem

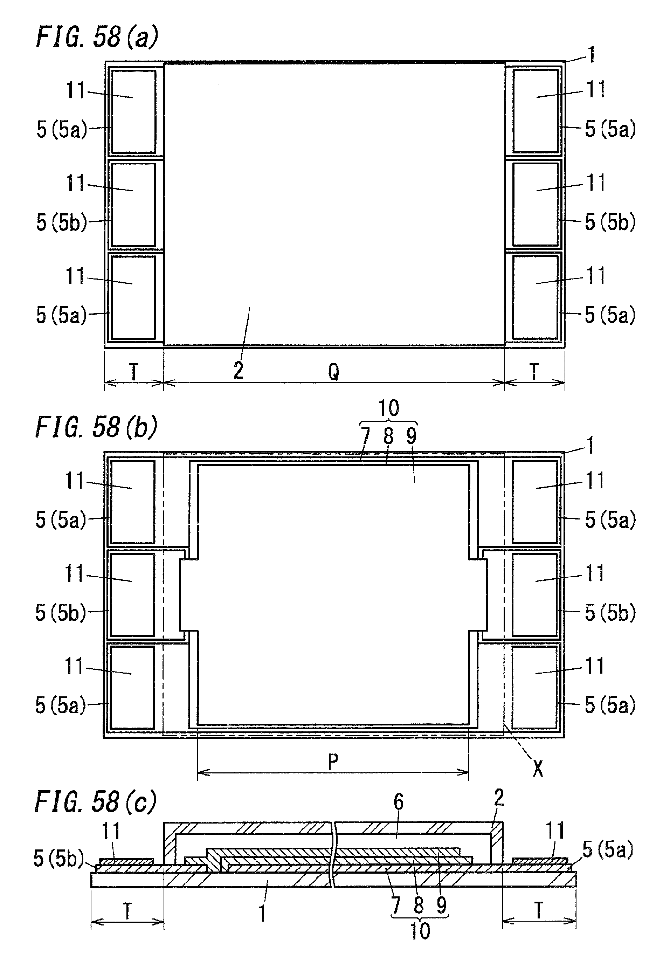

**FIG. 58** illustrates an example of an organic EL element of background art. In this organic EL element, an organic light emitter **10** which includes a first electrode **7,** an organic light emitting layer **8,** and a second electrode **9** in this order is formed on a surface of the substrate **1.** The organic light emitter **10** is enclosed by being covered with an enclosing member **2** bonded to the substrate **1.** When the organic EL element is viewed in a direction perpendicular to the surface of the substrate **1,** that is, in a plan view, a light emitting region is defined as a region in which the first electrode **7,** the organic light emitting layer **8,** the second electrode **9** are stacked. Further, a region enclosed by the enclosing member **2** is defined as an enclosed region in a plan view. In **FIG. 58****,** the light emitting region is represented as a region **P.** Further, the enclosed region is represented as a region **Q**, and a non-enclosed region which is a region outside the enclosed region is represented as a region **T.**

As shown in **FIG. 58(b)** and **FIG. 58(c)****,** in the organic EL element, a transparent electrically conductive layer with a desired pattern is formed on the surface of the substrate **1,** and a central region of this conductive layer with the desired pattern defines the first electrode **7.** Further, the organic light emitter **10** is formed by stacking the organic light emitting layer **8** and the second electrode **9** on the surface of the first electrode 7. Further, the organic light emitter **10** is enclosed by the enclosing member **2.** In **FIG. 58(b)****,** an outline of the enclosing member **2** is indicated by a dashed-two dotted line X.

In this regard, in the organic EL element, to supply electricity to the organic light emitting layer **8** through the first electrode **7** and the second electrode **9,** generally, extended electrode part **5** electrically connected to the individual electrodes is formed on an end part of the organic EL element, and electricity is supplied to the extended electrode part **5.** The extended electrode part **5** is constituted by a first extended electrode part **5a** electrically connected to the first electrode **7,** and a second extended electrode part **5b** electrically connected to the second electrode **9.** To clearly illustrate the element structure, in **FIG. 58(c)****,** the end part close to the first extended electrode part **5a** is illustrated on the right side, and the end part close to the second extended electrode part **5b** is illustrated on the left side.

On a surface of each extended electrode part **5,** an interconnection electrode **11** is formed. The interconnection electrode **11** is provided to the non-enclosed region (region **T)** defined as a part of the surface of the substrate **1** which protrudes outward relative to the enclosing member **2.** Further, by connecting an external power source to the interconnection electrodes **11,** supply of electricity to the organic light emitting layer **8** is allowed. The interconnection electrode **11** is an electrode terminal to be electrically connected to the external power source, and has high electrically conductivity and durability to electric connecting such as wire bonding. By providing the interconnection electrode **11,** connectability with the external power source can be improved.

However, when the interconnection electrode **11** is disposed to extend to the end part of the substrate, the interconnection electrode **11** forms a part of a non-light emitting region, and a proportion of the non-light emitting region is likely to increase. Additionally, to make electric connection such as wire bonding connection, the interconnection electrode **11** is required to have a certain region area, and hence it is difficult to decrease the width of the interconnection electrode **11.** When the interconnection electrode **11** occupies the outer peripheral space, the non-light emitting region is formed at an outer periphery of the organic EL element to have a frame shape. An increase in the proportion of the non-light emitting region causes a decrease in a proportion of an in-plane light emission area to the total area of the organic EL element, and consequently an in-plane effective light emitting rate is likely to decrease.

Patent literature 1 discloses a technique of increasing the light emitting area of the organic EL element by a structure in which a hole is provided to an enclosing plate and an external terminal is inserted into the hole to be connected to an electrode. However, according to the method of this literature, it is necessary to form the hole in the enclosing plate and then insert the external hole into the hole. Hence, there is a problem in which the production of the element becomes difficult. Further, the non-light emitting region is formed outward relative to the hole of the enclosing plate, and therefore it may be difficult to increase the light emitting region efficiently. Further, a junction of the external terminal and the electrode hides in the hole, and therefore it is difficult to check the degree of contact between the external terminal and the electrode and it may be difficult to ensure sufficient connection reliability.

In view of the above insufficiency, the present invention has aimed to propose the organic electroluminescence element and the illumination device which have a high proportion of the light emitting area and can be easily produced and have excellent connection reliability.

### Solution to Problem

The organic electroluminescence element in accordance with the present invention includes: a substrate with a surface; an organic light emitter which is formed on the surface of the substrate and includes a first electrode, an organic light emitting layer, and a second electrode in this order from the substrate; and an enclosing member which is bonded to the substrate to enclose the organic light emitter by covering the organic light emitter. The organic electroluminescence element further includes: an extended electrode part which is electrically connected to at least one of the first electrode and the second electrode and extends outward across the enclosing member so as to be on a surface of an end part of the substrate; and at least one electrode piece which serves as an interconnection electrode and is provided on an opposite side of the enclosing member from the substrate. The at least one electrode piece includes an extension part fixed to the extended electrode part so that the at least one electrode piece is electrically connected to the extended electrode part.

In a preferable embodiment of the above organic electroluminescence element, a plurality of the electrode pieces provided to opposite end parts of the substrate, and the plurality of electrode pieces are arranged in different positions in a horizontal direction in a plan view.

In another preferable embodiment of the above organic electroluminescence element, an electrically insulating barrier member is provided to a side part of the substrate, and the electrically insulating barrier member protrudes in a direction normal to the surface of the substrate relative to the extended electrode part.

In another preferable embodiment of the above organic electroluminescence element, the electrically insulating barrier member does not protrude in a direction normal to the surface of the substrate with regard to an opposite face of the substrate from a face to which the enclosing member is bonded.

In another preferable embodiment of the above organic electroluminescence element, a plurality of the electrode pieces are provided to a plurality of end parts of the substrate, and the electrically insulating barrier member is provided to a side part of the substrate at a position of the end part with regard to half or more of the plurality of end parts of the substrate.

In another preferable embodiment of the above organic electroluminescence element, a plurality of the electrode pieces are provided to a plurality of end parts of the substrate, and the electrically insulating barrier member is provided to a side part of the substrate corresponding to a position of the end part with regard to all of the plurality of end parts of the substrate.

In another preferable embodiment of the above organic electroluminescence element, a space between the electrically insulating barrier member and the enclosing member is filled with resin.

In another preferable embodiment of the above organic electroluminescence element, the electrically insulating barrier member protrudes in a direction normal to the surface of the substrate more than the at least one electrode piece.

In another preferable embodiment of the above organic electroluminescence element, at least an outside surface of the extension part of the at least one electrode piece which extends towards the substrate is covered with an electrically insulating cover.

In another preferable embodiment of the above organic electroluminescence element, the electrically insulating cover has a thickness of 0.1 mm or more.

In another preferable embodiment of the above organic electroluminescence element, the electrically insulating cover protrudes towards the substrate relative to a front end of the extension part of the at least one electrode piece.

In another preferable embodiment of the above organic electroluminescence element, the organic electroluminescence element further includes a space which is provided to the extension part of the at least one electrode piece, the electrically insulating cover, or between the at least one electrode piece and the electrically insulating cover, and has an opening directed to the substrate.

In another preferable embodiment of the above organic electroluminescence element, an electrically insulating protrusion of the electrically insulating cover which protrudes relative to a front end of the extension part of the at least one electrode piece extends outward.

In another preferable embodiment of the above organic electroluminescence element, the extension part of the at least one electrode piece is fixed to the extended electrode part so as to be pressed against the extended electrode part.

In another preferable embodiment of the above organic electroluminescence element, the extension part of the at least one electrode piece is fixed to the extended electrode part by an electrically conductive fixer made of electrically conductive paste.

In another preferable embodiment of the above organic electroluminescence element, the electrically conductive fixer is formed so as to be in contact with a surface of the extension part of the at least one electrode piece close to the enclosing member.

In another preferable embodiment of the above organic electroluminescence element, the electrically conductive fixer is formed so as to be in contact with a side face of the enclosing member.

In another preferable embodiment of the above organic electroluminescence element, the at least one electrode piece is fixed to the enclosing member by an electrically conductive bond made of electrically conductive paste.

In another preferable embodiment of the above organic electroluminescence element, the electrically conductive fixer and the electrically conductive bond are interconnected.

In another preferable embodiment of the above organic electroluminescence element, an interconnection electrode extension part is provided to a surface of the enclosing member, and the at least one electrode piece is bonded to the interconnection electrode extension part by the electrically conductive bond.

In another preferable embodiment of the above organic electroluminescence element, the organic electroluminescence element further includes a wiring board on a surface of the enclosing member. An interconnection electrode extension part is provided to a surface of the wiring board. The at least one electrode piece is electrically connected to the interconnection electrode extension part by an electrically conductive connector.

In another preferable embodiment of the above organic electroluminescence element, the interconnection electrode extension part is provided to a surface of the wiring board close to the enclosing member, and the interconnection electrode extension part is disposed in a position overlapping the enclosing member in a plan view.

In another preferable embodiment of the above organic electroluminescence element, the interconnection electrode extension part is disposed more inward than the at least one electrode piece in a plan view.

In another preferable embodiment of the above organic electroluminescence element, the at least one electrode piece and the interconnection electrode extension part are electrically interconnected by a flexible electric conductor constituting the electrically conductive connector.

In another preferable embodiment of the above organic electroluminescence element, an electrically insulating wall with electrically insulating properties is provided outside the extended electrode part with regard to the substrate.

In another preferable embodiment of the above organic electroluminescence element, a stepped part is formed at a boundary part between the surface and a side face of the substrate so as to be positioned more outward than the extended electrode part, the electrically insulating wall is formed in contact with a surface of the stepped part, and the electrically conductive fixer is in contact with the electrically insulating wall.

In another preferable embodiment of the above organic electroluminescence element, the at least one electrode piece has a stress relaxation structure for relaxing stress in a direction parallel to the surface of the substrate.

In another preferable embodiment of the above organic electroluminescence element, the stress relaxation structure is realized by an opening provided to the at least one electrode piece.

In another preferable embodiment of the above organic electroluminescence element, the stress relaxation structure is realized by a cut-out provided to the at least one electrode piece.

In another preferable embodiment of the above organic electroluminescence element, the stress relaxation structure is realized by a plurality of cut-outs provided to the at least one electrode piece, and the plurality of cut-outs are provided so that the at least one electrode piece includes an S-shaped part.

In another preferable embodiment of the above organic electroluminescence element, the stress relaxation structure is realized by a wavy structure provided to the at least one electrode piece.

In another preferable embodiment of the above organic electroluminescence element, the stress relaxation structure is realized by a bend which is part of the at least one electrode piece and defines a border between a part along a direction normal to the surface of the substrate and a part along a direction parallel to the surface of the substrate and protrudes outward from a surface of the at least one electrode piece.

In another preferable embodiment of the above organic electroluminescence element, the at least one electrode piece is formed so as to bend to be in contact with a surface and a side face of the enclosing member.

In another preferable embodiment of the above organic electroluminescence element, the at least one electrode piece includes a terminal protruding outward relative to a position at which the at least one electrode piece is fixed to the extended electrode part.

In another preferable embodiment of the above organic electroluminescence element, the at least one electrode piece and the extended electrode part are connected by crushing a plurality of protrusions with electrically conductive properties at a boundary part therebetween.

In another preferable embodiment of the above organic electroluminescence element, the at least one electrode piece and the extended electrode part are connected with an elastic member with electrically conductive properties being compressed at or near a boundary part therebetween.

In another preferable embodiment of the above organic electroluminescence element, the at least one electrode piece is formed as a single part.

In another preferable embodiment of the above organic electroluminescence element, the at least one electrode piece is bonded to an opposite surface of the enclosing member from the substrate.

In another preferable embodiment of the above organic electroluminescence element, the at least one electrode piece is fixed by being supported by an electrode piece supporter provided to an opposite surface of the enclosing member from the substrate.

In another preferable embodiment of the above organic electroluminescence element, the at least one electrode piece has a plate spring structure, and an extension part of the at least one electrode piece is pressed against the extended electrode part by force caused by the plate spring structure.

The illumination device in accordance with the present invention is an illumination device including the above organic electroluminescence element.

### Advantageous Effects of Invention

According to the present invention, it is possible to obtain the organic electroluminescence element and the illumination device which have a high proportion of the light emitting area and can be easily produced and have excellent connection reliability.

### Brief Description of Drawings

**FIG. 1(a)** and **FIG. 1(b)** relate to an example of an embodiment of an organic electroluminescence element, and the former is a plan view and the latter is a sectional view.
**FIG. 2(a)** and **FIG. 2(b)** relate to an example of the embodiment of the organic electroluminescence element, and the former is a perspective view and the latter is an exploded perspective view.
**FIG. 3(a)** is an enlarged sectional view illustrating an example of a production process of the organic electroluminescence element, and **FIG. 3(b)** is an enlarged sectional view illustrating an example of the organic electroluminescence element.
**FIG. 4(a)** is an enlarged sectional view illustrating an example of a production process of the organic electroluminescence element, and **FIG. 4(b)** is an enlarged sectional view illustrating an example of the embodiment of the organic electroluminescence element.
**FIG. 5** is an enlarged sectional view illustrating an example of the embodiment of the organic electroluminescence element.
**FIG. 6** is an enlarged sectional view illustrating an example of the embodiment of the organic electroluminescence element.
**FIG. 7** is an enlarged sectional view illustrating an example of the embodiment of the organic electroluminescence element.
**FIG. 8** is an enlarged sectional view illustrating an example of the embodiment of the organic electroluminescence element.
**FIG. 9** is an enlarged sectional view illustrating an example of the embodiment of the organic electroluminescence element.
**FIG. 10** is an enlarged sectional view illustrating an example of the embodiment of the organic electroluminescence element.
**FIG. 11(a)** and **FIG. 11(b)** relate to an example of the embodiment of the organic electroluminescence element, and the former is an enlarged sectional view and the latter is a partial plan view.
**FIG. 12** is an enlarged sectional view illustrating an example of the embodiment of the organic electroluminescence element.
**FIG. 13** is an enlarged sectional view illustrating an example of the embodiment of the organic electroluminescence element.
**FIG. 14** is an enlarged sectional view illustrating an example of the embodiment of the organic electroluminescence element.
**FIG. 15** is a sectional view illustrating an example of the embodiment of the organic electroluminescence element.
**FIG. 16** is an enlarged sectional view illustrating an example of the embodiment of the organic electroluminescence element.
**FIG. 17** is an enlarged sectional view illustrating an example of the embodiment of the organic electroluminescence element.
**FIG. 18** is an enlarged sectional view illustrating an example of the embodiment of the organic electroluminescence element.
**FIG. 19** is an enlarged sectional view illustrating an example of the embodiment of the organic electroluminescence element.
**FIG. 20** is an enlarged sectional view illustrating an example of the embodiment of the organic electroluminescence element.
**FIG. 21** is a partial perspective view illustrating an example of the embodiment of the organic electroluminescence element.
**FIG. 22(a)** is a partial perspective view illustrating an example of a production process of the organic electroluminescence element, and **FIG. 22(b)** is a partial perspective view illustrating an example of the embodiment of the organic electroluminescence element.
**FIG. 23** is a partial perspective view illustrating an example of the embodiment of the organic electroluminescence element.
**FIG. 24** is an enlarged sectional view illustrating an example of the embodiment of the organic electroluminescence element.
**FIG. 25** is an enlarged sectional view illustrating an example of the embodiment of the organic electroluminescence element.
**FIG. 26** is an enlarged sectional view illustrating an example of the embodiment of the organic electroluminescence element.
**FIG. 27** is an enlarged sectional view illustrating an example of the embodiment of the organic electroluminescence element.
**FIG. 28** is a plan view illustrating an example of an embodiment of an illumination device.
**FIG. 29(a)** is a plan view illustrating an example of the embodiment of the organic electroluminescence element, and **FIG. 29(b)** is an enlarged plan view illustrating an example of the embodiment of the illumination device.
**FIG. 30** is an enlarged sectional view illustrating an example of the embodiment of the organic electroluminescence element.
**FIG. 31(a)** and **FIG. 31(b)** relate to an example of the embodiment of the organic electroluminescence element, and **FIG. 31(a)** is a perspective view, and **FIG. 31(c)** is a sectional view, and **FIG. 31(c)** is an enlarged sectional view illustrating an example of the embodiment of the illumination device.
**FIG. 32(a)** and **FIG. 32(b)** relate to an example of the embodiment of the organic electroluminescence element, and **FIG. 32(a)** is a perspective view, and **FIG. 32(b)** is a sectional view, and **FIG. 32(c)** is an enlarged sectional view illustrating an example of the embodiment of the illumination device.
**FIG. 33** is an enlarged sectional view illustrating an example of the embodiment of the organic electroluminescence element.
**FIG. 34(a)** and **FIG. 34(b)** relate to an example of the embodiment of the illumination device, and the former is an enlarged sectional view and the latter is an enlarged plan view.
**FIG. 35** is an enlarged sectional view illustrating an example of the embodiment of the organic electroluminescence element.
**FIG. 36** is an enlarged sectional view illustrating an example of the embodiment of the organic electroluminescence element.
**FIG. 37** is an enlarged sectional view illustrating an example of the embodiment of the organic electroluminescence element.
**FIG. 38** is an enlarged sectional view illustrating an example of the embodiment of the organic electroluminescence element.
**FIG. 39** is an enlarged sectional view illustrating an example of the embodiment of the organic electroluminescence element.
**FIG. 40** is an enlarged sectional view illustrating an example of the embodiment of the organic electroluminescence element.
**FIG. 41** is an enlarged sectional view illustrating an example of the embodiment of the organic electroluminescence element.
**FIG. 42** is an enlarged sectional view illustrating an example of the embodiment of the organic electroluminescence element.
**FIG. 43** is an enlarged sectional view illustrating an example of the embodiment of the organic electroluminescence element.
**FIG. 44(a)** is a perspective view illustrating an example of an electrode piece, and **FIG. 44(b)** and **FIG. 44(c)** relate to an example of the embodiment of the organic electroluminescence element, and **FIG. 44(b)** is an enlarged plan view, and **FIG. 44(c)** is an enlarged side view.
**FIG. 45(a), FIG. 45(b),** and **FIG. 45(c)** are perspective views illustrating examples of the electrode piece.
**FIG. 46(a)** is an enlarged plan view illustrating an example of the embodiment of the organic electroluminescence element, and **FIG. 46(b)** is an enlarged side view illustrating an example of the embodiment of the organic electroluminescence element.
**FIG. 47(a)** is a perspective view illustrating an example of the electrode piece, and
**FIG. 47(b)** and **FIG. 47(c)** relate to an example of the embodiment of the organic electroluminescence element, and **FIG. 47(b)** is an enlarged plan view, and **FIG. 47(c)** is an enlarged side view.
**FIG. 48(a)** is a perspective view illustrating an example of the electrode piece, and
**FIG. 48(b)** and **FIG. 48(c)** relate to an example of the embodiment of the organic electroluminescence element, and **FIG. 48(b)** is an enlarged plan view, and **FIG. 48(c)** is an enlarged side view.
**FIG. 49(a), FIG. 49(b),** and **FIG. 49(c)** relate to an example of the embodiment of the organic electroluminescence element, and the first is an enlarged sectional view, and the second is an enlarged plan view, and the last is an enlarged side view.
**FIG. 50** is an enlarged sectional view illustrating an example of the embodiment of the organic electroluminescence element.
**FIG. 51** is an enlarged sectional view illustrating an example of the embodiment of the organic electroluminescence element.
**FIG. 52** is an enlarged sectional view illustrating an example of the embodiment of the organic electroluminescence element.
**FIG. 53** is an enlarged sectional view illustrating an example of the embodiment of the organic electroluminescence element.
**FIG. 54** is an enlarged sectional view illustrating an example of the embodiment of the organic electroluminescence element.
**FIG. 55** is an enlarged sectional view illustrating an example of the embodiment of the organic electroluminescence element.
**FIG. 56** is an enlarged sectional view illustrating an example of the embodiment of the organic electroluminescence element.
**FIG. 57** is an enlarged sectional view illustrating an example of the embodiment of the organic electroluminescence element.
**FIG. 58(a), FIG. 58(b),** and **FIG. 58(c)** relate to an example of an organic electroluminescence element of background art, and the first is a plan view, and the second is an exploded perspective view, and the last is a sectional view.

### Description of Embodiments

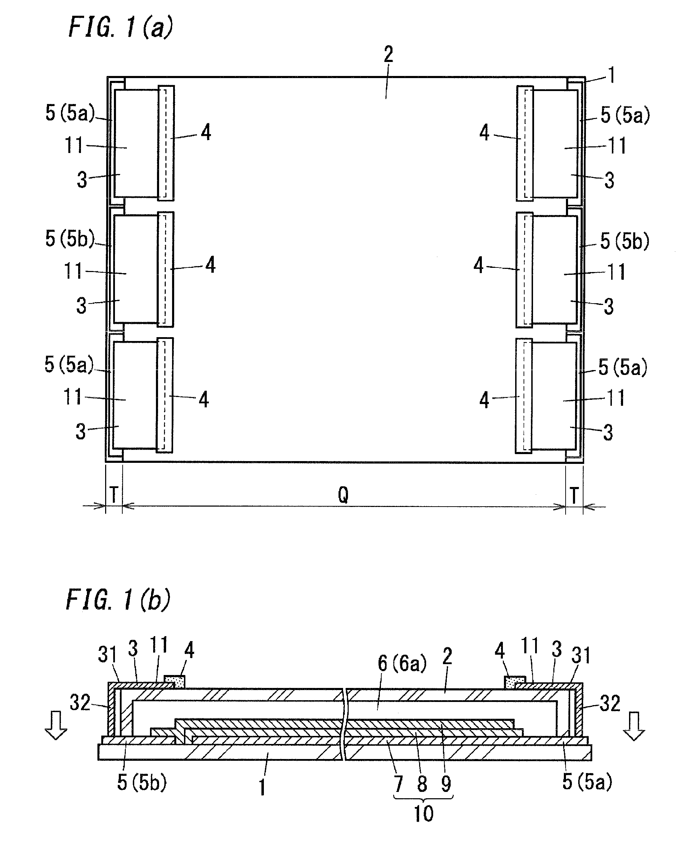

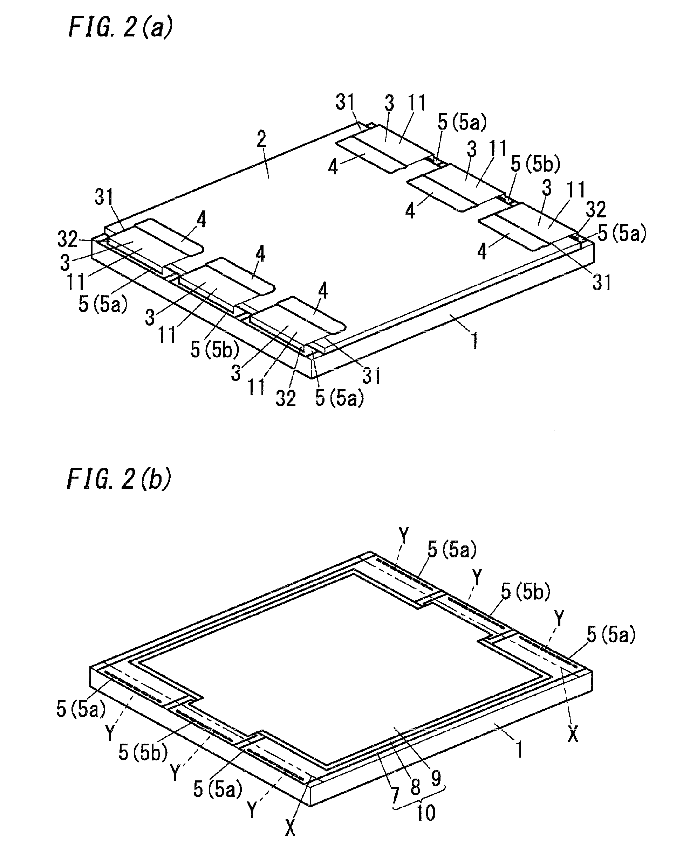

**FIG.** 1 and **FIG. 2** show an example of an embodiment of an organic electroluminescence element (organic EL element). In **FIG. 1(a)****,** an enclosed region which is a region enclosed by an enclosing member **2** is represented by a region **Q,** and a non-enclosed region which is a region outside this enclosed region is represented by a region T. Further, in **FIG. 1(a)****,** concealed part of electrode pieces **3** are denoted by broken lines. In a section of **FIG. 1(b)****,** to facilitate understanding of an element structure, an end part close to a first extended electrode part **5a** is illustrated on a right side, and an end part close to a second extended electrode part **5b** is illustrated on a left side. Further, in **FIG. 2(b)****,** an outer limit of the enclosing member **2** is represented by a dashed-two dotted line X.

As shown in **FIG. 1(b)** and **FIG. 2(b)****,** in the organic EL element, an organic light emitter **10** is formed on a surface of a substrate **1,** and includes a first electrode **7,** an organic light emitting layer **8,** and a second electrode **9** in this order from the surface of the substrate **1.** The organic light emitter **10** is enclosed by being covered with the enclosing member **2** bonded to the substrate **1.** In the organic EL element, an extended electrode part **5** which is electrically connected to at least one of the first electrode **7** and the second electrode **9** and extends outward from the enclosing member **2** so as to be on a surface of an end part of the substrate **1.** Further, an interconnection electrode **11** is provided to an opposite side of the enclosing member **2** from the substrate **1.** The interconnection electrode **11** is constituted by the electrode piece **3.** Additionally, an extension part of the electrode piece **3,** that is a part of the electrode piece 3 extending toward the end part of the element so as to protrude outward from the enclosing member **2,** is fixed to the extended electrode part 5, and thereby the electrode piece **3** and the extended electrode part **5** are electrically interconnected.

In the present specific embodiment, the interconnection electrode **11** is not provided to a region of the end part of the substrate **1** but is provided to a surface on an opposite side of the enclosing member **2** from the substrate **1,** and consequently there is no need to form a space for providing the interconnection electrode **11** at the end part of the substrate. Thus, it is possible to decrease a width of the non-enclosed region (region **T),** and thus it is possible to decrease a proportion of a non-light emitting region at an outer limit part and increase a proportion of a light emitting region, and thereby increase a proportion of a light emitting area of the element. Further, the electrode piece **3** is directly or indirectly fixed to the substrate **1,** and thereby electrical conductivity between the electrode piece **3** and the extended electrode part **5** can be kept high. Further, the electrode piece **3** is used, and thereby it is possible to easily realize the interconnection electrode **11** by attaching the electrode piece **3.** As a result, the organic EL element of the present specific embodiment has the high proportion of the light emitting area, and can be easily produced, and has high connection reliability. Hereinafter, the organic EL element of the present specific embodiment is further described.

The substrate **1** is preferably a transparent substrate **1** with light transmissive properties, and may be a glass substrate. In a case where the substrate **1** is constituted by a glass substrate, it is possible to prevent intrusion of moisture into the inside of the enclosed region because glass has low moisture permeability. A light outcoupling layer may be provided at an interface between the surface of the substrate **1** and the first electrode **7.** By providing the light outcoupling layer, light outcoupling efficiency can be improved. The light outcoupling layer may be selected from a resin layer with a higher refractive index than glass, a resin layer containing light scattering particles, and a layer of high refractive index glass. In the present specific embodiment, the substrate 1 has a rectangular shape.

The organic light emitter **10** is a stack of the first electrode **7,** the organic light emitting layer **8** and the second electrode **9.** A region to which the organic light emitter **10** is provided is a region of a central part of the substrate **1** in a plan view (when viewed in a direction perpendicular to the surface of the substrate). In the organic EL element, the region to which the organic light emitter **10** is provided in the plan view defines the light emitting region (see a region **P** in **FIG. 58(b)****).**

The first electrode **7** and the second electrode **9** define a pair of electrodes, and one of them serves as an anode and the other serves as a cathode. In the present specific embodiment, the first electrode **7** serves as the anode and the second electrode **9** serves as the cathode, and however, the first electrode **7** may serve as the cathode and the second electrode **9** may serve as the anode. The first electrode **7** preferably has light transmissive properties. In this case, the first electrode **7** defines an electrode for allowing light to emerge. The first electrode **7** may be constituted by a transparent electrically conductive layer. The electrically conductive layer may be made of ITO, IZO, or the like. Further, the second electrode **9** may have light reflective properties. In this case, light emitted from the light emitting layer towards the second electrode **9** can emerge outside from the substrate **1** by being reflected by the second electrode **9.** Alternatively, the second electrode **9** may be an electrode with light transmissive properties. In a case where the second electrode **9** has light transmissive properties, it is possible to obtain a structure which allows light to emerge outside from a surface facing the enclosing member **2.** Alternatively, in a case where the second electrode **9** has light transmissive properties, by providing a light reflective layer to an opposite surface of the second electrode **9** from the organic light emitting layer **8,** flight emitted from the light emitting layer towards the second electrode **9** can emerge outside from the substrate **1** by being reflected. The second electrode **9** can be made of, for example, Al or Ag. Thicknesses of the first electrode **7** and the second electrode **9** are not limited particularly, and can be in a range of 10 to 300 nm, for example.

The organic light emitting layer **8** is a layer with a function of producing light, and is constituted by two or more functional layers appropriately selected from hole injection layers, hole transport layers, light emitting layers (layers containing light emitting material), electron transport layers, electron injection layers, interlayers, and the like. A thickness of the organic light emitting layer **8** is not limited particularly, and may be in a range of 60 to 300 nm, for example.

In the organic EL element, when a voltage is applied between the first electrode **7** and the second electrode **9,** recombination of holes and electrons occurs in the organic light emitting layer **8** (light emitting material containing layer) and thus light is produced. In view of this, there is need to provide electrodes electrically connected to the first electrode **7** and the second electrode **9** individually by extending them to the end part of the substrate. The extended electrodes are to be electrically connected to the interconnection electrodes **11** serving as terminals to be electrically connected to external electrodes. In the present specific embodiment, to allow application of a voltage across the organic light emitting layer **8,** the extended electrode parts **5** electrically connected to the first electrode **7** and the second electrode **9** are provided to the surface of the substrate **1.**

The extended electrode parts **5** are formed on the surface of the end part of the substrate **1.** The extended electrode parts **5** include the first extended electrode part **5a** electrically connected to the first electrode **7** and the second extended electrode part **5b** electrically connected to the second electrode **9.** In the present specific embodiment, the extended electrode part **5** is made of an electrically conductive layer constituting the first electrode **7.**

The first extended electrode part **5a** is formed by extending the electrically conductive layer constituting the first electrode **7** toward the end part of the substrate **1** without being cut so as to protrude outside. In other words, with regard to the end part to which the first extended electrode part **5a** is provided, the electrically conductive layer constituting the first electrode **7** is formed so as to extend outward from the enclosing member **2** and reach the end part of the substrate **1.** By extending the first extended electrode part **5a** electrically connected to the first electrode **7** outward from the enclosed region, it is possible to make electrical connection between the outside of the enclosed region and the inside of the element. As described above, according to a method of forming the first extended electrode part **5a** by extending the first electrode **7,** the formation of the first extended electrode part **5a** is facilitated.

Further, in the present specific embodiment, the second extended electrode part **5b** is formed by separating a part of the electrically conductive layer for forming the first electrode **7** from the first electrode **7** and extending the separated part toward the end part of the substrate **1** so as to protrude outside. In other words, the electrically conductive layer constituting the second extended electrode part **5b** is separated from the first electrode **7,** and is formed so as to extend outward from the enclosing member **2** and reach the end part of the substrate **1.** By extending the second extended electrode part **5b** electrically connected to the second electrode **9** outward from the enclosed region, it is possible to make electrical connection between the outside of the enclosed region and the inside of the element. According to a method of forming the second extended electrode part **5b** by patterning the electrically conductive layer, the formation of the second extended electrode part **5b** is facilitated. The second extended electrode part **5b** is in contact with the second electrode **9** of the stack inside the element, and therefore a structure in which the second extended electrode part **5b** and the second electrode **9** are interconnected is formed.

**FIG. 1** shows the embodiment in which the extended electrode part **5** is formed inside an area slightly smaller than the outline of the substrate **1.** However, the extended electrode part **5** may extend to reach the peripheral edge of the substrate **1.** When the peripheral edge of the extended electrode part **5** and the peripheral edge of the substrate **1** are at the same position, the non-enclosed region can be more decreased, and therefore non-light emitting region at the end part of the substrate can be more reduced. Further, an illumination device can be formed by arranging a plurality of organic EL elements in a planar manner. In this case, when the extended electrode part **5** is formed to reach the peripheral edge of the substrate **1,** it becomes easy that the organic EL elements can be electrically connected by making electrical connection at desired parts. Alternatively, it is also preferable that the extended electrode part **5** is not formed to reach the peripheral edge of the substrate **1.** When the extended electrode part **5** is not formed to reach the peripheral edge of the substrate **1,** it is possible to ensure a sufficient insulation distance between adjacent organic EL elements, and failure caused by short-circuit can be suppressed.

The first electrode **7,** the first extended electrode part **5a** and the second extended electrode part **5b** may be made of the same electrically conductive material. By doing so, it is possible to easily produce the organic EL element. The electrically conductive layer for the first electrode **7** may be made of transparent metal oxide, for example. Specifically, for example, this electrically conductive layer may be made of ITO. The thickness of the electrically conductive layer is not limited particularly, and may be in a range of 0.01 to 0.5 µm. Preferably, the thickness of this electrically conductive layer is in a range of about 0.1 to 0.2 µm, for example.

The enclosing member **2** can be made of substrate material with low moisture permeability. The enclosing member **2** may be, for example, a glass substrate. By using a glass substrate, intrusion of moisture can be suppressed. Further, the enclosing member **2** may be an enclosing substrate in which an accommodation recess for accommodating the organic light emitter **10** is formed in a surface, that is, a cap-shaped enclosing substrate. By using the enclosing substrate including the accommodation recess, the organic light emitter **10** can be enclosed in a good airtight manner.

The enclosing member **2** is bonded to the substrate **1** with bonding material. The bonding material may be, for example, resinous bonding material. It is preferable to use the resinous bonding material with moisture-proof properties. For example, when the resinous bonding material contains desiccant, the moisture-proof properties can be improved. The resinous bonding material may be mainly composed of thermosetting resin or ultraviolet curable resin.

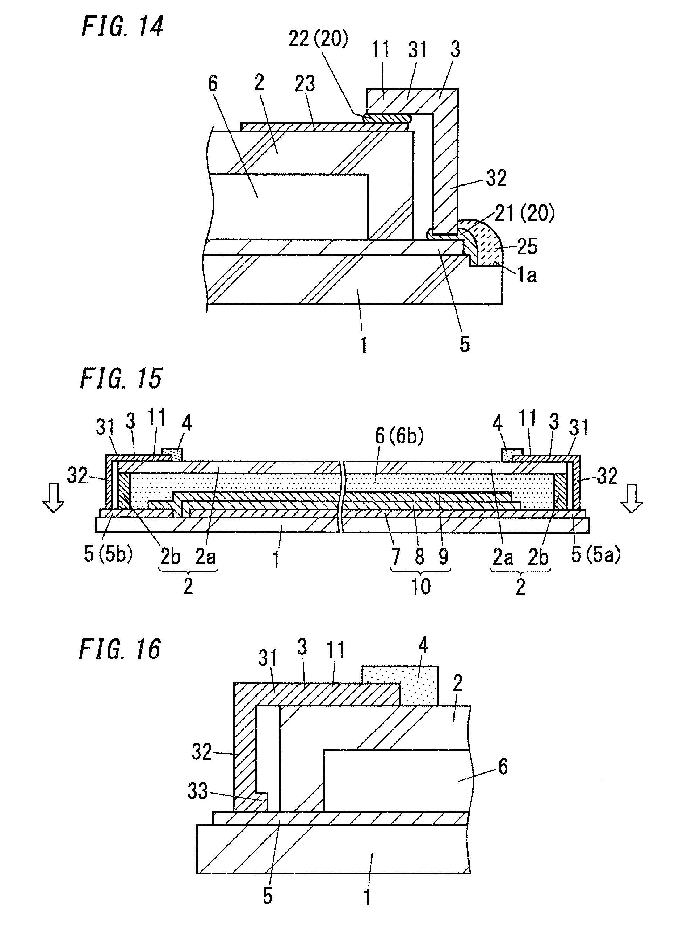

The enclosing member **2** may be bonded to the substrate **1** at a region surrounding the outline of the organic light emitter **10.** In this case, the substrate **1** and the enclosing substrate are bonded along the outline, and therefore the organic light emitter **10** is enclosed highly hermetically and can be isolated from the outside. When the organic light emitter **10** is enclosed, there is an enclosed space **6** inside the accommodation recess. In the organic EL element, this enclosed space **6** may be filled with filler **6b** to give a filled and enclosed structure (see the specific embodiment shown in **FIG. 15** described later), or may be provided as an enclosed empty space serving as a void to give a hollow structure. In the specific embodiment of **FIG. 1****,** the enclosed space **6** is provided as the enclosed empty space **6a.** When the enclosed space **6** is provided as the enclosed empty space **6a,** it is possible to provide a desiccant inside the enclosed empty space **6a.** In this case, even when moisture intrudes into the enclosed empty space **6a,** intruding moisture can be absorbed by the desiccant. Further, in a case where the enclosed space **6** is filled with the filler **6b,** it is possible to use the filler **6b** containing a desiccant. In this case, even when moisture intrudes into the inside of the element, intruding moisture can be absorbed by the desiccant.

Further, in the organic EL element of the present specific embodiment, the electrode piece **3** constituting the interconnection electrode **11** is provided on the opposite side of the enclosing member **2** from the substrate **1,** and the extension part of the electrode piece **3** is fixed to the extended electrode part **5.** The electrode piece **3** may be made of a metal piece with electrically conductive properties. By using a metal piece, it is possible to easily make the electrode terminal of a thin metal strip. Further, when the electrode piece **3** is used, the width of the non-enclosed region (region **T)** outside the enclosing member **2** can be adjusted to be almost equal to a width enough to fix the electrode piece **3.** Therefore, the non-light emitting region outside the enclosing member **2** can be decreased, and thus the proportion of the light emitting region in the organic EL element can be increased. In **FIG. 2(b)****,** a part (fixed part) at which the electrode piece **3** is in contact with the extended electrode part **5** is represented by a broad broken line **Y.** The fixed part has a straight shape along the edge of the enclosing member **2.**

In a preferable embodiment of the organic EL element, the extension part of the electrode piece **3** is fixed to the extended electrode part 5 so as to be pressed against the extended electrode part **5.** In a case where the electrode piece **3** is pressed against the extended electrode part **5,** the degree of contact therebetween is improved, and thus electric connectivity can be improved. Further, in a case where the electrode piece **3** is pressed against the extended electrode part **5,** the degree of fixing them is improved, and thus it is possible to firmly fix the electrode piece **3** to the extended electrode part **5.** In a case where the electrode piece **3** is pressed against the extended electrode part **5,** the width of the non-enclosed region (region **T)** outside the enclosing member **2** can be adjusted to be almost equal to a width enough to press the electrode piece **3** against the extended electrode part **5.** Therefore, the non-light emitting region outside the enclosing member **2** can be decreased, and thus the proportion of the light emitting region in the organic EL element can be increased. In **FIG. 2(b)****,** the fixed part represented by the broad broken line **Y** indicates a pressed part.

Force for pressing the electrode piece **3** against the extended electrode part **5** can be obtained by a spring structure provided to the electrode piece **3.** When one of ends of the electrode piece **3** is fixed and the other is pressed against the extended electrode part **5,** force causing deformation of the electrode piece **3** occurs. However, the electrode piece **3** tends to keep its original shape or return to its original shape. Hence, force is exerted on the electrode piece **3** so that the end of the electrode piece **3** is pressed against the extended electrode part **5** so as to press its front end against the extended electrode part **5.** By making use of such pressing force, the electrode piece **3** and the extended electrode part **5** are interconnected.

The interconnection electrode **11** is constituted by part of the electrode piece **3,** and is formed on the opposite surface of the enclosing member **2** from the substrate **1.** Hence, there is no need to provide the interconnection electrode **11** at the end part of the substrate, and thus the non-light emitting region at the end part of the substrate can be decreased. Further, in a case where light is allowed to emerge from the substrate **1,** the interconnection electrode **11** may be formed on a rear surface of the element which is on an opposite side of the light emitting surface. Thus, it is possible to form the interconnection electrode **11** with a relatively large area by use of a strong metal piece, and therefore electrical connection such as wire bonding is facilitated and consequently it is possible to easily connect the interconnection electrode **11** to an external power source.

The metal piece used for the electrode piece **3** may be formed by molding by injecting melted metal into a mold or cutting out a metal plate or a metal sheet. In a case of cutting out a metal member, it is possible to easily obtain the metal piece. Further, in a case of forming a bent metal piece or a metal piece branched by cutting-in, bending or cutting-in may be conducted. Alternatively, the electrode piece **3** may be constituted by a metal plate spring member. The metal piece may be made of copper, aluminum, or the like. Alternatively, the metal piece may be a metal piece in which a surface of a base piece is covered with an electrically conductive metal plating such as a copper plating, a nickel plating, a silver plating, and a gold plating. Alternatively, the metal piece may be made of a Cu alloy, a Fe alloy, an Al alloy, or the like. In this regard, the metal piece may be used as a base piece. The thickness of the metal piece constituting the electrode piece **3** may be in a range of 0.1 to 3 mm, for example, but is not limited to this range. The metal piece used for the electrode piece **3** may be a metal pin. The metal pin may be a so-called lead pin. In a case of using the metal pin, it is possible to form the electrode piece **3** with a simple structure and to realize electrical connection. The metal pin may be a bar with an almost circular cross section. Note that, to improve electric conductivity, the metal plate preferably has a plate shape rather than a bar shape. Further, to obtain a plate spring properties, the metal piece preferably has a plate shape.

There are two types of electrode pieces **3** which include an electrode piece **3** fixed to the first extended electrode part **5a** and an electrode pieces **3** fixed to the second extended electrode part **5b.** In this case, it is possible to provide the interconnection electrode **11** electrically connected to the first electrode **7** and the interconnection electrode **11** electrically connected to the second electrode **9,** and therefore it is possible to supply electricity to the organic light emitter **10.**

In the present specific embodiment, the electrode piece **3** includes a supported piece **31** whose front end is supported by and fixed to the enclosing member **2,** and a fixed piece **32** whose front end is fixed to the extended electrode part **5.** The fixed piece **32** protrudes from one end of the supported piece **31** almost perpendicular to the supported piece **31.** The electrode piece **3** is formed into an almost L-shape as a whole. This electrode piece **3** may be formed by bending a metal piece with a flat plate shape, for example. A part of the supported piece **31** protruding outward relative to the enclosing member **2** constitutes the extension part of the electrode piece **3** fixed to the extended electrode part **5.** In the electrode piece **3,** the supported piece **31** is disposed in parallel with the surface of the enclosing member **2,** and the fixed piece **32** is disposed in parallel with the side face of the enclosing member **2.** The supported piece **31** may be disposed in almost parallel to the surface of the substrate **1,** and the fixed piece **32** may be disposed in almost perpendicular to the surface of the substrate **1.** However, it is sufficient that the electrode piece **3** is directly or indirectly fixed to the substrate **1,** and hence there is no need to satisfy a relation in which the supported piece **31** is absolutely parallel to the surface of the substrate **1** and the fixed piece **32** is absolutely perpendicular to the surface of the substrate **1.** For example, in order that the electrode piece **3** has a shape suitable for pressing the electrode piece **3** against the extended electrode part **5,** the electrode piece **3** may be bent so as to be slightly distorted as a whole. In FIG. **1(b)****,** with regard to a case where the electrode piece **3** is pressed against the extended electrode part **5,** a direction in which the electrode piece **3** is pressed against the extended electrode part **5** is represented by outline arrows.

The surface of the supported piece **31** can be used as a connection terminal to be connected to an external power source, and hence serves as the interconnection electrode **11** for making electrical connection with the external power source. By constituting the interconnection electrode **11** by the supported piece **31** as described above, it is possible to make the interconnection electrode **11** larger, and therefore the electrical connectability with external parts can be improved. It is sufficient that the interconnection electrode **11** can serve as an electrode for application of a voltage across the organic EL element. An external wire may be directly connected to the interconnection electrode **11,** or an additional electrically conductive member may be connected to the interconnection electrode **11** and the additional electrically conductive member may be connected to an external wire.

It is allowable that a space is formed between the side face of the enclosing member **2** and the fixed piece **32** of the electrode piece **3.** In other words, it is allowable that the fixed piece **32** is not in contact with the side face of the enclosing member **2.** In this case, a space allowing movement of the fixed piece **32** is formed, and therefore it is possible to easily position and fix the electrode piece **3.** Further, when the space is formed between the fixed piece **32** and the enclosing member **2,** in a process of pressing the electrode piece 3 against the extended electrode part **5,** the electrode piece 3 can be easily deformed. The spring properties can be improved.

The electrode piece **3** is bonded to the surface of the enclosing member **2** by bonding the end part of the supported piece **31** to an electrode piece supporter **4.** The electrode piece supporter **4** may be made of curable and adhesive resin material. Alternatively, the electrode piece supporter **4** may be fixed by engaging the end part of the electrode piece 3 with the electrode piece supporter **4.** Further, the electrode piece supporter **4** may be made of plastic material. It is preferable that the electrode piece supporter **4** be fixed to the surface of the enclosing member **2.** By doing so, the end part of the electrode piece **3** can be supported and fixed firmly. In a case where light is allowed to emerge from the substrate **1,** a position at which the electrode piece supporter **4** is provided may overlap the light emitting region in a plan view.

As described above, in the present specific embodiment, the electrode piece **3** is bonded to the opposite surface of the enclosing member **2** from the substrate **1.** In this case, the electrode piece **3** can be firmly fixed in contrast to a case where the electrode piece **3** is fixed to a part other than the surface of the enclosing member **2.** Further, by bonding the electrode piece **3** to the surface of the enclosing member **2,** the spring properties of the electrode piece **3** can be improved and thus force of pressing can be increased. Further, it is possible to easily form the interconnection electrode **11** on the surface of the enclosing member **2,** and therefore electric connectability with external parts can be improved.

Further, like the present specific embodiment, it is preferable that the electrode piece **3** be fixed by being supported by the electrode piece supporter **4** provided to the opposite surface of the enclosing member **2** from the substrate **1.** In this case, the electrode piece **3** can be firmly fixed in contrast to a case where the electrode piece **3** is fixed without using a fixing member such as a supporter. Further, by bonding the electrode piece **3** to the enclosing member **2** with the electrode piece supporter **4,** the spring properties of the electrode piece **3** can be improved and thus force of pressing can be increased.

It is preferable that the electrode piece supporter **4** be provided to the end part of the supported piece **31** (i.e., the opposite end from the fixed piece **32).** By providing the electrode piece supporter **4** at the end of the supported piece **31,** the end part can be supported and fixed firmly. Therefore, the spring properties can be improved. Further, it is possible to ensure the region reserved for the interconnection electrode **11** in the surface of the enclosing member **2,** and therefore electric connectability with external parts can be improved.

It is preferable that the electrode piece supporter **4** cover the end part of the electrode piece **3.** In this case, the end part can be supported and fixed firmly. Consequently, the spring properties of the electrode piece **3** can be improved and thus force of pressing can be increased.

In the present specific embodiment, the electrode piece **3** is formed so as to bend to be in contact with the surface and the side face of the enclosing member **2.** As described above, when the electrode piece **3** is formed to bend, the electrode piece **3** does not protrude from the element, and the electrode piece **3** can be fixed while being kept in a desired space. Further, when the electrode piece **3** is pressed against the extended electrode part **5,** such bend improves the spring properties and therefore the force of pressing can be improved. Further, when the electrode piece **3** has its shape along the shape of the enclosing member **2,** the electrode piece **3** can be prevented from protruding outside the element, and consequently it is possible to suppress breakage of the electrode piece **3.**

Further, in the present specific embodiment, the electrode piece **3** is formed as a single part. In other words, the electrode piece **3** is constituted by a single metal piece, but is not made by bonding two or more metal pieces. Therefore, the strength of the electrode piece 3 can be increased, and the degree of fixing can be improved. Further, when the electrode piece **3** is pressed against the extended electrode part **5,** the spring properties can be improved and therefore the force of pressing can be improved.

The electrode pieces **3** are connected to the individual extended electrode parts **5,** and the interconnection electrodes **11** are classified into an interconnection electrode **11** electrically connected to the first electrode **7** through the first extended electrode part **5a** and an interconnection electrode **11** electrically connected to the second electrode **9** through the second extended electrode part **5b.** In the present specific embodiment, multiple electrode pieces **3** are used, and hence multiple interconnection electrodes **11** are formed. By applying a voltage at multiple sites, the electric conductivity can be improved. By connecting lead lines to the interconnection electrodes **11** by wire bonding, it is possible to make connection with the external power source.

Further, like the present specific embodiment, it is preferable that the electrode piece **3** have a plate spring structure and, the extension part of the electrode piece **3** be pressed against the extended electrode part **5** by the force derived from the plate spring structure. The plate spring structure means a structure which shows such spring properties that in a case where one end of a plate is supported and fixed and the other serves as a free end, when the free end is pressed, force against such pressing occurs and moves the free end to its original position. Owing to the force caused by the plate spring structure, it is possible to easily and strongly press the electrode piece **3** against the extended electrode part **5.**

According to the organic EL element, by arranging multiple organic EL elements in a planar manner, it is possible to produce a surface illumination device (illuminator) with a large light emitting area. In the organic EL element of the present embodiment, the non-light emitting region at the end part of the substrate can be reduced. Therefore, the non-light emitting region formed at the boundary portion between adjacent organic EL elements can be decreased, and therefore it can be made difficult to perceive a junction between the organic EL elements. Further, the non-light emitting region becomes smaller, and therefore the proportion of the light emission can be improved and it is possible to produce an illumination device with high light emitting intensity.

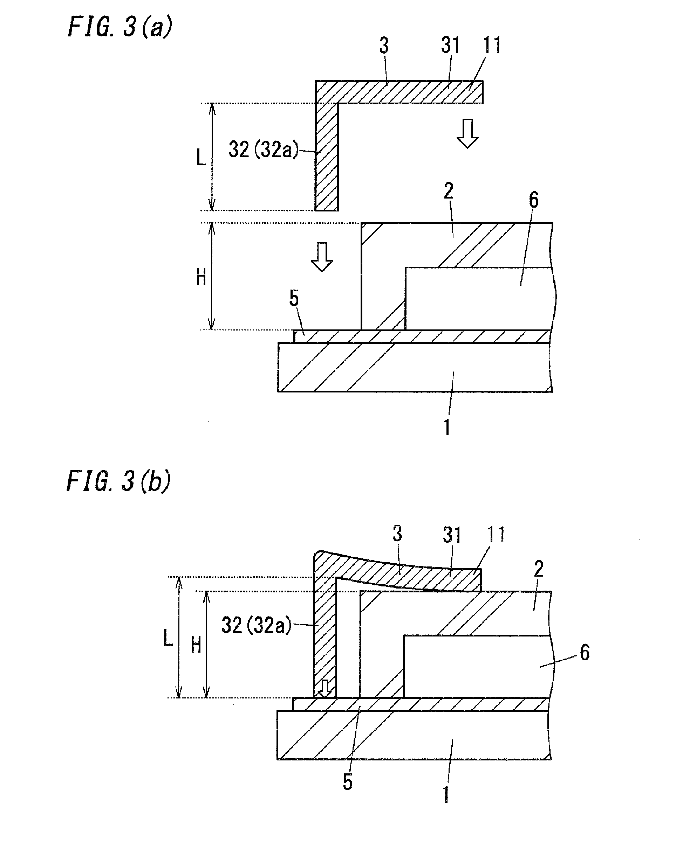

**FIG. 3** shows an example of a production process of the organic EL element, and an example of a process of attaching the electrode piece **3.** In the present specific embodiment, a front end part of the fixed piece **32** of the electrode piece **3** is formed as a pressed piece **32a** which is to be in contact with the extended electrode part **5** and pressed against the extended electrode part **5.** In the organic EL element of the present specific embodiment, steps prior to a step of attaching the electrode piece **3** can be done by an appropriate manner. For example, the electrically conductive layer is patterned to constitute the first electrode **7** and the extended electrode part **5** on the surface of the substrate **1.** Next, layers constituting the organic light emitting layer **8** are stacked sequentially to form the organic light emitting layer **8.** Subsequently, the second electrode **9** is formed. Thereby, it is possible to form stacked layers serving as the organic light emitter **10.** Stacking can be done by deposition or coating. The second electrode **9** and the first electrode **7** are stacked in such a pattern that they are not in contact with each other. Further, the enclosing member **2** is bonded to the substrate **1** with bonding material and thereby the organic light emitter **10** is enclosed. Consequently, the element in which the electrode piece **3** is not attached can be obtained.

Thereafter, as shown in **FIG. 3(a)****,** the electrode piece **3** is moved closer to the element from the enclosing member 2 side. In this regard, the supported piece **31** is bonded to the surface of the enclosing member **2**, and the front end of the pressed piece **32a** (the fixed piece **32)** is pressed against the extended electrode part **5.** In a case where the electrode piece **3** has an L-shape like the specific embodiment of **FIG. 3(a)****,** to obtain sufficient force of pressing, the length **L** of the fixed piece **32** is preferably equal to or longer than the height **H** of the enclosing member **2.** More preferably, the length **L** of the fixed piece **32** is slightly longer than the height **H** of the enclosing member **2.** In this case, the spring property is improved, and thus the front end of the fixed piece **32** can be pressed strongly against the extended electrode part **5.**

**FIG. 3(b)** is a view illustrating pressing the electrode piece **3** against the extended electrode part **5.** To clearly illustrate spring force caused by pressing the electrode piece **3** against the extended electrode part **5,** **FIG. 3(b)** illustrates a condition in which the electrode piece **3** is extremely deformed. However, it is sufficient that the electrode piece **3** is slightly deformed. As shown in **FIG. 3(b)****,** in the electrode piece 3, when the front end part of the supported piece **31** is fixed to the enclosing member **2,** the front end part of this supported piece **31** serves as a fixed end. In contrast, the end part of the supported piece **31** close to the fixed piece **32** serves as a free end. In this regard, when the length **L** of the fixed piece **32** is longer than the height **H** of the enclosing member **2,** the fixed piece **32** is pressed in a direction almost perpendicular to the surface of the substrate **1.** As a result, force to cause deformation of the electrode piece **3** occurs. However, the end part of the supported piece **31** is fixed, and thus force directed to the substrate **1** occurs so that the electrode piece **3** resumes its normal shape from the deformed shape (indicated by the outline arrow in the figure). Therefore, the fixed piece **32** (the pressed piece **32a)** can be strongly pressed against the extended electrode part **5,** and thus it is possible to improve electric connectability owing to pressing the electrode piece **3** against the extended electrode part **5.** Note that, the electrode piece **3** may be not deformed extremely like **FIG. 3(b)****,** however when the electrode piece **3** is pressed against the extended electrode part **5,** it is considered that the electrode piece **3** is deformed so that it is slightly distorted around its bend part. Hence, it is possible to confirm whether the electrode piece **3** is pressed against the extended electrode part **5.**

In a case where the fixed piece **32** is pressed against the extended electrode part **5,** when the fixed piece **32** has an excessively short length, the fixed piece **32** is unlikely to have a sufficient spring property, and when the fixed piece **32** has an excessively long length, the extended electrode part **5** is likely to be damaged by the fixed piece **32,** and the electrode piece **3** is likely to be deformed to an extent of losing the spring property. With regard to the electrode piece **3** of the embodiment shown in **FIG. 3(a)****,** it is preferable that the length **L** of the fixed piece **32** be 1 to 2 times longer than the height **H** of the enclosing member **2,** and it is more preferable that the length **L** of the fixed piece **32** is 1.1 to 1.5 times longer than the height **H** of the enclosing member **2.** However, if the effect of pressing the electrode piece **3** against the extended electrode part **5** can be obtained, the length is not limited to being in the aforementioned range. For example, in a case where the extension part (a part protruding outward relative to the enclosing member **2)** of the supported piece **31** is bent towards the extended electrode part **5,** the length L of the fixed piece **32** may be 0.5 to 1 times longer than the height **H** of the enclosing member **2.** In this case, the effect of pressing the electrode piece **3** against the extended electrode part **5** can be obtained.

In a case of using the electrode piece supporter **4,** the electrode piece supporter **4** may be provided at the same time of attaching the electrode piece **3.** Alternatively, the electrode piece **3** may be attached to the electrode piece supporter **4** in advance and then the electrode piece **3** may be attached together with the electrode piece supporter **4.** Alternatively, the electrode piece **3** may be attached in advance by, for example, tentatively fixing the electrode piece **3** with double face adhesive tape, and then resin material may be applied and then cured to form the electrode piece supporter **4.** It is not always necessary to provide the electrode piece supporter **4.** However, in this case, it is preferable to use a structure for supporting and fixing the supported piece **31,** for example, bonding the supported piece **31** to the enclosing member **2** with double face adhesive tape.

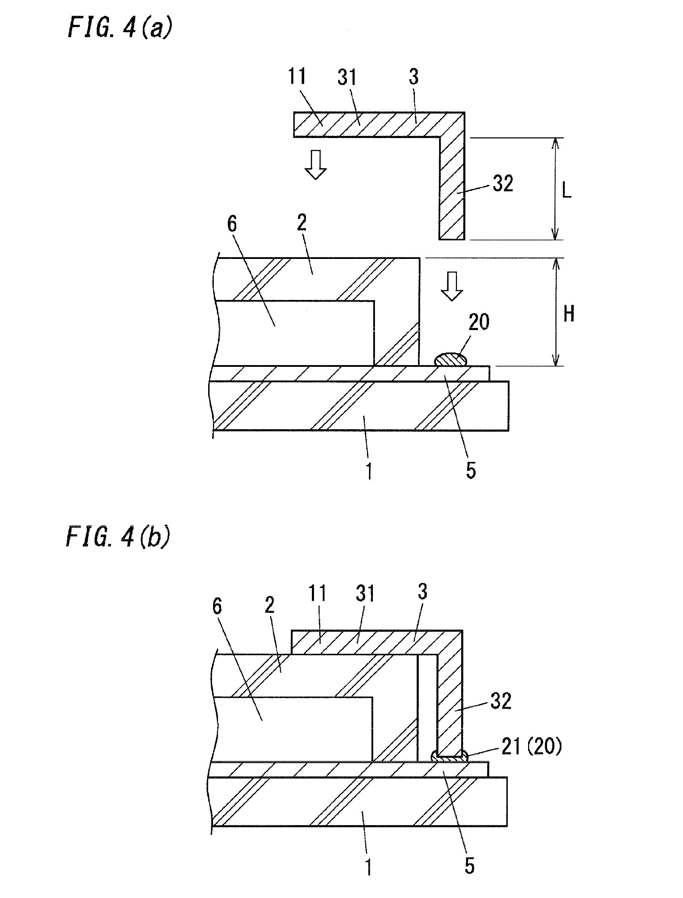

**FIG. 4** relates to another example of the embodiment of the organic EL element, and is an enlarged view illustrating the electrode piece **3** and its surroundings. **FIG. 4(b)** shows the organic EL element in which the electrode piece **3** is attached. **FIG. 4(a)** shows an example of the production method of the organic **EL** element of **FIG. 4(b)****.** The present specific embodiment has the same configurations as the specific embodiment of **FIG. 1** but is different from the specific embodiment of **FIG. 1** in the fixing structure of the electrode piece 3. The same configurations as the specific embodiment of **FIG. 1** are designated by the same reference signs as the embodiment **FIG. 1** and their explanations are omitted.

As shown in **FIG. 4(b)****,** in the organic EL element of the present specific embodiment, the extension part of the electrode piece **3** is fixed to the extended electrode part **5** with electrically conductive fixing part **21** made of electrically conductive paste **20.** As described above, in a preferable embodiment of the organic EL element, the electrode piece **3** is fixed with the electrically conductive paste **20.** When the electrode piece **3** is fixed with the electrically conductive paste **20,** it is possible to increase the degree of fixing and improve the electric connectability. Further, the electrode piece **3** can be fixed with the electrically conductive fixer **21** formed by curing the electrically conductive paste **20.** Therefore, the electrode piece **3** can be fixed firmly. Further, in a case of fixing with the electrically conductive paste **20,** the electrically conductive paste **20** can be easily provided by application, and fixing can be conducted by curing. The electrode piece **3** can be fixed and bonded easily. Further, when the electrode piece **3** is fixed with the electrically conductive paste **20,** the width of the non-enclosed region (region **T)** outside the enclosing member **2** can be adjusted to be almost equal to a width necessary for fixing the electrode piece **3** with the electrically conductive paste **20.** Therefore, it is possible to decrease the non-light emitting region outside the enclosing member 2, and thus increase the proportion of the light emitting region in the organic EL element.

The electrically conductive paste **20** may be preferably thermoset. In this case, it is possible to easily form the electrically conductive fixer **21** of the electrically conductive paste **20** by thermal curing. The electrically conductive paste **20** is paste material with fluidity, and therefore it can be easily applied.

Electrically conductive material contained in the electrically conductive paste **20** is not limited particularly and may be preferably metal particles. The metal particles are, for example, particles of silver, gold, copper, or nickel. Among these, silver paste including silver is preferable. The electrically conductive paste **20** may include a binder. When the electrically conductive paste **20** includes a binder, viscosity and adhesiveness of the electrically conductive paste **20** are adjustable, and therefore it is possible to obtain the electrically conductive paste **20** with high handleability. The binder may be thermosetting resin. The thermosetting resin may include epoxy resin and silicone resin. The electrically conductive paste **20** may be prepared by dispersing the electrically conductive material in a solvent. The solvent may be an organic solvent. By using an organic solvent which vaporizes in thermal curing, the electrically conductive paste **20** can be easily cured. A thermal curing temperature of the electrically conductive paste **20** is not limited particularly, and may be equal to or more than 100°C and be equal to or less than 200°C, for example. When the thermal curing temperature is excessively high, the element may deteriorate due to heat for curing.

In a case of producing the organic EL element of the present specific embodiment, for example, as shown in **FIG. 4(a)****,** the electrode piece **3** is moved closer to the element from the enclosing member **2** side. In this regard, the electrically conductive paste **20** is provided in advance to at least one of the surface of the extended electrode part **5** and the front end of the fixed piece **32** provided to the electrode piece **3** by application. The application of the electrically conductive paste **20** can be done with a dispenser or by printing. **FIG. 4(a)** illustrates a condition where the electrically conductive paste **20** is provided to the surface of the extended electrode part **5.** As described above, when the electrically conductive paste **20** is provided to the surface of the extended electrode part **5,** it is possible to easily provide the electrically conductive paste **20** by application. Thereafter, the supported piece **31** is bonded to the surface of the enclosing member **2,** and the front end of the fixed piece **32** is moved closer to the extended electrode part **5.** Bonding of the supported piece **31** to the enclosing member **2** can be done with double face adhesive tape. Subsequently, the fixed piece **32** is made in contact with the electrically conductive paste **20** and is bonded to the extended electrode part **5.** In this regard, it is allowable that the electrically conductive paste **20** is slightly crushed by the front end of the fixed piece **32.** In this case, the front end of the fixed piece **32** is embedded into the electrically conductive paste **20,** and therefore it is possible to improve the degree of fixing and the electric connectability.

In the case of the electrode piece **3** like the specific embodiment of **FIG. 4(a)****,** the degree of fixing and the electric connectability are obtained by the electrically conductive paste **20,** and hence the length **L** of the fixed piece **32** may be equal to, slightly longer than, or slightly shorter than the height **H** of the enclosing member **2.** However, when the length **L** of the fixed piece **32** is excessively shorter than the height **H** of the enclosing member **2,** it is necessary to thicken the electrically conductive paste **20** for fixing the fixed piece **32** to the extended electrode part **5.** Thus, it may become difficult to easily fix the fixed piece **32** to the extended electrode part **5,** and the degree of fixing may decrease. Further, when the length L of the fixed piece **32** is excessively longer than the height **H** of the enclosing member **2,** the front end of the fixed piece **32** may be excessively strongly pressed against the extended electrode part **5,** and the element is likely to be broken. In view of this, it is preferable that the length **L** of the fixed piece **32** be almost equal to the height **H** of the enclosing member **2.** For example, the length L of the fixed piece **32** is not limited particularly, and may be 0.5 to 1.5 times longer than the height **H** of the enclosing member **2.**

Thereafter, by heating the element in which the electrically conductive paste **20** is between the electrode piece **3** and the extended electrode part **5,** the electrically conductive paste **20** is thermally cured to become solid, and consequently the electrically conductive fixer **21** is formed. Accordingly, as shown in **FIG. 4(b)****,** it is possible to obtain the organic EL element in which the electrode piece **3** is fixed to the extended electrode part **5** with the electrically conductive fixer **21.**

Note that, **FIG. 4(a)** shows the embodiment in which the electrically conductive paste **20** is provided in advance and later bonded. However, the electrically conductive paste **20** may be provided after the electrode piece **3** is attached. For example, after the fixed piece **32** is fixed to the enclosing member **2,** the electrically conductive paste **20** is provided to a gap or a boundary portion between the extended electrode part **5** and the fixed piece **32** and then cured. By doing so, the electrode piece **3** can be fixed to the extended electrode part **5** with the electrically conductive paste **20.** However, to firmly fix the electrode piece **3** to the extended electrode part **5,** it is preferable that, like the specific embodiment of **FIG. 4(a)****,** the electrically conductive paste **20** is preliminarily provided and the fixed piece **32** is fixed to the extended electrode part **5** with the electrically conductive paste **20** in-between.

Note that, with regard to the specific embodiment of **FIG. 4(b)****,** the electrode piece supporter **4** can be used in a similar manner to the specific embodiment of **FIG. 1****.** In this case, the electrode piece supporter **4** may be provided at the same time of attaching the electrode piece 3. Alternatively, the electrode piece **3** may be attached to the electrode piece supporter **4** in advance and then the electrode piece **3** may be attached together with the electrode piece supporter **4.** Alternatively, the electrode piece 3 may be attached in advance by, for example, tentatively fixing the electrode piece 3 with double face adhesive tape, and then resin material may be applied and then cured to form the electrode piece supporter **4.** It is not always necessary to provide the electrode piece supporter **4.** However, in this case, it is preferable to use a structure for supporting and fixing the supported piece **31,** for example, bonding the supported piece **31** to the enclosing member **2** with double face adhesive tape.

Also in the embodiment in which the extension part of the electrode piece 3 is pressed against the extended electrode part **5** as shown in **FIG. 3****,** it is preferable that the electrically conductive paste **20** be provided at the boundary portion between the electrode piece **3** and the extended electrode part **5** so as to bond them. In this case, the extension part of the electrode piece **3** is fixed by pressing the electrode piece **3** against the extended electrode part **5** and with the electrically conductive fixer **21** made of the electrically conductive paste **20.** By providing the electrically conductive paste **20,** it is possible to fix the electrode piece **3** to the extended electrode part **5** by firmly bonding them, and to increase the electric connectability. The electrically conductive paste **20** may form an electric conductor (the electrically conductive fixer **21)** when cured. Further, the electrode piece **3** is bonded to the extended electrode part **5** with the electric conductor made of the electrically conductive paste **20,** and additionally the boundary portion between the electrode piece **3** and the extended electrode part **5** may be covered with this electric conductor. By doing so, the fixing strength of the electrode piece **3** can be improved.

Further, when the electrically conductive paste **20** is used in the specific embodiment of **FIG. 3****,** it is preferable that, in the process of pressing the electrode piece **3** against the extended electrode part **5,** the electrically conductive paste **20** be provided in advance to at least one of the surface of the extended electrode part **5** and the front end of the fixed piece **32.** By doing so, it is possible to press the electrode piece **3** against the extended electrode part **5** while pressing the electrically conductive paste **20** against the extended electrode part **5.** Further, when the boundary portion between the electrode piece **3** and the extended electrode part **5** is covered with the electrically conductive paste **20,** the attaching strength can be improved. Further, by using the electrically conductive paste **20,** even if there is an unintended gap between the electrode piece **3** and the extended electrode part **5,** such an unintended gap can be filled with the electrically conductive paste 20, and therefore the electric connectability can be improved. It is preferable that after bonding the electrically conductive paste **20** be cured to serve as the electric conductor constituting the electrically conductive fixer **21.**

Further, the embodiment in which the electrically conductive paste **20** is used with regard to the specific embodiment of **FIG. 3** is as sort of the embodiment in which the extension part of the electrode piece **3** is pressed against the extended electrode part **5** with regard to the specific embodiment of **FIG. 4****.** Therefore, with regard to the specific embodiment of **FIG. 4****,** the fixed piece **32** of the electrode piece **3** may be pressed against the extended electrode part **5** in a manner similar to the manner described with regard to the specific embodiment of **FIG. 3****.** In the specific embodiment of **FIG. 4****,** in a case where the electrode piece **3** is pressed against the extended electrode part **5,** it is allowable that, after the electrode piece **3** is pressed against the extended electrode part **5,** the front end of the extension part (front end of the fixed piece **32)** of the electrode piece **3** is not in direct contact with the extended electrode part **5** and optionally the electrically conductive fixer **21** (the electrically conductive paste **20)** is provided therebetween.

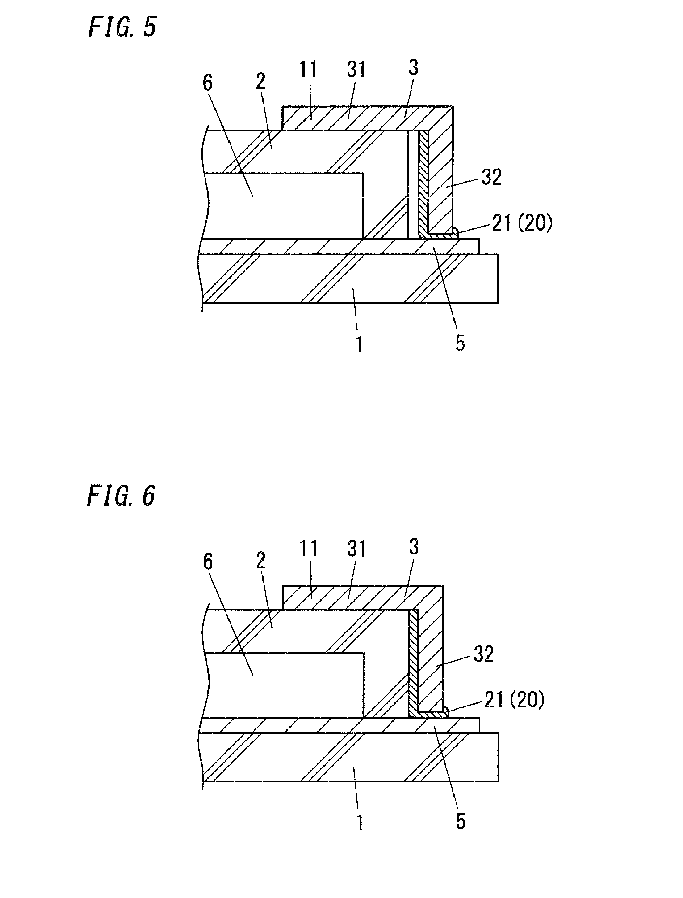

**FIG. 5** relates to another example of the embodiment of the organic EL element, and is an enlarged view illustrating the electrode piece **3** and its surroundings. The present specific embodiment has the same configuration as the specific embodiment of **FIG. 4** but is different in the structure of the electrically conductive fixer **21** made of the electrically conductive paste **20.**

In the specific embodiment of **FIG. 5****,** the electrically conductive fixer **21** made of the electrically conductive paste **20** is formed in contact with a surface of the extension part (the fixed piece **32)** of the electrode piece 3 close the enclosing member **2.** As described above, when the electrically conductive fixer **21** is formed on the surface of the fixed piece **32** close to the enclosing member **2,** the extension part of the electrode piece **3** can be fixed with the electrically conductive fixer **21** larger in size, and thus the degree of fixing can be improved. Further, as the electrically conductive fixer **21** becomes large in size, the electric conductivity increases, and thus it is possible to improve the electric connectability.

**FIG. 5** shows a situation where the electrically conductive fixer **21** is formed on the entire surface of the fixed piece 32 close to the enclosing member **2.** However, the electrically conductive fixer **21** may be formed on part of the surface of the fixed piece **32** close to the enclosing member **2.** In summary, if the electrically conductive fixer **21** is formed on the surface of the front end part of the fixed piece **32** close to the enclosing member **2,** and further is formed to include the boundary portion between the fixed piece **32** and the extended electrode part **5,** the degree of fixing can be improved. Note that, to more improve the degree of fixing and the electric connectability, it is preferable that the electrically conductive fixer **21** be larger and formed on the entire surface of the fixed piece **32** close to the enclosing member **2.**

The specific embodiment of **FIG. 5** can be formed by pressing the fixed piece 32 into the electrically conductive paste **20** so that the electrically conductive paste **20** flows so as to climb up the surface of the fixed piece **32** at the time of making the extension part of the electrode piece **3** in contact in the process shown in **FIG. 4(a)****,** for example. By doing so, it is possible to provide the electrically conductive paste **20** to the surface of the fixed piece **32** close to the enclosing member **2,** and thus it is possible to form the electrically conductive fixer **21** on the surface of the fixed piece **32** which defines an internal surface of the element. Alternatively, a part of the electrically conductive paste **20** may be provided to the surface of the fixed piece **32** close to the enclosing member **2** in advance, and another part of the electrically conductive paste **20** may be provided to the surface of the extended electrode part **5,** and the fixed piece **32** may be moved closer to the extended electrode part **5** to attach the electrode piece **3,** and thereby these parts of the electrically conductive paste **20** may be made in contact with each other. By doing so, after cured, the both parts of the electrically conductive paste **20** are integrated and connected, and thus the degree of fixing and the electric connectability can be improved. The electrically conductive paste **20** can be provided by application.

**FIG. 6** relates to another example of the embodiment of the organic EL element, and is an enlarged view illustrating the electrode piece **3** and its surroundings. The present specific embodiment has the same configuration as the specific embodiment of **FIG. 4** but is different in the structure of the electrically conductive fixer **21** made of the electrically conductive paste **20.**

In the specific embodiment of **FIG. 6****,** the electrically conductive fixer **21** made of the electrically conductive paste **20** is formed in contact with a side face of the enclosing member **2.** As described above, when the electrically conductive fixer **21** is formed in contact with the side face of the enclosing member **2,** the extension part of the electrode piece 3 can be fixed with the larger electrically conductive fixer **21,** and thus the degree of fixing can be improved. Further, in the present specific embodiment, the electrically conductive fixer **21** is formed on the surface of the fixed piece **32** close to the enclosing member **2** and in contact with the side face of the enclosing member **2.** In other words, to fill a gap between the enclosing member **2** and the fixed piece **32,** the electrically conductive fixer **21** is formed by filling this gap with the electrically conductive paste **20.** As described above, when the electrically conductive fixer **21** is formed so that the space between the enclosing member **2** and the electrode piece **3** is filled, the electrode piece **3** can be firmly fixed to the enclosing member **2,** and the degree of fixing of the electrode piece **3** can be improved.

**FIG. 6** shows a situation where the electrically conductive fixer **21** is formed to fill the entire gap between the fixed piece **32** and the enclosing member **2.** However, the electrically conductive fixer **21** may be formed to fill part of the gap between the fixed piece **32** and the enclosing member **2.** In summary, if the electrically conductive fixer **21** is formed in contact with the fixed piece **32** and the enclosing member **2,** the degree of fixing can be improved. Note that, to more improve the degree of fixing and the electric connectability, it is preferable that the electrically conductive fixer **21** be larger and formed to fill the entire gap between the fixed piece **32** and the enclosing member **2.**

The specific embodiment of **FIG. 6** can be formed by injecting the electrically conductive paste **20** into the gap between the fixed piece **32** and the enclosing member **2** so that the gap between the fixed piece **32** and the enclosing member **2** is filled with the electrically conductive paste **20,** after the specific embodiment of **FIG. 5** is prepared, for example. Note that, an amount of the electrically conductive paste **20** enough to be in contact with the enclosing member **2** may be provided to the surface of the fixed piece **32** close to the enclosing member **2** in advance, or an amount of the electrically conductive paste **20** enough to be in contact with the fixed piece 32 may be provided to the side face of the enclosing member **2,** and then the gap can be filled by fixing the fixed piece **32.** In a case of providing multiple parts of the electrically conductive paste **20** to different positions, when these parts of the electrically conductive paste **20** are made in contact with each other, the parts of the electrically conductive paste **20** are integrated and connected by curing, and thus the degree of fixing and the electric connectability can be improved. The electrically conductive paste **20** can be provided by application.

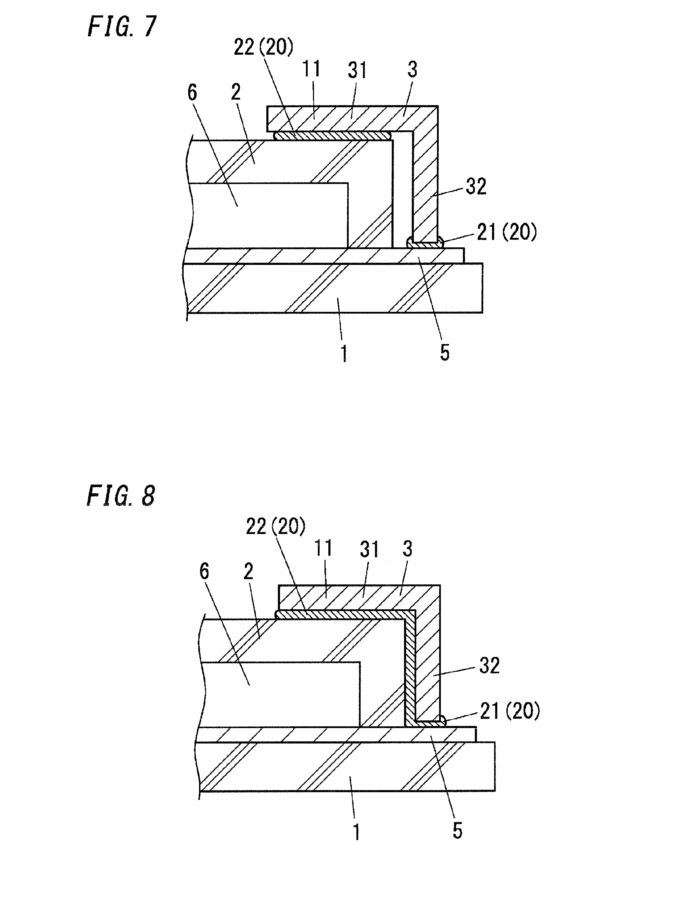

**FIG. 7** relates to another example of the embodiment of the organic EL element, and is an enlarged view illustrating the electrode piece **3** and its surroundings. The present specific embodiment has the same configuration as the specific embodiment of **FIG. 4(b)** but is different in that an electrically conductive bond **22** is formed.

In the specific embodiment of **FIG. 7****,** the electrode piece **3** is fixed to the enclosing member **2** with the electrically conductive bond **22** made of the electrically conductive paste **20.** The electrically conductive bond **22** bonds the electrode piece **3** and the enclosing member **2.** As described above, in a preferable embodiment of the organic EL element, the electrode piece **3** is bonded and fixed to the enclosing member **2** with the electrically conductive paste **20.** The electrode piece **3** is bonded to the enclosing member **2** with the electrically conductive paste **20,** and thus the degree of fixing at the side of the electrode piece **3** close to the enclosing member **2** can be improved. Further, with regard to the electrode piece **3,** both the front end of the fixed piece **32** serving as the extension part and the supported piece **31** serving as a base part are fixed with the individual electrically conductive pastes **20,** and therefore the electrode piece 3 can be bonded and fixed efficiently. The electrically conductive paste **20** used for the electrically conductive bond **22** and the electrically conductive paste **20** used for the electrically conductive fixer **21** may be different materials but preferably the same material. By doing so, the opposite ends of the electrode piece 3 can be fixed with the electrically conductive pastes **20** of the same material. Therefore, it is possible to easily bond and fix the electrode piece **3.**

The specific embodiment of **FIG. 7** can be formed by providing the electrically conductive paste **20** to the surface of the enclosing member **2** in the process of moving the electrode piece **3** closer to the substrate **1** as shown in **FIG. 4(a)****,** for example. Alternatively, the electrically conductive paste **20** may be provided to the surface of the supported piece **31** of the electrode piece **3** close to the enclosing member **2** in advance. Thereafter, in a condition where the electrically conductive paste **20** is provided between the fixed piece **32** and the substrate **1** and the further electrically conductive paste **20** is provided between the supported piece **31** and the enclosing member **2,** the electrically conductive pastes **20** are thermally cured and thereby the electrode piece **3** can be fixed. By curing, the electrically conductive paste **20** provided in contact with the front end of the fixed piece **32** forms the electrically conductive fixer **21,** and the electrically conductive paste **20** between the supported piece **31** and the enclosing member 2 forms the electrically conductive bond **22.**

**FIG. 8** relates to another example of the embodiment of the organic EL element, and is an enlarged view illustrating the electrode piece **3** and its surroundings. The present specific embodiment has the same configuration as the specific embodiment of **FIG. 7** but is different in the structure of the electrically conductive fixer **21** and the electrically conductive bond **22** which are made of the electrically conductive pastes **20.**

In the specific embodiment of **FIG. 8****,** the electrode piece **3** is bonded to the enclosing member **2** with the electrically conductive bond **22** made of the electrically conductive paste **20** in a similar manner to the specific embodiment of **FIG. 7****,** and the electrically conductive fixer **21** is further provided to the inward surface of the fixed piece **32** in a similar manner to the specific embodiment of **FIG. 6****.** Further, the electrically conductive fixer **21** and the electrically conductive bond **22** are interconnected. In other words, the inward surface of the electrode piece **3** is fixed with the electrically conductive paste **20** constituted by interconnected and integrated parts formed on the extended electrode part **5,** the side face of the enclosing member **2,** and the surface of the enclosing member **2.** As described above, the electrically conductive fixer **21** and the electrically conductive bond **22** are interconnected, bonding can be done by continuous electric conductor, and therefore the degree of fixing can be more improved. Further, in the present specific embodiment, the electrically conductive fixer **21** is formed on the surface of the fixed piece **32** close to the enclosing member **2,** and in contact with the side face of the enclosing member **2.** In other words, the electrically conductive fixer **21** is formed by injecting the electrically conductive paste **20** into the gap between the enclosing member **2** and the fixed piece **32** to fill up the gap. As described above, when the electrically conductive fixer **21** is formed between the enclosing member **2** and the fixed piece **32** to fill up the gap therebetween, it is possible to firmly fix the electrode piece **3** to the enclosing member **2,** and therefore the degree of fixing of the electrode piece **3** can be improved.

The specific embodiment of **FIG. 8** can be formed by in advance providing the electrically conductive paste **20** to the surface and side face of the enclosing member **2** in the process of moving the electrode piece **3** closer to the substrate **1** as shown in **FIG. 4(a)****,** for example. Alternatively, the electrically conductive paste 20 may be provided to the entire surface of the electrode piece **3** close to the enclosing member **2** (the entire inward surfaces of the supported piece **31** and the fixed piece **32)** in advance. Thereafter, in a condition where the electrically conductive paste **20** is provided between the fixed piece **32** and the substrate **1,** between the inward surface of the fixed piece **32** and the side face of the enclosing member **2,** and between the supported piece **31** and the surface of the enclosing member **2,** the electrically conductive pastes **20** is thermally cured and thereby the electrode piece **3** can be fixed. By curing, one part of the electrically conductive paste **20** provided in contact with the extended electrode part **5** around the front end of the fixed piece **32** forms the electrically conductive fixer **21,** and another part of the electrically conductive paste **20** between the supported piece **31** and the enclosing member **2** forms the electrically conductive bond **22,** and these parts are interconnected and integrated.

In the specific embodiments of **FIG. 4** to **FIG. 8****,** the electrically conductive pastes **20** (the electrically conductive fixer **21** and the electrically conductive bond **22)** may cover the electrode piece **3** partially or entirely. By covering the electrode piece **3** with the electrically conductive paste **20,** the degree of fixing can be improved. For example, by covering the electrode piece **3** (the fixed piece **32)** with the electrically conductive fixer **21** at the side part of the enclosing member **2,** it is possible to firmly fix the electrode piece **3.**

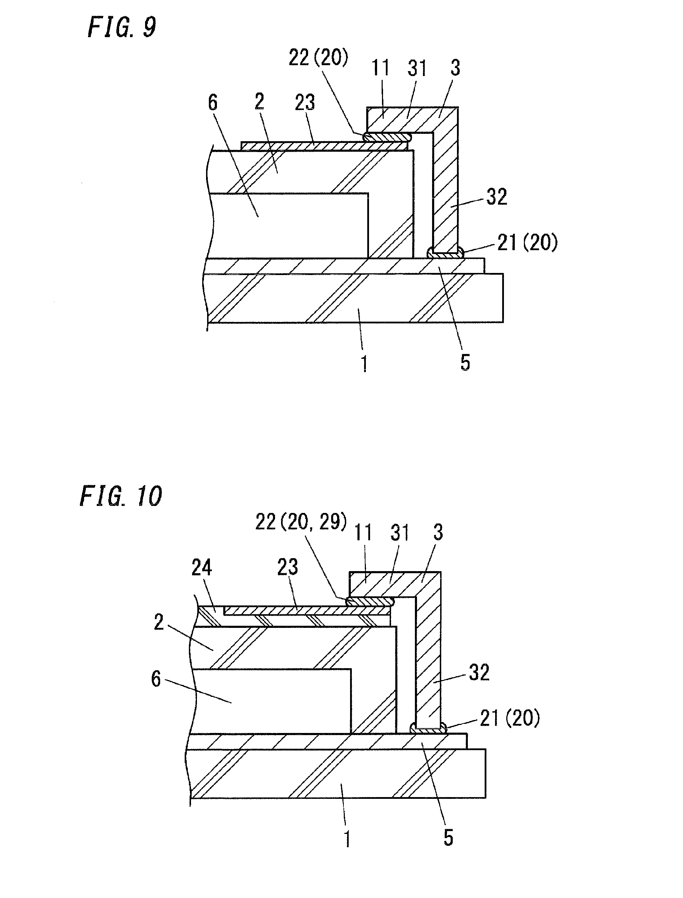

**FIG. 9** relates to another example of the embodiment of the organic EL element, and is an enlarged view illustrating the electrode piece **3** and its surroundings. The present specific embodiment has substantially the same configuration as the specific embodiment of **FIG. 7** but is different in the fixing structure at the enclosing member **2** side of the electrode piece **3.**

In the specific embodiment of **FIG. 9****,** in a similar manner to the specific embodiment of **FIG. 7****,** the electrode piece **3** is fixed to the enclosing member **2** with the electrically conductive bond **22** made of the electrically conductive paste **20,** and is fixed directly or indirectly to the substrate **1** with the electrically conductive fixer **21** made of the electrically conductive paste **20.**

Further, in the present specific embodiment, an interconnection electrode extension part **23** is provided to the surface of the enclosing member **2,** and the electrode piece **3** is bonded to the interconnection electrode extension part **23** with the electrically conductive bond **22.** As described above, by providing the interconnection electrode extension part **23** to the surface of the enclosing member **2,** connection with the external power source can be made by connecting the external power source to the interconnection electrode extension part **23** electrically connected to the electrode piece **3.** Therefore, it is possible to make connection with the external power source at a larger area, and connectability with electric wires can be improved. Further, when the interconnection electrode extension part **23** is provided, the length of part of the electrode piece **3** on the surface of the enclosing member **2** can be shortened, and thus a usage amount of material for the electrode piece **3** can be reduced, and therefore electric connection can be made efficiently. Further, when the interconnection electrode extension part **23** made of electrode material is bonded to the electrode piece **3** with the electrically conductive paste **20,** adhesiveness can be improved, and thus it is possible to more firmly fix the electrode piece **3.**

The interconnection electrode extension part **23** may be formed as a layer of electrically conductive material stacked on the enclosing member **2.** For example, the interconnection electrode extension part **23** may be formed on the enclosing member **2** by use of appropriate metal material such as copper, silver, gold, aluminum, and the like which are suitable for electrodes. The method of forming the interconnection electrode extension part **23** is not particularly limited and the interconnection electrode extension part **23** may be constituted by a film of electrically conductive material formed by a film formation method such as sputtering, plating, printing, deposition, or the like. The interconnection electrode extension part **23** may be formed before or after enclosing. To prevent breakage of the organic EL element, it is preferable that the interconnection electrode extension part **23** be formed on the enclosing member **2** which has not been bonded to the substrate **1** yet before enclosing. Bonding and fixing of the electrode piece **3** may be done in a similar manner to the specific embodiment of **FIG. 7****.** In the specific embodiment of **FIG. 9****,** the electrically conductive fixer **21** and the electrically conductive bond **22** are formed separately. However, also in the present specific embodiment, like the specific embodiment of **FIG. 8****,** the electrically conductive fixer **21** and the electrically conductive bond **22** may be interconnected. In this case, the degree of fixing can be more improved. Note that, the interconnection electrode extension part **23** may be formed by attaching electrically conductive metal tape, for example. In this case, it is possible to easily provide the interconnection electrode extension part **23.**

**FIG. 10** relates to another example of the embodiment of the organic EL element, and is an enlarged view illustrating the electrode piece **3** and its surroundings. The present specific embodiment has substantially the same configuration as the specific embodiment of **FIG. 9** but is different in that a wiring board **24** is provided to the enclosing member **2.**

In the specific embodiment of **FIG. 10****,** the electrode piece **3** is fixed to the enclosing member **2** with the electrically conductive bond **22** formed on the enclosing member **2** by use of the electrically conductive paste **20** in a similar manner to the specific embodiment of **FIG. 9****.** The electrically conductive bond **22** bonds the electrode piece **3** and the interconnection electrode extension part **23.**

Further, in the present specific embodiment, the organic EL element includes the wiring board **24** at the surface of the enclosing member **2.** The interconnection electrode extension part **23** is provided to a surface of the wiring boared **24**. The electrode piece **3** is electrically connected to the interconnection electrode extension part **23** via an electrically conductive connector **29.** The electrically conductive connector **29** is constituted by the electrically conductive bond **22.** Therefore, the electrode piece **3** is bonded to the interconnection electrode extension part **23** with the electrically conductive bond **22.** The supported piece **31** of the electrode piece **3** is bonded to the interconnection electrode extension part **23.** As described above, the interconnection electrode extension part **23** is provided to the wiring board **24,** the wiring board **24** is bonded to the enclosing member **2,** and further the electrode piece **3** is connected to the interconnection electrode extension part **23** provided to the wiring board **24.** Hence, the interconnection electrode extension part **23** can be provided to the surface of the enclosing member **2** by only attaching the wiring board **24,** and therefore it is possible to provide easily and safely the interconnection electrode extension part **23.** Further, the interconnection electrode extension part **23** is provided to the wiring board **24,** and therefore it is possible to provide the interconnection electrode extension part **23** with appropriate pattern, and provide patterned circuit to the wiring board **24.** Consequently, the electric connectability can be improved and the degree of freedom of patterns of circuits can be improved.

The wiring board **24** may be an appropriate wiring board **24** in which an electrically conductive material layer is formed on a surface of an insulating layer. The wiring board **24** may be a plate with an insulating layer formed by curing insulating material. Further, the wiring board **24** may be preferably a flexible wiring board. When a wiring board is flexible, it is possible to use the wiring board which is in a sheet shape, bendable, or rollable, and therefore handleablity can be improved. Consequently, it is possible to easily attach the wiring board **24.** The interconnection electrode extension part **23** formed on the wiring board **24** may be a layer with a desired pattern of the interconnection electrode extension part **23** or a layer formed by patterning an electrically conductive layer on the surface of the wiring board **24** by etching and the like.

The wiring board **24** may be attached to the surface of the enclosing member 2 with double face adhesive tape or bonding material. Bonding and fixing of the electrode piece 3 may be done in a similar manner to the specific embodiments of **FIG. 7** and **FIG. 9****.** In the specific embodiment of **FIG. 10****,** the electrically conductive fixer **21** and the electrically conductive bond **22** are formed separately. However, also in the present specific embodiment, like the specific embodiment of **FIG. 8****,** the electrically conductive fixer **21** and the electrically conductive bond **22** may be interconnected. In this case, the degree of fixing can be more improved.

Material of a body (insulating layer) of the wiring board **24** may be selected from a printed wiring board (e.g., FR4), a flexible substrate (e.g., made of polyimide), a ceramic substrate, and a silicon substrate, and the like. Electrode material formed on the wiring board **24** may have a stack structure of Au/Ni/Cu from the upmost layer, but is not limited to this.

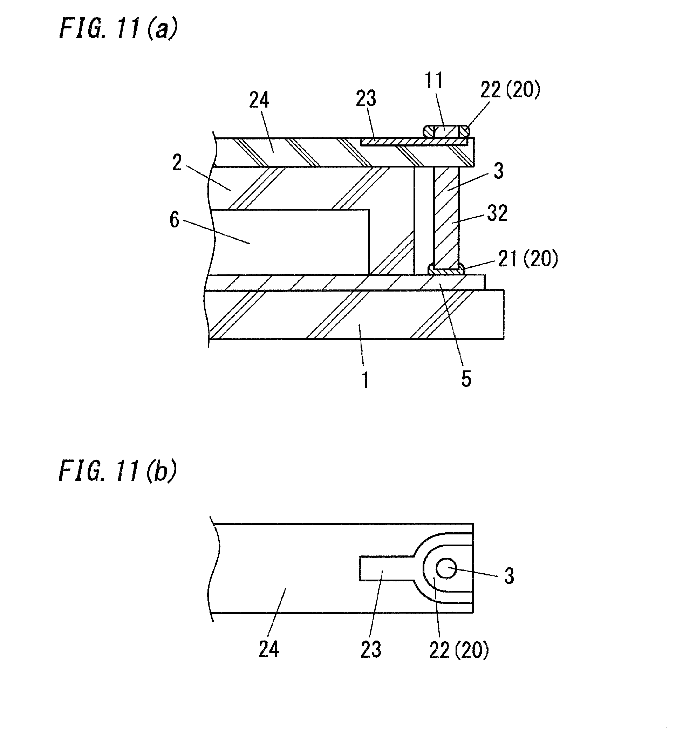

**FIG. 11** relates to another example of the embodiment of the organic EL element, and is an enlarged view illustrating the electrode piece **3** and its surroundings. **FIG. 11(a)** is a section. **FIG. 11(b)** is a plan, and however, the outside of the wiring board **24** is omitted. The present specific embodiment is the same as the specific embodiment of **FIG. 10** in that the wiring board **24** is provided to the enclosing member **2,** but is different from the specific embodiment of **FIG. 10** in a connection structure of the electrode piece **3** and the interconnection electrode extension part **23.**

In the specific embodiment of **FIG. 11****,** the wiring board **24** with the interconnection electrode extension part **23** is provided on the surface of the enclosing member **2** in a similar manner to the specific embodiment of **FIG. 10****.** This wiring board **24** is provided to extend outward relative to the enclosing member **2.** Further, the electrode piece **3** is not bent and has a straight shape (flat plate shape or pin shape). The electrode piece **3** penetrates through the wiring board **24** and provides therefrom at a position where the interconnection electrode extension part **23** is provided, and a part of the electrode piece **3** protruding from the wiring board **24** is fixed with the electrically conductive bond **22** made of the electrically conductive paste **20.** In the specific embodiment of **FIG. 11****,** it is possible to make a structure for facilitating supply of electricity to electrodes by use of the unbent electrode piece **3** such as a metal plate and a metal pin. Therefore, the configuration of the electrode piece **3** can be simplified and electrical connection can be made. Further, the interconnection electrode extension part **23** can be provided to the surface of the enclosing member **2** by only attaching the interconnection electrode extension part **23** to the wiring board **24.** Therefore, it is possible to easily and safely provide the interconnection electrode extension part **23.** Further, the interconnection electrode extension part **23** is provided to the wiring board **24,** and therefore it is possible to provide the interconnection electrode extension part **23** with appropriate pattern, and provide patterned circuit to the wiring board **24.** Consequently, the electric connectability can be improved and the degree of freedom of patterns of circuits can be improved.

The wiring board **24** may be the same as one described with regard to the specific embodiment of **FIG. 10****.** As shown in **FIG. 11(b)****,** the wiring board **24** may have a strip shape. It is preferable that the wiring board **24** include a through hole at a position where the interconnection electrode extension part **23** is provided. In this case, it is possible to attach the electrode piece **3** by inserting it into the through hole. Further, the front end of the electrode piece **3** may be sharpened, and a hole may be made in the wiring board **24** with the front end of the electrode piece **3.** In this case, the electrode piece **3** can easily penetrate through the wiring board **24.** When the interconnection electrode extension part **23** has a line shape, it may be broadened at a part where the electrode piece **3** is provided.

The wiring board **24** may be attached to the surface of the enclosing member **2** with double face adhesive tape or bonding material. Bonding and fixing of the electrode piece **3** may be done in a manner in conformity with a manner of the specific embodiment of **FIG. 10****.** For example, after the wiring board **24** is attached to the enclosing member **2,** the electrode piece **3** is moved closer to the wiring board **24** from outside to be inserted in the through hole, and the front end of the electrode piece **3** passing through the wiring board **24** is made in contact with the extended electrode part **5** and the electrically conductive paste **20.** Alternatively, by use of the electrode piece **3** with the sharp front end, the through hole may be formed with the front end of the electrode piece **3,** and the front end of the electrode piece **3** passing through the wiring board **24** may be made in contact with the extended electrode part **5** and the electrically conductive paste **20.** Thereafter, the electrically conductive paste **20** is provided to the part of the electrode piece **3** protruding from the wiring board **24,** and then the electrically conductive paste **20** is thermally cured, and thereby the electrode piece **3** can be fixed. Further, before the wiring board **24** is attached, the electrode piece **3** may be bonded to the extended electrode part **5** with the electrically conductive paste **20** in advance. In this case, the wiring board **24** is attached to the enclosing member **2** while the electrode piece **3** penetrating the wiring board **24,** and thereafter the part of the electrode piece **3** protruding from the wiring board **24** is bonded and fixed with the electrically conductive paste **20.**

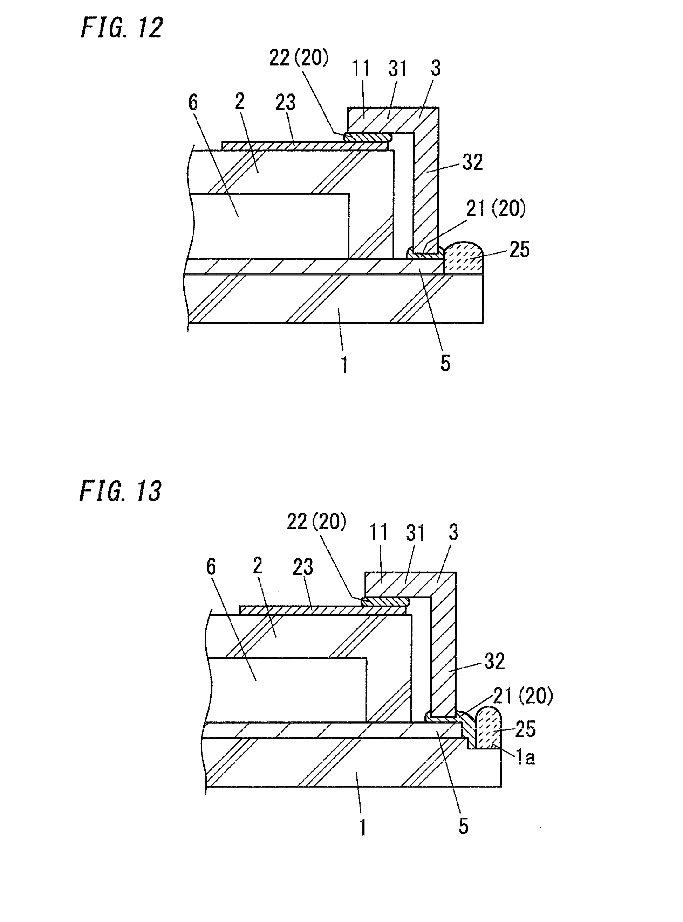

**FIG. 12** relates to another example of the embodiment of the organic EL element, and is an enlarged view illustrating the electrode piece **3** and its surroundings. The present specific embodiment is substantially the same as the specific embodiment of **FIG. 9** except an electrically insulating wall **25** is provided.

In the present specific embodiment, the electrically insulating wall **25** having an electrically insulating property is provided outside the extended electrode part **5** in the substrate **1.** By providing the electrically insulating wall **25** in this manner, it is possible to ensure an insulating distance at the outer peripheral part of the organic EL element and therefore insulation failure can be prevented. Further, in a case where the multiple organic EL elements are arranged in line or plane, electrodes of adjacent elements are likely to be in contact, and consequently short-circuiting may occur. However, the insulation distance is ensured by the electrically insulating wall **25** and therefore short-circuiting can be prevented. Further, in a case of using the electrically conductive paste **20,** the electrically conductive paste **20** has fluidity and hence it may flow out. However, the electrically insulating wall **25** can block a flow of the electrically conductive paste **20,** and therefore short-circuiting can be effectively prevented. In particular, in a case of crushing the electrically conductive paste **20** to be in contact with the fixed piece **32,** when the fixed piece **32** is pressed against the electrically conductive paste **20,** the electrically conductive paste **20** tends to flow laterally. However, the electrically insulating wall **25** can block spread of the electrically conductive paste **20.** The electrically insulating wall **25** and the electrically conductive fixer **21** may or may not be in contact. In a case where the electrically conductive paste **20** is cured while a flow of the electrically conductive paste **20** is blocked, the electrically insulating wall **25** and the electrically conductive fixer **21** are in contact.

It is preferable that the electrically insulating wall **25** have a thickness (height of the wall) which is greater than the thickness of the extended electrode part **5.** In this case, it is possible to block the electrically conductive paste **20** from flowing out. The electrically insulating wall **25** may surround the outer peripheral part of the substrate **1.** In this case, a flow of the electrically conductive paste **20** can be suppressed.

Note that, to make electrical connection between adjacent elements, part or whole of the electrically insulating wall **25** may not be provided with regard to the part for electrical connection. For example, the electrically insulating wall **25** may be divided to avoid the electric conduction part. In this case, the extended electrode part **5** or the electrically conductive fixer **21** may be formed to reach the peripheral edge of the substrate **1.**

The electrically insulating wall **25** and the extended electrode part **5** may or may not be in contact. When the electrically insulating wall **25** and the extended electrode part **5** are in close contact, the proportion of the non-light emitting region can be decreased. In contrast, in a case where the electrically insulating wall **25** and the extended electrode part **5** are not in contact and there is a gap between the electrically insulating wall **25** and the extended electrode part **5,** when the electrically conductive paste **20** flows out, it flows into the gap and thus can be stored in the gap. Hence, it is possible to more suppress the electrically conductive paste **20** from flowing out through the end part. Therefore, the electrically insulating property can be improved.

The inside part of the electrically insulating wall **25** may overlap the surface of the extended electrode part **5.** In this case, the thickness of the electrically insulating wall **25** is increased, and therefore it is possible to more suppress the electrically conductive paste **20** from flowing out.

The electrically insulating wall **25** may be made of appropriate electrically insulating material. For example, the electrically insulating wall **25** may be made of resin or the like. In this case, the electrically insulating wall **25** can be formed by applying electrically insulating resin on the surface of the substrate **1** with a dispenser or the like and curing it. Alternatively, the electrically insulating wall **25** may be formed by attaching a linear resin member to the outer peripheral part of the substrate **1.** When the electrically conductive paste **20** is applied under a condition where the electrically insulating wall **25** is provided, the electrically conductive paste **20** comes into contact with the electrically insulating wall **25** and thus is blocked, and does not flow out. Thereafter, when the electrically conductive paste **20** is cured, curing is completed while the electrically conductive fixer **21** and the electrically insulating wall **25** are in contact.

Further, the electrically insulating wall **25** and the electrically conductive paste **20** may be cured simultaneously. For example, the electrically insulating wall **25** is made of resin material having such viscosity that the electrically insulating wall **25** can retain its original shape, and a flow of the electrically conductive paste **20** is blocked by the uncured electrically insulating wall **25,** and thereafter the electrically insulating wall **25** and the electrically conductive paste **20** can be cured simultaneously by heating. In this case, thermal curing for different member can be done simultaneously, and therefore the electrode piece **3** can be attached efficiently. In this regard, materials are selected so that the electrically conductive paste **20** and the uncured electrically insulating wall **25** do not mix. However, to more successfully prevent the electrically conductive paste **20** from flowing out, it is preferable that the electrically conductive paste **20** be applied after the electrically insulating wall **25** is cured.

It is preferable that the electrically insulating wall **25** be formed after enclosing. By doing so, it is possible to easily provide the electrically insulating wall **25** without damaging the element. Note that, the electrically insulating wall **25** may be formed at appropriate timing before completion of enclosing. For example, the electrically insulating wall **25** may be formed on the surface of the substrate **1** before the first electrode **7** and the extended electrode part **5** are provided, or may be formed on the surface of the substrate **1** after the extended electrode part **5** is provided and before the organic layer **8** is formed.

**FIG. 12** shows the embodiment in which the electrically insulating wall **25** is provided to the specific embodiment of **FIG. 9****.** However, the electrically insulating wall **25** may be also provided to any of other embodiments including the electrically conductive paste **20** (see **FIG. 4** to **FIG. 11****).** In this case, by providing the electrically insulating wall **25,** it is possible to ensure the insulation distance and obtain the element with high electric conduction reliability.

**FIG. 13** relates to another example of the embodiment of the organic EL element, and is an enlarged view illustrating the electrode piece **3** and its surroundings. In the present specific embodiment, the electrically insulating wall **25** is provided in a similar manner to the specific embodiment of **FIG. 12****.** The present specific embodiment has substantially the same configuration as the specific embodiment of **FIG. 12** but is different from the specific embodiment of **FIG. 12** in the shape of the end part of the substrate **1.** The same configurations as the specific embodiment of **FIG. 12** are designated by the same reference signs as the embodiment **FIG. 12** and their explanations are omitted.

In the present specific embodiment, the electrically insulating wall **25** having an electrically insulating property is provided outside the extended electrode part **5** in the substrate **1.** Therefore, the present specific embodiment gives the same effects as the specific embodiment of **FIG. 12****.**

Further, in the present specific embodiment, a stepped part **1a** is formed at a boundary part between the surface and the side face of the substrate **1** so as to be positioned more outward than the extended electrode part **5.** The stepped part **1a** is a recessed part of the surface at the end part of the substrate **1.** Further, the electrically insulating wall **25** is formed in contact with a surface of the stepped part **1a,** and the electrically conductive fixer **21** is in contact with the electrically insulating wall **25.** Therefore, the electrically conductive paste **20** can be stored in the stepped part **1a** of the substrate **1,** and thus the electrically insulating property at the outer peripheral part of the substrate **1** can be more improved.

The electrically insulating wall **25** is formed on a bottom of the stepped part **1a.** It is preferable that the electrically insulating wall **25** be not in contact with a side face of the stepped part **1a.** In other words, it is preferable that there be a gap between the electrically insulating wall **25** and the side surface of the stepped part **1a.** In this case, the electrically conductive paste **20** is allowed to flow into the gap and is held in the gap, and therefore it is possible to more suppress the electrically conductive paste **20** from flowing out.

The production method and the material of the electrically insulating wall **25** are similar to those of the specific embodiment of **FIG. 12****.**

FIG. 14 relates to another example of the embodiment of the organic EL element, and is an enlarged view illustrating the electrode piece **3** and its surroundings. In the present specific embodiment, the electrically insulating wall **25** is provided in a similar manner to the specific embodiments of **FIG. 12** and **FIG. 13****.** The present specific embodiment has substantially the same configuration as the specific embodiment of **FIG. 13** but is different from the specific embodiment of **FIG. 13** in the shape of the electrically insulating wall **25.** The same configurations as the specific embodiments of **FIG. 12** and **FIG. 13** are designated by the same reference signs as the specific embodiments **FIG. 12** and **FIG. 13** and their explanations are omitted.

In the present specific embodiment, in a similar manner to the specific embodiment of **FIG. 13****,** the stepped part **1a** is formed and the electrically insulating wall **25** is formed in contact with the stepped part **1a.** Further, the electrically insulating wall **25** covers a surface of an outside part of the electrically conductive fixer **21.** As described above, in a preferable embodiment, the electrically insulating wall **25** covers the electrically conductive fixer **21.** In this regard, the electrically insulating property at the outer peripheral part can be more improved. Further, by providing the stepped part **1a,** it is possible to suppress the electrically conductive fixer **21** made of the electrically conductive paste **20** from protruding outward.

The electrically insulating wall **25** may be provided after the electrically conductive fixer **21** is formed. By doing so, it is possible to easily cover the electrically conductive fixer **21.** For example, the electrode piece **3** is fixed with the electrically conductive paste **20,** and thereafter electrically insulating material is applied to cover the electrically conductive fixer **21** formed by curing the electrically conductive paste **20.** Thereby, the electrically insulating wall **25** can be formed. If the electrically insulating wall **25** does not mix with the electrically conductive paste **20,** the electrically insulating wall **25** may be formed by applying electrically insulating material before the electrically conductive paste **20** for forming the electrically conductive fixer **21** is disposed and cured.

Note that, with regard to the specific embodiments including the electrically conductive paste **20** as shown in **FIG. 4** to **FIG. 14****,** the end part of the supported piece **31** may be supported by and fixed to the electrode piece supporter **4.** In this case, the degree of fixing can be more improved by the electrode piece supporter **4.**

**FIG. 15** relates to another example of the embodiment of the organic EL element. The present specific embodiment has the same configuration as the specific embodiment of **FIG. 1** but is different from the specific embodiment of **FIG. 1** in the enclosing structure. The same configurations as the specific embodiment of **FIG. 1** are designated by the same reference signs as the embodiment **FIG. 1** and their explanations are omitted.

In the specific embodiment of **FIG. 15****,** the enclosing member **2** is constituted by a facing substrate **2a** and an enclosing side wall **2b.** The facing substrate **2a** faces the substrate **1** and has a flat plate shape with a flat surface. The enclosing side wall **2b** is provided between the substrate **1** and the facing substrate **2a** at an outer peripheral part of the facing substrate **2a.** The facing substrate **2a** may be made of a glass substrate. The enclosing side wall **2b** may be made of enclosing resin material. The enclosing resin material may be thermosetting or photocurable resin composition. It is preferable that the enclosing resin material include desiccant. Further, it is preferable that the enclosing resin material have adhesiveness. In this case, the facing substrate **2a** can be bonded to the substrate **1** with the enclosing resin material. The enclosing side wall **2b** is thicker than the organic light emitter **10.** In this case, a space to an extent of the thickness of the organic light emitter **10** is ensured, and therefore the organic light emitter **10** can be enclosed by use of the flat facing substrate **2a.** Further, the enclosed space **6** is filled with the filler **6b.** It is preferable that the filler **6b** include desiccant and have adhesiveness. The enclosing side wall **2b** may serve as a dam layer for holding the filler **6b** at the time of filling of the filler **6.**

In the present specific embodiment, the height of the enclosing member **2** is equal to the sum of the thickness (height) of the enclosing side wall **2b** and the thickness of the facing substrate **2a.** In this regard, the enclosing side wall **2b** can be made of resin, and therefore the thickness thereof can be easily adjusted. Therefore, it is possible to easily adjust the height of the enclosing member **2.** Adjustment of the height of the enclosing member **2** can be easily done according to the length of the fixed piece **32** of the electrode piece **3.** Thereby the distance between the electrode piece **3** and the extended electrode part **5** and force of pressing by the electrode piece **3** can be adjusted.

In the present specific embodiment, the electrode piece **3** is pressed against the extended electrode part **5** and consequently it is possible to firmly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate 1 and the enclosing member **2** with the electrically conductive paste **20.** In this case, the fixed piece **32** may or may not be pressed against the extended electrode part **5.**

**FIG. 16** relates to another example of the embodiment of the organic EL element, and is an enlarged view illustrating the electrode piece **3** and its surroundings. The present specific embodiment has the same configuration as the specific embodiment of **FIG. 1** but is different from the specific embodiment of **FIG. 1** in the shape of the electrode piece **3.** The same configurations as the specific embodiment of **FIG. 1** are designated by the same reference signs as the embodiment **FIG. 1** and their explanations are omitted.

In the specific embodiment of **FIG. 16****,** the electrode piece **3** has a face contact piece **33** which is formed by bending the front end of the fixed piece **32** inward. The face contact piece **33** is formed almost perpendicular to the fixed piece **32,** and is disposed in parallel with the surface of the substrate **1.** When the face contact piece **33** is provided in this manner, the electrode piece **3** can be bonded to the extended electrode part **5** at the surface of the face contact piece **33,** or the electrode piece **3** can be pressed against the extended electrode part **5** at the surface of the face contact piece **33,** a contact area between the electrode piece **3** and the extended electrode part **5** can be increased, and therefore the electric connectability can be improved. Further, when the electrode piece **3** is pressed against the extended electrode part **5** at a piece with a sharp front end, in some cases the extended electrode part **5** and the substrate **1** may be damaged. In the present specific embodiment, the electrode piece **3** can be pressed against the extended electrode part **5** at the surface of the face contact piece **33,** and therefore the damages on the element can be prevented.

In the present specific embodiment, the electrode piece **3** is pressed against the extended electrode part **5** and consequently it is possible to firmly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the face contact piece **33** may not be in direct contact with the extended electrode part **5.** In this regard, it is sufficient that the face contact piece **33** is electrically connected to the extended electrode part **5** through the electrically conductive paste **20** (the electrically conductive fixer **21).**

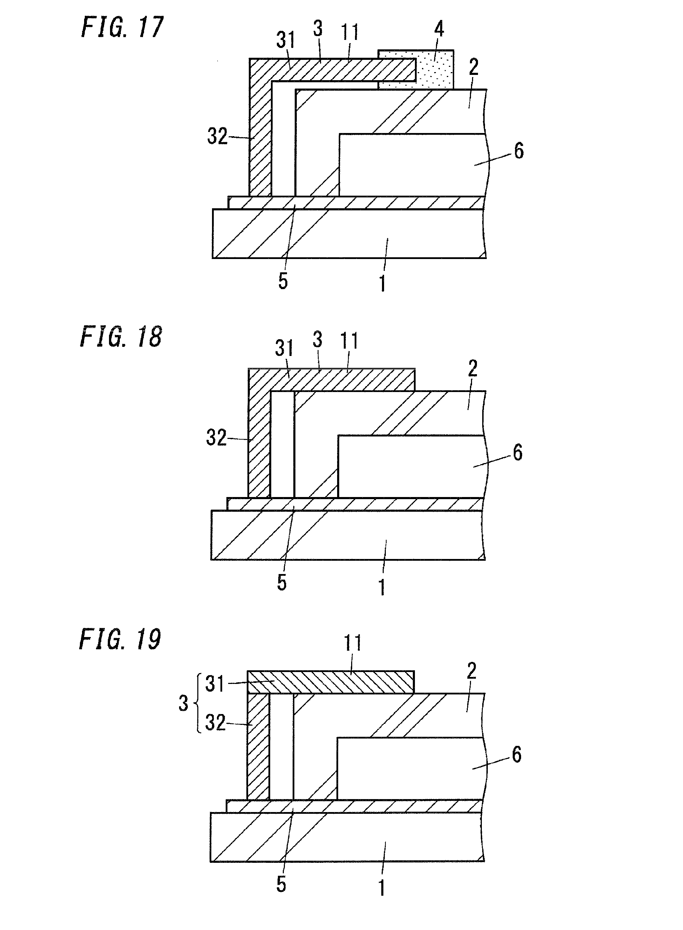

**FIG. 17** relates to another example of the embodiment of the organic EL element, and is an enlarged view illustrating the electrode piece **3** and its surroundings. The present specific embodiment has the same configurations as the specific embodiment of **FIG. 1** but is different from the specific embodiment of **FIG. 1** in the structure for supporting the electrode piece **3.** The same configurations as the specific embodiment of **FIG. 1** are designated by the same reference signs as the embodiment **FIG. 1** and their explanations are omitted.

In the specific embodiment of **FIG. 17****,** the electrode piece **3** is supported and fixed so that the electrode piece **3** is positioned at a distance from the enclosing member **2** and the end part of the electrode piece **3** is embedded in the electrode piece supporter **4.** Therefore, there is a gap formed between the electrode piece **3** and the surface of the enclosing member **2.** Therefore, the electrode piece **3** can be more elastically deformed, and the spring property can be improved, and it is possible to press strongly the electrode piece **3** against the extended electrode part **5.** Further, a height position of the electrode piece **3** can be adjusted by the electrode piece supporter **4.** Therefore, spring force can be easily adjusted. Further, it becomes easy to adjust force of pressing the electrode piece **3** against the extended electrode part **5,** and therefore the electric connectability can be improved.

In the specific embodiment of **FIG. 17****,** the electrode piece supporter **4** may be constituted by a first layer (base part) close to the enclosing member **2,** and a second layer (cover part) facing the first layer. The electrode piece **3** may be supported and fixed by interposing the end part of the supported piece **31** between the first layer and the second layer. In this case, it is preferable that the first layer be formed first and then the electrode piece **3** be disposed and thereafter the second layer be formed. By doing so, it becomes easy to adjust the height of the first layer, and it is possible to easily adjust the spring property.

Further, in the specific embodiment of **FIG. 17****,** the electrode piece supporter **4** may be a casing made of plastic material or the like. In this case, first the electrode piece **3** is fixed by being fitted into the electrode piece supporter **4** and next the electrode piece supporter **4** to which the electrode piece **3** is fixed is fixed to the enclosing member **2.** Thereby, the electrode piece **3** can be attached so as to be pressed against the extended electrode part **5.** Fixing of the electrode piece supporter **4** can be done by use of bonding material, for example.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.**

**FIG. 18** relates to another example of the embodiment of the organic EL element, and is an enlarged view illustrating the electrode piece **3** and its surroundings. The present specific embodiment has the same configurations as the specific embodiment of **FIG. 1** but is different from the specific embodiment of **FIG. 1** in the structure for supporting the electrode piece **3.** The same configurations as the specific embodiment of **FIG. 1** are designated by the same reference signs as the embodiment **FIG. 1** and their explanations are omitted.

In the specific embodiment of **FIG. 18****,** the electrode piece **3** is supported and fixed by bonding the end part of the supported piece **31** to the surface of the enclosing member **2.** Bonding of the electrode piece **3** can be done by use of double face adhesive tape or the like. Further, the present specific embodiment is devoid of the electrode piece supporter **4** which supports and fixes the electrode piece **3** so as to cover the end part of the electrode piece **3.** Therefore, it is possible to easily support and fix the electrode piece **3,** and thus attachment of the electrode piece **3** can be facilitated.

Note that, the structure for supporting and fixing the electrode piece **3** is not limited to the structure including the electrode piece supporter **4,** the structure including double face adhesive tape, or the like. For example, a groove-like recess is provided to the end part of the surface of the enclosing member **2,** and the end part of the supported piece **31** is fitted into the recess, and thereby the electrode piece **3** is supported and fixed.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.**

**FIG. 19** relates to another example of the embodiment of the organic EL element, and is an enlarged view illustrating the electrode piece **3** and its surroundings. The present specific embodiment has the same configurations as the specific embodiment of **FIG. 18** but is different from the specific embodiment of **FIG. 18** in the configuration of the electrode piece **3** and the structure for supporting the electrode piece **3.** The same configurations as the above embodiment are designated by the same reference signs as the above embodiment and their explanations are omitted.

In the specific embodiment of **FIG. 19****,** the electrode piece **3** is not constituted by a single metal piece but is constituted by multiple (in the present specific embodiment, two) metal pieces. In more detail, the electrode piece **3** is constituted by a first metal piece serving as the supported piece **31,** and a second metal piece serving as the fixed piece **32.** The end part of the supported piece **31** may be supported on and fixed to the enclosing member **2** with double face adhesive tape in a similar manner to the specific embodiment of **FIG. 18****.** Alternatively, in a similar manner to the specific embodiment of **FIG. 1****,** the end part of the supported piece **31** may be supported on and fixed to the electrode piece supporter **4.** Further, the end part (the extension part) of the supported piece **31,** which protrudes outward relative to the enclosing member **2** presses one of opposite end parts of the fixed piece **32** against the substrate **1,** and by such pressing force, the other (the end part close to the substrate **1)** of the opposite ends of the fixed piece **32** is pressed against the extended electrode part **5.** In the present specific embodiment, the electrode piece **3** can be formed by use of metal pieces with flat plate shapes having flat surfaces, and therefore the structure of pressing the electrode piece **3** against the extended electrode part **5** can be easily formed.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.** Further, the supported piece **31** and the fixed piece **32** may be bonded to each other with the electrically conductive paste **20.**

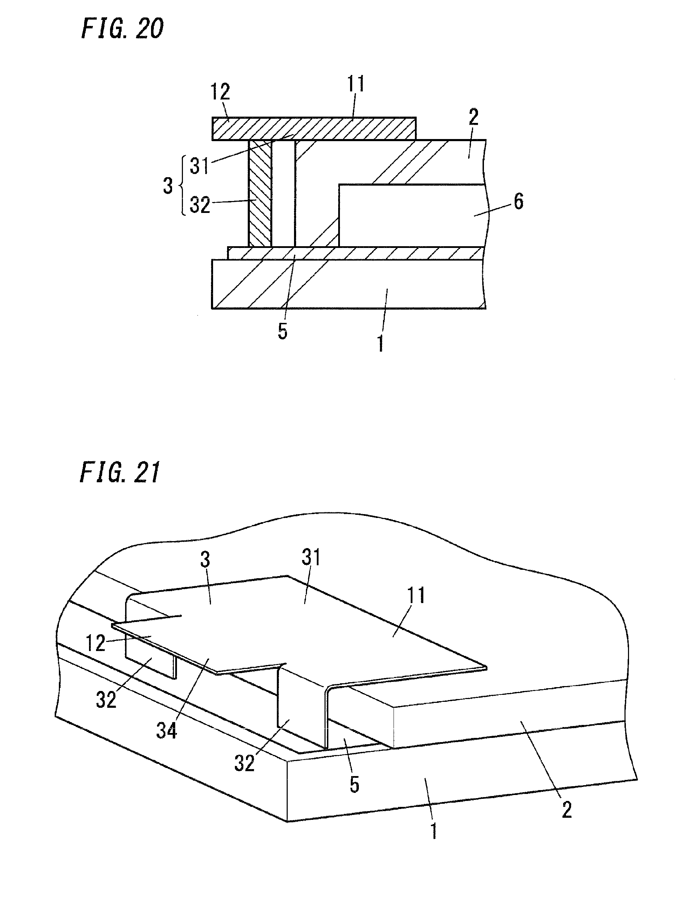

**FIG. 20** relates to another example of the embodiment of the organic EL element, and is an enlarged view illustrating the electrode piece **3** and its surroundings. The present specific embodiment has the same configurations as the specific embodiment of **FIG. 19** but is different from the specific embodiment of **FIG. 19** in the configuration of the electrode piece **3.** The same configurations as the above embodiment are designated by the same reference signs as the above embodiment and their explanations are omitted.

In the specific embodiment of **FIG. 20****,** as with the specific embodiment of **FIG. 19****,** the electrode piece **3** is not constituted by a single metal piece, but is constituted by multiple (two in the present specific embodiment) metal pieces. Further, the end part (the extension part) of the supported piece **31,** which protrudes outward relative to the enclosing member **2** presses one of opposite end parts of the fixed piece **32** against the substrate **1,** and by such pressing force, the other (the end part close to the substrate **1)** of the opposite ends of the fixed piece **32** is pressed against the extended electrode part **5.** Note that, the specific embodiment of **FIG. 20** does not include the electrode piece supporter **4.** However, the electrode piece supporter **4** may be provided.

Further, in the present specific embodiment, the supported piece **31** extends outward so as to protrude outward relative to a position where the electrode piece **3** is fixed to the extended electrode part **5** (i.e., a position where the electrode piece **3** is pressed against the extended electrode part **5).** A region of the supported piece **31,** which protrudes outward relative to the fixed piece **32,** serves as a terminal **12** which means a part to be electrically connected to another terminal.

As described above, in a preferable embodiment, the electrode piece **3** includes the terminal **12** protruding outward relative to the position at which the electrode piece **3** is pressed against the extended electrode part **5,** that is, the position at which the electrode piece **3** is fixed to the extended electrode part **5.** In this case, in a process of forming a surface illumination device with a relatively large light emitting area by arranging the multiple organic EL elements in a plane, adjacent organic EL elements can be electrically interconnected by use of the terminals **12.** Consequently, the connectability can be improved.

The outside peripheral edge of the supported piece **31** may be positioned at substantially the same position as the peripheral edge of the substrate **1.** When the metal piece extends to reach the peripheral edge of the substrate **1,** the connectability in a plan view, the connectability can be improved.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.** Further, the supported piece **31** and the fixed piece **32** may be bonded to each other with the electrically conductive paste **20.**

**FIG. 21** relates to another example of the embodiment of the organic EL element, and is an enlarged view illustrating the electrode piece **3** and its surroundings. **FIG. 21** shows another example of the electrode piece **3** including the terminal **12.** The same configurations as the above embodiment are designated by the same reference signs as the above embodiment and their explanations are omitted.

In the electrode piece **3** of the present specific embodiment, the fixed pieces **32** are formed so as to be branched off from both side parts of the supported piece **31.** A terminal piece **34,** which extends outward continuously from the supported piece **31** so as to protrude outward, is branched off from a part of the electrode piece **3** at which the fixed piece **32** are branched off. This electrode piece **3** can be formed by cutting-in and bending a metal piece. In the present specific embodiment, as with the specific embodiment of **FIG. 20****,** the terminal **12** is provided, and consequently adjacent organic EL elements can be electrically connected easily.

In the electrode piece **3** shown in **FIG.** 21, the electrode piece **3** can be formed as a single part. Therefore, the strength of the electrode piece **3** can be improved, and the spring property can be enhanced, and therefore the force of pressing the electrode piece **3** against the extended electrode part **5** can be improved. Further, the terminal **12** protruding outward can be easily formed of the electrode piece **3** provided as a single part. Note that, the specific embodiment of **FIG. 21** does not include the electrode piece supporter **4.** However, the electrode piece supporter **4** may be provided.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.** Further, the supported piece **31** and the fixed piece **32** may be bonded to each other with the electrically conductive paste **20.**

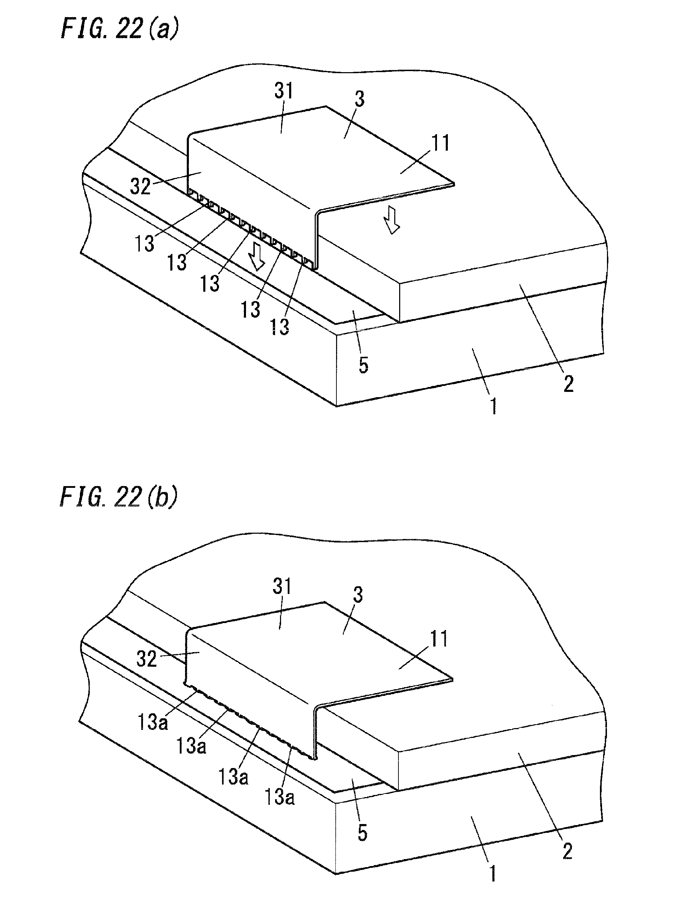

**FIG. 22** relates to another example of the embodiment of the organic EL element. **FIG. 22(a)** shows a situation before the electrode piece **3** is attached, and **FIG. 22(b)** shows a situation after the electrode piece **3** is attached. The same configurations as the above embodiment are designated by the same reference signs as the above embodiment and their explanations are omitted.

As shown in **FIG. 22(a)****,** in the present specific embodiment, the electrode piece **3** includes a plurality of protrusions **13.** Further, as shown in **FIG. 22(b)****,** in a process of attaching the electrode piece **3,** the protrusions **13** are crushed, and thereby crushed protrusions **13a** are formed. As described above, it is preferable that the electrode piece **3** and the extended electrode part **5** are connected by crushing a plurality of protrusions **13** with electrically conductive properties at a boundary part therebetween. The electrode piece **3** is pressed against the extended electrode part **5** by crushing the plurality of protrusions **13,** and therefore the electric connectability can be improved. Note that, the specific embodiment of **FIG. 22** does not include the electrode piece supporter **4.** However, the electrode piece supporter **4** may be provided.

As shown in **FIG. 22(a)****,** in the present specific embodiment, the plurality of protrusions **13** is provided to the front end of the fixed piece **32** of the electrode piece **3.** The protrusions **13** may be made of the same material as the electrode piece **3,** or may be made of other electrically conductive material. Further, the electrode piece **3** is moved closer to the substrate **1** from the enclosing member **2** side, and the end part of the supported piece **31** is supported and fixed, and the fixed piece **32** is pressed against the substrate **1.** Then, as shown in **FIG. 22(b)****,** the fixed piece **32** is pressed against the extended electrode part **5,** and consequently the protrusions **13** are crushed. Thereby, the crushed protrusions **13a** resulting from crushing of the protrusions **13** are formed at a boundary portion between the electrode piece **3** and the extended electrode part **5.** Therefore, it is possible to improve the electric connectability. Note that, in **FIG. 22****,** the protrusions **13** are provided to the electrode piece **3.** However, the protrusions **13** may be provided to the surface of the interconnection electrode **11.** In summary, it is sufficient that the protrusions **13** are at the boundary portion between the electrode piece **3** and the extended electrode part **5.**

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In a case of using the electrically conductive paste **20,** the protrusions **13** may be embedded into the electrically conductive paste **20** (the electrically conductive fixer **21).**

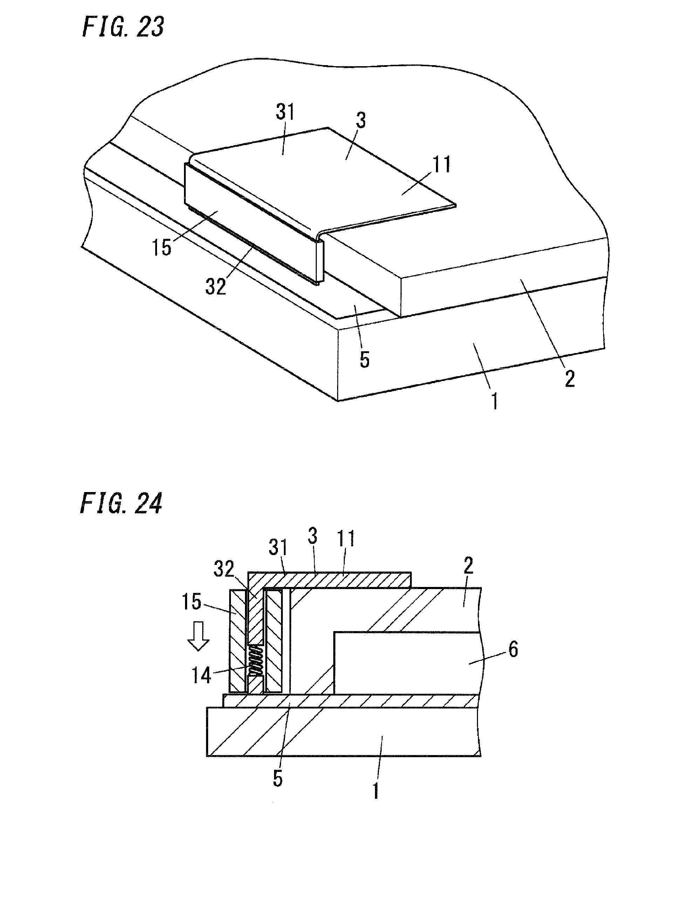

**FIG. 23** relates to another example of the embodiment of the organic EL element, and is an enlarged view illustrating the electrode piece **3** and its surroundings. The same configurations as the above embodiment are designated by the same reference signs as the above embodiment and their explanations are omitted.

In the specific embodiment of **FIG. 23****,** the fixed piece **32** of the electrode piece **3** is housed in a housing **15** which has a hollow cylindrical shape and includes openings at upper and lower ends. The housing **15** may be made of electrically insulating material such as resin and plastic or may be made of metal. The height of the housing **15** with a cylindrical shape is shorter than the length of the fixed piece **32,** and the front end of the fixed piece **32** protrudes outward (toward the substrate 1) relative to the housing **15.** Further, the front end of the fixed piece **32** which protrudes outward (toward the substrate **1)** relative to the housing **15** is pressed against the extended electrode part **5.**

In the present specific embodiment, the fixed piece **32** of the electrode piece **3** is surrounded by the housing **15** and consequently it is possible to suppress damage to and breakage of the electrode piece **3.** Further, the housing **15** may be bonded to the substrate **1.** In this case, the degree of fixing can be more improved. Note that, in the present specific embodiment, the housing **15** surrounds the fixed piece **32.** However, the housing **15** is not limited to this and may surround the supported piece **31** if it is possible to ensure the interconnection electrode **11.** Note that, the specific embodiment of **FIG. 23** does not include the electrode piece supporter **4.** However, the electrode piece supporter **4** may be provided.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In a case of using the electrically conductive paste **20,** the protrusions **13** may be embedded into the electrically conductive paste **20** (the electrically conductive fixer **21).**

**FIG. 24** relates to another example of the embodiment of the organic EL element, and is an enlarged view illustrating the electrode piece **3** and its surroundings. The same configurations as the above embodiment are designated by the same reference signs as the above embodiment and their explanations are omitted.

In the specific embodiment of **FIG. 24****,** the electrode piece **3** and the extended electrode part **5** are connected with an elastic member **14** with electrically conductive properties being compressed near a boundary part therebetween. As described above, the elastic member **14** is provided and therefore the force of pressing the electrode piece **3** against the extended electrode part **5** can be reinforced by bounce in the elastic member **14.**

In the specific embodiment of **FIG. 24****,** the fixed piece **32** of the electrode piece **3** includes the elastic member **14** having a coil spring shape at a position near the boundary part between the fixed piece **32** and the extended electrode part **5.** The elastic member **14** is housed in the housing **15.** Therefore, it is possible to protect the elastic member **14** tending to have weak strength. When the electrode piece **3** is pressed against the extended electrode part **5,** the elastic member **14** is deformed to be compressed. However, the elastic member **14** has a coil spring shape, and therefore the force to recover this deformation occurs. Then, the front end part of the fixed piece **32,** which is closer to a front side than the elastic member **14** is, is pressed against the extended electrode part **5.** Therefore, the electric connectability can be improved. In the present specific embodiment, the electrode piece **3** may be formed as a single part by an appropriate molding method. Alternatively, the electrode piece **3** may be constituted by multiple metal pieces such as a metal piece serving as the supported piece **31** and a metal piece serving as the fixed piece **32.** Further, the electrode piece **3** may be formed by forming the elastic member **14** as a separate part from a metal piece, and bonding the elastic member **14** to the metal piece.

In the present specific embodiment, the electrode piece **3** is pressed against the extended electrode part **5** by use of the elastic member **14** having a coil spring shape, and therefore the force of pressing the electrode piece **3** against the extended electrode part **5** is absorbed in the elastic member **14.** Therefore, deformation of the electrode piece **3** as a whole is suppressed, and consequently, the electrode piece **3** can be attached so as to be in close contact with the surface of the enclosing member **2** and it is possible to prevent the electrode piece **3** from bulging due to the deformation.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In a case of using the electrically conductive paste **20,** the protrusions **13** may be embedded into the electrically conductive paste **20** (the electrically conductive fixer **21).**

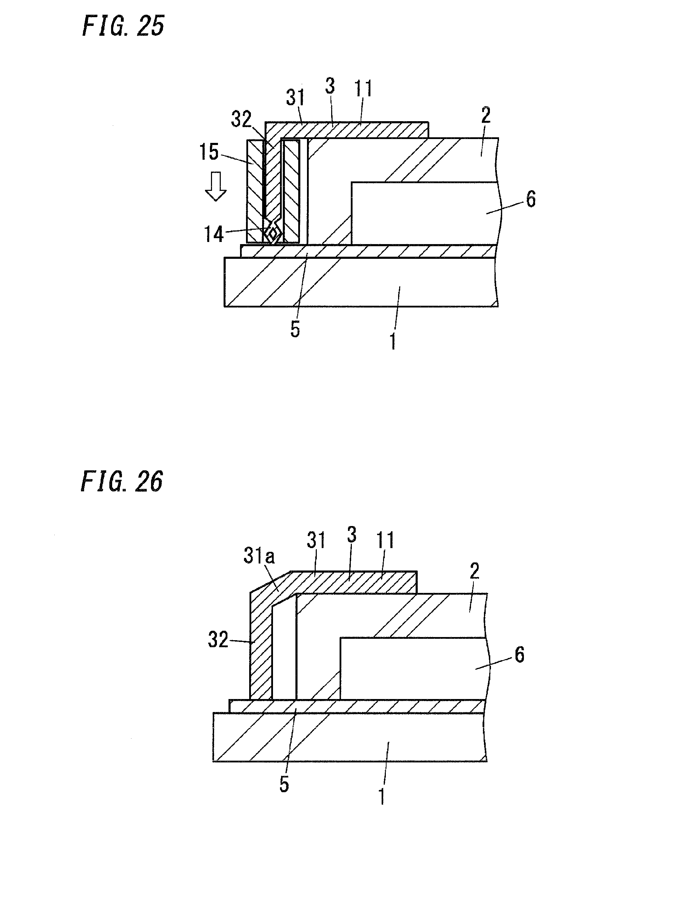

**FIG. 25** relates to another example of the embodiment of the organic EL element, and is an enlarged view illustrating the electrode piece **3** and its surroundings. The same configurations as the above embodiment are designated by the same reference signs as the above embodiment and their explanations are omitted.

In the specific embodiment of **FIG. 25****,** the electrode piece **3** and the extended electrode part **5** are connected with the elastic member **14** with electrically conductive properties being compressed at the boundary part therebetween. As described above, the elastic member **14** is provided and therefore the force of pressing the electrode piece **3** against the extended electrode part **5** can be reinforced by bounce in the elastic member **14.**

In the specific embodiment of **FIG. 25****,** the fixed piece **32** of the electrode piece **3** includes the elastic member **14** having a stretchable plate spring shape at the front end part which is also the boundary part between the fixed piece **32** and the extended electrode part **5.** The front end of the elastic member **14** protrudes outward from the housing **15.** When the electrode piece **3** is pressed against the extended electrode part **5,** the elastic member **14** is deformed to be compressed. However, the force to recover this deformation occurs in the elastic member **14.** The elastic member **14** is deformed and thus bounces in the elastic member **14** presses the electrode piece **3** against the extended electrode part **5.** Therefore, the electric connectability can be improved. In the present specific embodiment, the electrode piece **3** may be formed as a single part by an appropriate molding method. Alternatively, the electrode piece **3** may be constituted by multiple metal pieces such as a metal piece serving as the supported piece **31** and a metal piece serving as the fixed piece **32.** Further, the electrode piece **3** may be formed by forming the elastic member **14** as a separate part from a metal piece, and bonding the elastic member **14** to the metal piece.

In the present specific embodiment, the electrode piece **3** is pressed against the extended electrode part **5** by use of the elastic member **14** having a plate spring shape, and therefore the force of pressing the electrode piece **3** against the extended electrode part **5** is absorbed in the elastic member **14.** Therefore, deformation of the electrode piece **3** as a whole is suppressed, and consequently, the electrode piece **3** can be attached so as to be in close contact with the surface of the enclosing member **2** and it is possible to prevent the electrode piece **3** from bulging due to the deformation.

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In a case of using the electrically conductive paste **20,** the protrusions **13** may be embedded into the electrically conductive paste **20** (the electrically conductive fixer **21).**

Note that, in each of the specific embodiments of **FIG. 24** and **FIG. 25****,** the elastic member **14** is provided to the electrode piece **3.** However, the elastic member **14** may be provided to the extended electrode part **5.** Further, the elastic member **14** may be formed as a separate member (elastic member) from the electrode piece **3,** and this elastic member is interposed between the fixed piece **32** and the extended electrode part **5** so that the electrode piece **3** is pressed against the elastic member.

**FIG. 26** relates to another example of the embodiment of the organic EL element, and is an enlarged view illustrating the electrode piece **3** and its surroundings. The same configurations as the above embodiment are designated by the same reference signs as the above embodiment and their explanations are omitted.

In the electrode piece **3** of the present specific embodiment, the supported piece **31** includes an inward bending part **31a,** which bends inward to be directed in a direction close to the substrate **1,** at a part protruding outward relative to the enclosing member **2.** Further, the length of the fixed piece **32** is shorter than the height of the enclosing member **2.** However, the inward bending part **31a** is formed and thus the front end part of the supported piece **31** bends. Consequently, the front end of the fixed piece **32** is pressed against the extended electrode part **5.** In summary, the electrode piece **3** is plastically deformed. In the present specific embodiment, the length of the fixed piece **32** may be more than **0.5** times longer than and be shorter than the height of the enclosing member **2,** but is not limited to this.

In the present specific embodiment, inward bending part **31a** is formed, and therefore the boundary portion between the supported piece **31** and the fixed piece **32** is inclined. The end part of the rear surface of the element is recessed inward, and therefore bulge at the electrode piece **3** can be prevented. Further, the inward bending part **31a** can suppress deformation of the electrode piece **3** as a whole, and it is possible to reduce load on the element due to excess strain caused by deformation of the electrode piece **3.**

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.**

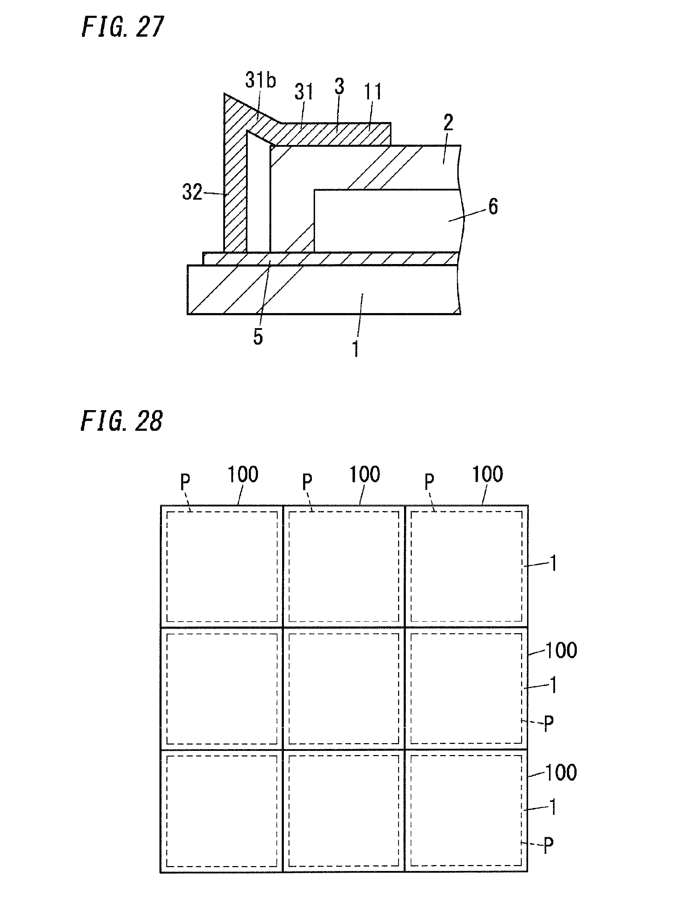

**FIG. 27** relates to another example of the embodiment of the organic EL element, and is an enlarged view illustrating the electrode piece **3** and its surroundings. The same configurations as the above embodiment are designated by the same reference signs as the above embodiment and their explanations are omitted.

In the electrode piece **3** of the present specific embodiment, the supported piece **31** includes an outward bending part **31b,** which bends outward to be directed in a direction away from the substrate **1,** at a part protruding outward relative to a vicinity of the end part of the enclosing member **2.** Further, the length of the fixed piece **32** is longer than the height of the enclosing member **2.** However, the outward bending part **31b** is formed and thus the front end part of the supported piece **31** bends. Consequently, the front end of the fixed piece **32** is pressed against the extended electrode part **5** at appropriate pressing force. In the present specific embodiment, the length of the fixed piece **32** may be longer than and less than **5** times shorter than the height of the enclosing member **2,** but is not limited to this.

In the present specific embodiment, the outward bending part **31b** is formed at the boundary portion between the supported piece **31** and the fixed piece **32** is inclined. When the outward bending part **31b** is deformed, the spring property comes into effect. Therefore, the force of pressing the electrode piece **3** against the extended electrode part **5** efficiently acts on the extended electrode part **5.** Thus, the force of pressing the electrode piece **3** against the extended electrode part **5** can be enhanced. Further, the fixed piece **32** is pressed against the extended electrode part **5** while the outward bending part **31b** is deformed. Therefore, it becomes easy to adjust the force of pressing the electrode piece **3** against the extended electrode part **5** to an appropriate one. Further, the outward bending part **31b** can suppress deformation of the electrode piece **3** as a whole, and it is possible to reduce load on the element due to excess strain caused by deformation of the electrode piece **3.**

In the present specific embodiment, the electrode piece **3** is pressed against the extended electrode part **5,** and therefore it is possible to strongly fix the electrode piece **3** to the extended electrode part **5.** In this regard, there may be no need to provide the electrically conductive paste **20.** Further, also in the present specific embodiment, the electrode piece **3** is bonded and fixed directly or indirectly to at least one of the substrate **1** and the enclosing member **2** with the electrically conductive paste **20.** In this case, the front end of the fixed piece **32** may or may not be in direct contact with the extended electrode part **5.**

**FIG. 28** shows an example of an illumination device. In **FIG. 28****,** the illumination device is viewed from a light emission surface side. In this figure, the outer limit of the light emitting region **P** is indicated by a broken line.

The illumination device includes one or a plurality of organic EL elements. In the illumination device of the present specific embodiment, one organic EL element serves as one lighting panel **100,** and the illumination device is formed so that a plurality of lighting panels **100** are arranged in plane. When the illumination device includes a plurality of organic EL elements, the organic EL elements may be arranged in plane. In the specific embodiment of **FIG. 28****,** the organic EL elements with a quadrangular shape are arranged in plane so as to show a matrix with horizontal and vertical axes. It is preferable that the plurality of organic EL elements be fixed. For example, it is possible to provide a fixing member for fixing the organic EL elements on the opposite side from the light emitting surface. It is preferable that the plurality of organic EL elements be tightly arranged in plane. The illumination device may include electric wires. The illumination device may include plugs.

In the specific embodiment of **FIG. 28****,** the total of nine lighting panels **100** are arranged in plane in a 3×3 matrix manner. The number of lighting panels **100** (organic EL elements) may be 4 (2×2), 16 (4×4), 25 (5x5), or the like. Further, the number of lighting panels **100** in the vertical axis may be different from the number of lighting panels **100** in the horizontal axis. Alternatively, the lighting panels **100** may be arranged in line along one direction.

In the illumination device, the above organic EL elements are arranged in plane, and therefore the non-light emitting region can be decreased, and the non-light emitting region at a boundary portion between adjacent organic EL elements can be made less noticeable. Therefore, it is possible to prevent an unwanted situation that the non-light emitting part has a frame or grid shape and becomes noticeable. Hence it is possible to realize light emission with superior light emission properties.

When the plurality of organic EL elements (the lighting panels **100)** are arranged in plane, a distance between electrodes of adjacent organic EL elements becomes shorter. Particularly, in the above organic EL element, parts for supplying electricity to electrodes are disposed closer to the end part by use of the electrode pieces 3, and thus a distance between the electrodes of different elements is decreased. When electrodes with different polarities are in contact with each other, a short-circuit is likely to occur. Further, even when electrodes with the same polarity are in contact with each other, a flow of current is likely to be non-uniform in a plane of the illumination device, and there may be a possibility that fine light emission cannot be obtained. Further, even when the electrodes are spaced physically, electrically insulating properties are required for safety. Hence, it is necessary to ensure an insulating distance between adjacent elements.

In view of safety, it is preferable that the insulating distance between the electrode pieces **3** of adjacent elements be longer. Further, it is preferable that the insulating distance between cured parts of the electrically conductive pastes **20** of adjacent elements be longer. Generally, when there is no insulator with insulation reliability between two conductors, the insulating distance between the two conductors can be determined as a physical straight distance between the two conductors. When there is an insulator with insulation reliability between two conductors, the insulating distance between the two conductors can be determined as the shortest distance selected so that a route between the two conductors avoids the insulator. The insulator with insulation reliability may be an insulation sheet which satisfies insulation standard. In view of safety and reliability, it is preferable to ensure the insulating distance selected in the above manner.

With regard to ensuring the insulating property, the specific embodiments of **FIG. 12** to **FIG. 14** in which the electrically insulating wall **25** is provided are preferable. However, to ensure the insulating distance, there may be a more preferable embodiment or an embodiment applicable to each of the above embodiments. Hereinafter, with regard to ensuring the insulating distance, the more preferable embodiment or the embodiment applicable to each of the above specific embodiments are described.

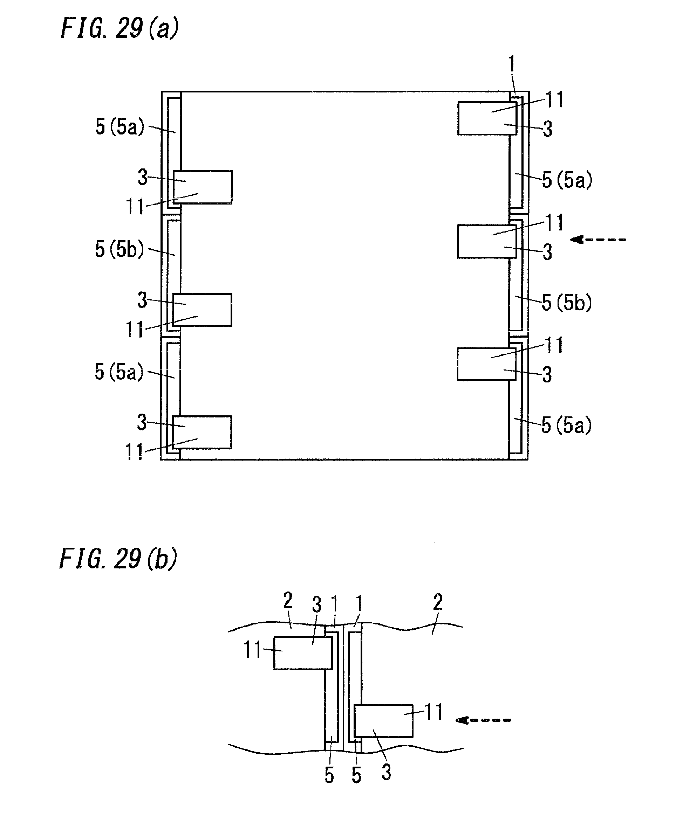

**FIG. 29(a)** shows an example of the embodiment of the organic EL element, and **FIG. 29(b)** shows part of the illumination device formed by use of the organic EL elements of **FIG. 29(a)****.** The same configurations as the above embodiment are designated by the same reference signs as the above embodiment and their explanations are omitted.

In the present specific embodiment, a plurality of electrode pieces **3** are provided to opposite end parts of the substrate 1. The plurality of electrode pieces **3** are arranged in different positions in a horizontal direction in a plan view. **FIG. 29(a)** shows an embodiment in which a plurality of electrode pieces **3** are disposed at left and right end parts. The electrode piece **3** disposed on the right side and the electrode piece **3** disposed on the left side are at different positions in the horizontal direction. In a case where the electrode terminals are arranged in the vertical directions, arrangement of different positions may be considered as arrangement of different positions in the lateral direction. In other words, when the organic EL element is viewed from a side where the electrode terminals are formed (i.e., a lateral side) as shown in a dotted line arrow of this figure, the arrangement of different positions may be considered as arrangement in which the electrode pieces **3** on the opposite end parts of the substrate are positioned at regions which do not overlap each other. In short, the opposite electrode pieces **3** are disposed not to face each other.

As shown in **FIG. 29(b)****,** when the organic EL elements of the present specific embodiment are arranged in plane, adjacent two electrode pieces **3** of adjacent organic EL elements are disposed in different positions in the horizontal direction. In other words, as indicated by an arrow of **FIG. 29(b)****,** when the element is viewed from its side, adjacent electrode pieces **3** are disposed not to overlap with each other. Therefore, it is possible to prevent contact between the electrode pieces **3,** and thus the insulating property can be improved. Further, it is possible to increase the distance between the adjacent interconnection electrodes **11.** When the electrode piece **3** is bonded with the electrically conductive paste **20,** it is possible to increase the distance between parts made of the electrically conductive pastes **20** (the electrically conductive fixer **21** and the electrically conductive bond **22).** Therefore, the insulating properties can be easily improved.

It is preferable that the electrode piece **3** be arranged symmetrical about a center of the light emitting region. In this case, in-plane distribution of current density is made uniform, and thus light emission can be made more uniform in plane, and unevenness of luminance can be reduced. In **FIG. 29(a)****,** the electrode pieces **3** are arranged in a point symmetrical manner. When the element is turned **180°,** the electrode pieces **3** are at the same positions.

To increase the insulating distance between adjacent the electrode pieces **3** of the illumination device, various types of organic EL elements with electrode pieces **3** at different positions in the horizontal direction are formed and are arranged in contact with each other. For example, the organic EL element in which the electrode pieces **3** are arranged on left and right sides according to the positions of the electrode pieces at the right side end of **FIG. 29(a)****,** and the organic EL element in which the electrode pieces **3** are arranged on left and right sides according to the positions of the electrode pieces at the left side end of **FIG. 29(a)** are prepared, and are arranged adjacent to each other. In this regard, the two organic EL elements may have the same configuration as the specific embodiment of **FIG. 29(a)** except the positions of the electrode pieces **3.** The two organic EL elements are arranged alternately in the lateral direction. In this case, when the end parts of the organic EL elements are made in contact with each other, as shown in **FIG. 29(b)****,** the adjacent electrode pieces **3** are disposed at different positions in the horizontal direction. Therefore, as with the case of using the organic EL element of **FIG. 29(a)****,** the insulating distance can be increased. However, it is troublesome to prepare a plurality of the organic EL elements different in the positions of the electrode pieces **3** and arrange the plurality of the organic EL elements in plane. Consequently, as shown in **FIG. 29(a)****,** the organic EL element with the electrode pieces **3** disposed at different positions is of advantage.

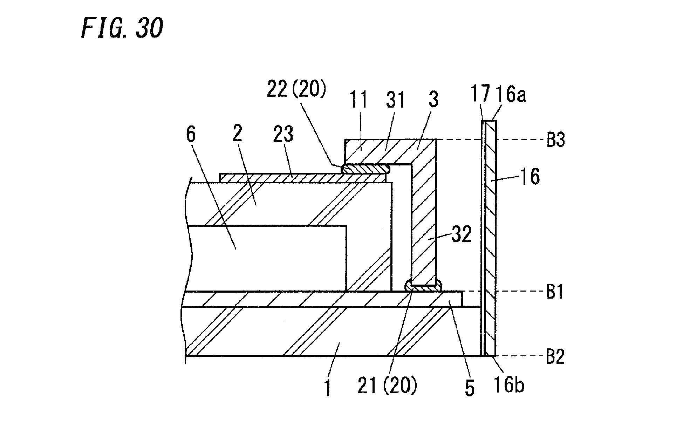

**FIG. 30** shows an example of the embodiment of the organic EL element. This embodiment illustrates a preferable aspect for increasing the insulating distance. The same configurations as the above embodiment are designated by the same reference signs as the above embodiment and their explanations are omitted.

In the present specific embodiment, an electrically insulating barrier member **16** is provided to the side part of the substrate **1.** The electrically insulating barrier member **16** protrudes in a direction normal to the surface of the substrate **1** relative to the extended electrode part **5.** When the electrically insulating barrier member **16** is provided, it is possible to easily ensure the insulating property. Therefore, the insulating property can be improved.

As a method of ensuring the insulating distance, a method of using the electrically insulating wall **25** is described with reference to **FIG. 12****.** However, when the good electrically insulating wall **25** is not formed or the electrically insulating wall **25** with an insufficient thickness is formed, the sufficient insulating property may not be ensured. Especially, when the electrically insulating wall **25** is made of resin or the like, the insulating property may vary depending on a condition of formation of resin, and therefore in some cases desired voltage resistance cannot be ensured. In a case of resin, the performance may depend on condition of application, condition of curing, or the like. However, by using the electrically insulating barrier member **16,** a barrier property of the electrically insulating barrier member **16** allows easy ensuring of the insulating property, and the high insulating property can be obtained. In a case of using the electrically insulating barrier member **16,** it is possible to check the insulating property before the electrically insulating barrier member **16** is bonded to the substrate **1.** The electrically insulating barrier member **16** with excellent insulating property can be used for production of the element.

The electrically insulating barrier member **16** is provided to the side face of the substrate **1.** By doing so, the insulating property at the side face of the substrate **1** can be ensured. The electrically insulating barrier member **16** is bonded to the substrate **1** with a bonding layer **17.**

The electrically insulating barrier member **16** may be an electrically insulating sheet, an electrically insulating film, or an electrically insulating plate. For example, by attaching an electrically insulating sheet with the bonding layer **17** to the side face of the substrate **1,** the electrically insulating barrier member **16** can be easily bonded to the substrate **1.** Further, when the organic EL element includes the electrically insulating barrier member **16,** the organic EL element can be disposed at a dusty and gritty place, or arrangement requiring high voltage resistance such as arrangement of a plurality of organic EL elements can be allowed.

The electrically insulating barrier member **16** may have a thickness of 0.1 mm or more, for example. In this case, the insulating property can be more improved. In this case, the thickness of the electrically insulating barrier member **16** means the length of the electrically insulating barrier member **16** in a direction (lateral direction) parallel to the surface of the substrate **1,** and also means the length of the electrically insulating barrier member **16** in a direction perpendicular to a stacking direction of the organic light emitter **10.** However, to decrease the non-light emitting part, it is preferable that the electrically insulating barrier member **16** be thinner. For example, thickness of the electrically insulating barrier member **16** may be **5** mm or less, preferably **3** mm or less, and more preferably **1** mm or less.

It is preferable that the electrically insulating barrier member **16** be provided to the entire side part of the substrate **1.** In this case, the insulating property can be improved and the electrically insulating barrier member **16** can be easily provided. It is preferable that the electrically insulating barrier member **16** be disposed on the side of the electrode piece **3.**

In **FIG. 30****,** as positions in the direction perpendicular to the surface of the substrate **1,** a position **B1** of the surface of the extended electrode part **5,** a position **B2** of the surface on the light emerging side of the substrate **1,** and a position **B3** of the opposite end part of the electrode piece **3** from the substrate **1** are denoted by broken lines. The electrically insulating barrier member **16** protrudes towards the opposite side from the light emerging side (in this figure, upward) relative to the position **B1** of the surface of the extended electrode part **5.** In this case, the electrically insulating barrier member **16** is disposed on the side of the extended electrode part **5,** and therefore the insulating distance can be more easily ensured. To increase the insulating distance, it is preferable that the electrically insulating barrier member **16** protrude outward relative to the electrically conductive fixer **21.** In this case, the barrier member **16** can be disposed on the side of the electrically conductive fixer **21.**

It is preferable that the electrically insulating barrier member **16** do not protrude outward in a direction perpendicular to the surface of the substrate **1** with regard to the opposite surface of the substrate **1** from the surface to which the enclosing member **2** is bonded. In **FIG. 30****,** the end part (the end part **16b** on the light emerging side) of the electrically insulating barrier member **16** is positioned at a position same as the position **B2** which is a position of the surface of the substrate **1** facing the outside, and therefore does not protrude outward relative to the substrate **1.** As described above, the electrically insulating barrier member **16** does not protrude outward relative to the substrate **1,** and therefore when the illumination device is formed, the electrically insulating barrier member **16** is prevented from protruding on the light emitting surface. Therefore, it is possible to suppress the element from having poor appearance due to the electrically insulating barrier member **16,** and to suppress the non-light emitting part from being noticeable due to the electrically insulating barrier member **16.** The end part **16b** of the electrically insulating barrier member **16** may be positioned inward relative to the position **B2.** However, when the end part **16b** of the electrically insulating barrier member **16** is excessively recessed, the appearance is likely to become poor. Therefore, even when the electrically insulating barrier member **16** is recessed, it is preferable that the end part **16b** of the electrically insulating barrier member **16** be disposed in a vicinity of the position **B2.**

It is preferable that the electrically insulating barrier member **16** protrude outward in a direction perpendicular to the surface of the substrate **1** relative to the electrode piece **3.** In **FIG. 30****,** the end part (the opposite end part **16a** from the light emerging side) of the electrically insulating barrier member **16** is disposed closer to the opposite side from the light emerging side than the position **B3,** which means the position of the opposite end part of the electrode piece **3** from the light emerging side, is, and therefore the end part (the opposite end part **16a** from the light emerging side) of the electrically insulating barrier member **16** protrudes relative to the electrode piece **3.** As described above, the electrically insulating barrier member **16** protrudes relative to the electrode piece **3,** and therefore when the illumination device is formed, contact between the electrode pieces **3** of the adjacent organic EL elements is made difficult. Thus, the insulating property can be more improved. Further, the insulating distance between the electrically conductive fixers **21** of the adjacent the organic EL elements can be calculated as a distance of the route avoiding the electrically insulating barrier member **16,** and therefore the length of the electrically insulating barrier member **16** in the perpendicular direction can be increased and thus the insulating distance can be more increased.

The opposite end part **16a** of the electrically insulating barrier member **16** from the light emerging side may be disposed, for example, at a position positioned at a distance, which is two times or more longer than the length of the organic EL element of the electrode piece **3,** from the surface of the substrate **1.** As the electrically insulating barrier member **16** protrudes, the insulating property increases. For example, when it is assumed that the electrically insulating barrier member **16** is bent along the electrode piece **3,** the end part **16a** of the electrically insulating barrier member **16** may be positioned closer to the inside of the element than the end part of the supported piece **31** is. Further, for example, when it is assumed that the electrically insulating barrier member **16** is bent inward at the position of the surface of the enclosing member **2,** the end part **16a** of the electrically insulating barrier member **16** may be positioned closer to the inside of the element than the inside part of the interconnection electrode extension part **23** is. In a case where the electrically insulating barrier member **16** has sufficient length, even when configurations of the electrically conductive paste **20** and the interconnection electrode **11** are changed, the insulating distance can be ensured by the electrically insulating barrier member **16,** and therefore there may be no need to change the insulating design. Consequently, the insulating design can be facilitated.

The opposite end part **16a** of the electrically insulating barrier member **16** from the light emerging side may be disposed at the position equal to the position **B3** of the opposite end part of the electrode piece **3** from the light emerging side. In this case, the electrically insulating barrier member **16** is disposed on the side of the electrode piece **3** so as to cover the side part of the electrode piece **3,** and therefore the insulating property can be increased. Further, the end part **16a** of the electrically insulating barrier member **16** may be disposed closer to the substrate **1** than the position **B3 is.** Also in this case, the electrically insulating barrier member **16** is disposed on the side of the electrode piece **3,** and therefore the insulating property can be increased. Further, when the electrically insulating barrier member **16** does not protrude relative to the electrode piece **3,** it is possible to prevent the electrically insulating barrier member **16** from being caught and detached, for example. Further, the element can be thinned. To more improve the insulating property, it is preferable that the end part **16a** of the electrically insulating barrier member **16** protrudes outward relative to the position **B3.** To prevent detachment of the electrically insulating barrier member **16,** it is preferable that the end part **16a** of the electrically insulating barrier member **16** is positioned inward relative to the position **B3.** Therefore, in view of the insulating property, safety, or the like, it is possible to select the position of the end part **16a** of the electrically insulating barrier member **16.**

For example, the length of the electrically insulating barrier member **16** in the direction perpendicular to the surface of the substrate **1** may be equal to the length of the fixed piece **3** in the extending direction. Alternatively, for example, the length of the electrically insulating barrier member **16** in the direction perpendicular to the surface of the substrate **1** may be equal to the sum of the length of the fixed piece **3** and the thickness of the substrate **1.** Alternatively, for example, the length of the electrically insulating barrier member **16** in the direction perpendicular to the surface of the substrate **1** may be longer than the sum of the length of the fixed piece **3** and the thickness of the substrate **1.**

The electrically insulating barrier member **16** may be bonded to the substrate **1** at appropriate timing. It is also possible to provide the electrically insulating barrier member **16** to substrate material for the substrate 1 before the organic light emitter **10** is formed. However, in a case where the electrically insulating barrier member **16** is provided before a stack is formed, there may be a possibility that it is difficult to form the good organic light emitter **10.** Therefore, it is preferable that the electrically insulating barrier member **16** be formed at appropriate timing after the organic light emitter **10** is formed and enclosed. In this regard, the electrically insulating barrier member **16** can be provided before attachment of the electrode piece **3,** or the electrically insulating barrier member **16** can be provided after attachment of the electrode piece **3.** For example, the electrically insulating barrier member **16** may be bonded to the substrate **1** before attachment of the electrode piece **3,** and then the electrically conductive paste **20** may be applied onto the surface of the extended electrode part **5,** and subsequently the electrode piece **3** may be attached. In this case, a flow of the electrically conductive paste **20** can be blocked by the electrically insulating barrier member **16,** and hence the insulating property can be improved. Alternatively, for example, the electrically conductive paste **20** may be applied onto the surface of the extended electrode part **5,** and then the electrode piece **3** may be attached, and subsequently the electrically insulating barrier member **16** may be bonded to the substrate **1.** In this case, even when the electrically conductive paste **20** unfortunately extends outward, the electrically insulating barrier member **16** can be attached so as to cover extended part of the electrically conductive paste **20,** and therefore the insulating property can be improved. It is more preferable that the bonding layer **17** be provided to a whole one surface of the electrically insulating barrier member **16.** In this case, workability of bonding of the electrically insulating barrier member **16** can be improved. Note that, it is sufficient that the bonding layer **17** is finally cured. Even when the bonding layer **17** is exposed on the outermost surface, it is sufficient that the adhesiveness of the bonding layer **17** is lost finally.

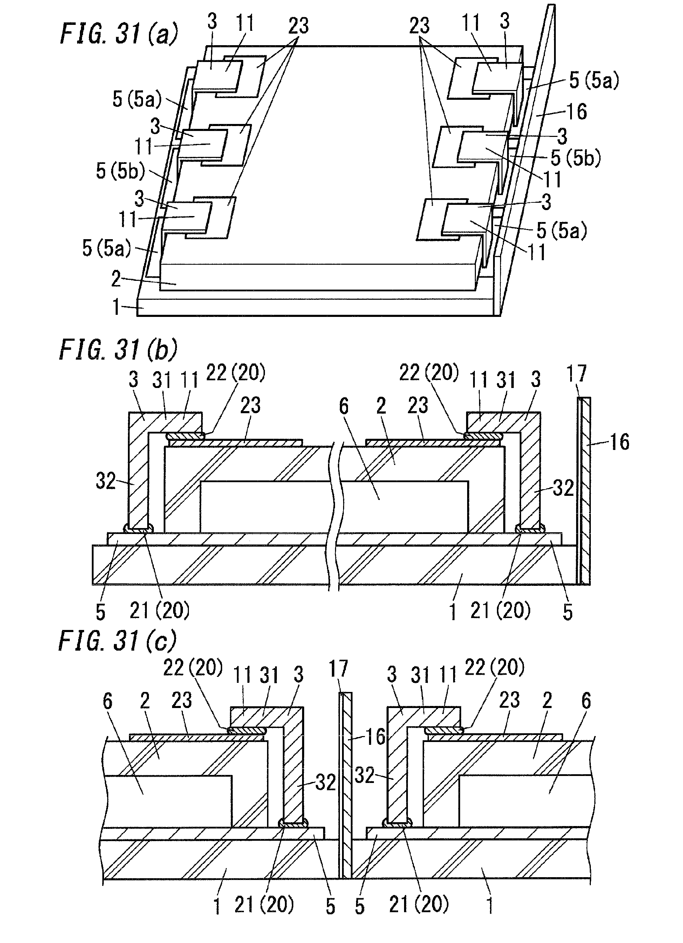

**FIG. 31** shows an example of the embodiment of the organic EL element and the illumination device. **FIG. 31(a)** and **FIG. 31(b)** show the organic EL element, and **FIG. 31(c)** shows a boundary portion between the organic EL elements of the illumination device including a plurality of organic EL elements. The same configurations as the above embodiment are designated by the same reference signs as the above embodiment and their explanations are omitted. Note that, in **FIG. 31(a)****,** the bonding layer **17** is omitted because the bonding layer **17** is thin practically.

In a case where a plurality of organic EL elements are arranged side by side, it is sufficient that the electrically insulating barrier member **16** is provided between the adjacent electrode pieces **3.** Therefore, the electrically insulating barrier member **16** may not be provided to one of the side parts of the substrate **1** to which the electrode piece **3** is provided. In **FIG. 31(a)****,** the electrically insulating barrier member **16** is provided to one end part of the opposite end parts each to which the electrode piece **3** is provided, and the electrically insulating barrier member **16** is not provided to the other end part. In this organic EL element, when the illumination device is formed, as shown in **FIG. 31(c)****,** the adjacent organic EL elements are disposed so that the end part to which the electrically insulating barrier member **16** is not provided is in contact with the end part to which the electrically insulating barrier member **16** is provided. Therefore, it is possible to provide the electrically insulating barrier member **16** between the electrode terminals, and consequently the insulating property can be improved.

It is preferable that the electrically insulating barrier member **16** is provided to extend the entire length of the end part of the substrate **1** to which the electrode piece **3** is attached. In this case, it is possible to easily form the insulating structure by use of the electrically insulating barrier member **16.** The electrically insulating barrier member **16** is formed into an elongate shape so as to extend the entire peripheral edge of the substrate **1.** The electrically insulating barrier members **16** may be provided corresponding to the individual electrode pieces **3.** However, it is preferable that such electrically insulating barrier members **16** are formed as a single part. Thus, the formation of the insulating structure can be facilitated.

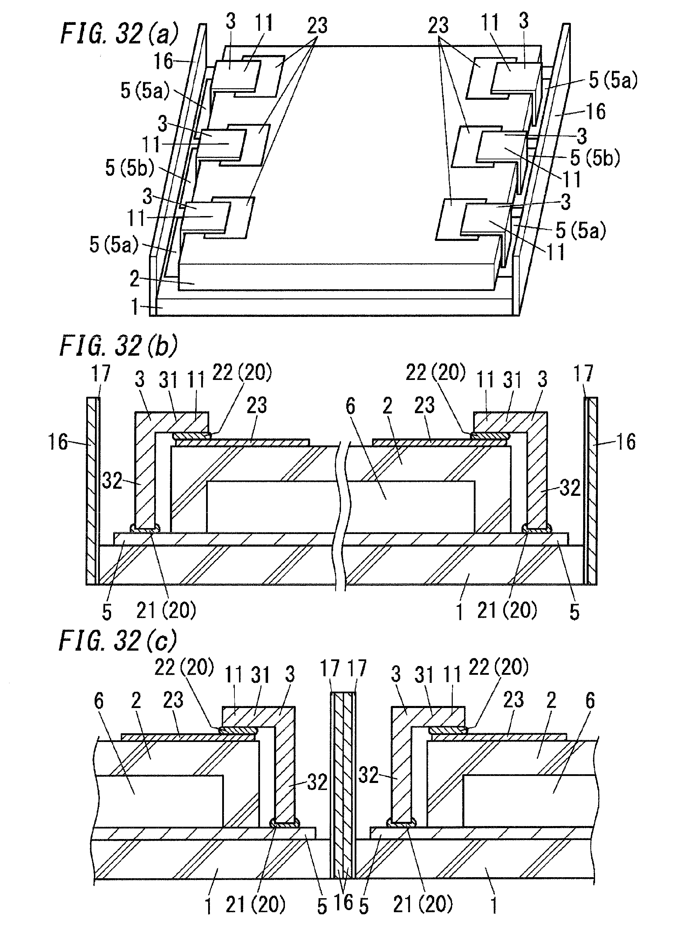

**FIG. 32** shows an example of the embodiment of the organic EL element and the illumination device. **FIG. 32(a)** and **FIG. 32(b)** show the organic EL element, and **FIG. 32(c)** shows a boundary portion between the organic EL elements of the illumination device including a plurality of organic EL elements. The same configurations as the above embodiment are designated by the same reference signs as the above embodiment and their explanations are omitted. Note that, in **FIG. 32(a)****,** the bonding layer **17** is omitted because the bonding layer **17** is thin practically.

In the present specific embodiment, the electrically insulating barrier member **16** is provided to each end part of the organic EL element to which the electrode piece **3** is provided. In summary, as shown in **FIG. 32(a)****,** the electrically insulating barrier members **16** are provided to both the opposite end parts each to which the electrode piece **3** is provided. Therefore, the electrically insulating barrier members **16** are disposed to the sides of all the end parts each to which the electrode piece **3** is formed, and therefore, when the organic EL elements are arranged adjacent to each other, it is possible to successfully dispose the electrically insulating barrier member **16** between the adjacent electrode pieces **3.** Therefore, it is possible to successfully provide the electrically insulating barrier member **16** between the electrode terminals, and therefore the insulating property can be improved. Further, as shown in **FIG. 32(c)****,** the two electrically insulating barrier members **16** are disposed between the adjacent organic EL elements. Consequently, the insulating property can be more improved. Further, each electrically insulating barrier member **16** can be thinned.

In this embodiment, the electrically insulating barrier member **16** has an elongated shape, and the electrode piece **3** extends the entire length of the end part of the substrate **1** to which the electrode piece **3** is attached. Therefore, it is possible to easily improve the insulating property.

In this regard, the specific embodiment of **FIG. 31** gives an advantage that an amount of material of the electrically insulating barrier member **16** can be reduced. In contrast, the specific embodiment of **FIG. 32** gives an advantage that the electrically insulating barrier member **16** can be easily provided between the adjacent organic EL elements and tiling with the organic EL elements can be facilitated. Therefore, which one is used can be determined appropriately in consideration of productivity, cost, and the like.

The following can be understood from the specific embodiments of **FIG. 31** and **FIG. 32****.** It is preferable that a plurality of electrode pieces **3** be provided to a plurality of end parts of the substrate 1. When the electrode pieces **3** are provided to the end parts of the substrate **1,** a plurality of electrode terminals including the interconnection electrodes **11** are formed on the plurality of end parts. Consequently, it is possible to obtain light emission with more uniformity in plane. Further, it is preferable that the electrically insulating barrier member **16** is provided to the side part of the substrate **1** at a position of the end part with regard to half or more of the plurality of end parts of the substrate **1.** In this case, when the organic EL elements are arranged in plane, it is possible to easily dispose the electrically insulating barrier member **16** between the adjacent electrode terminals. For example, in the specific embodiment of **FIG. 31****,** the electrode piece **3** is formed on each of the two end parts of the substrate **1,** and hence it is preferable that the electrically insulating barrier member **16** be provided with regard to one or two end parts which are half or more of the end parts on which the electrode piece **3** is formed. If the electrode piece **3** is formed on one end part of the substrate **1,** it is preferable that the electrically insulating barrier member **16** be provided to this end part. Alternatively, if the electrode piece **3** is formed on each of the three or four end parts of the substrate **1,** it is preferable that the electrically insulating barrier member **16** be provided with regard to two or more end parts. Note that, the shape of the organic EL element is not limited to a quadrangular shape and may be a hexagonal shape, for example. When the organic EL element has a hexagonal shape, the organic EL elements can be closely arranged in plane by being arranged in a honeycomb manner. Even when the organic EL element has a hexagonal shape, the relation of the number of end parts to which the electrically insulating barrier member **16** is provided is similar to the above case.

With regard to the electrically insulating barrier member **16,** it is more preferable that the electrically insulating barrier member **16** be provided to the side part of the substrate **1** corresponding to a position of the end part with regard to all of the plurality of end parts of the substrate **1,** as described with reference to the specific embodiment of **FIG. 32****.** In this case, it is possible to prevent the end part to which the electrically insulating barrier member **16** is not provided from being in contact with the other end part. Therefore, the insulating property can be successfully improved.

In the above embodiment, the organic EL element has a quadrangular shape in a plan view. Therefore, the electrically insulating barrier member **16** can be provided to at least one side of the organic EL element with a quadrangular shape. In a preferable embodiment, electrically insulating barrier members **16** are provided to opposite two sides of the organic EL element with a quadrangular shape. In this regard, a quadrangular shape may be a rectangular shape or a square shape.

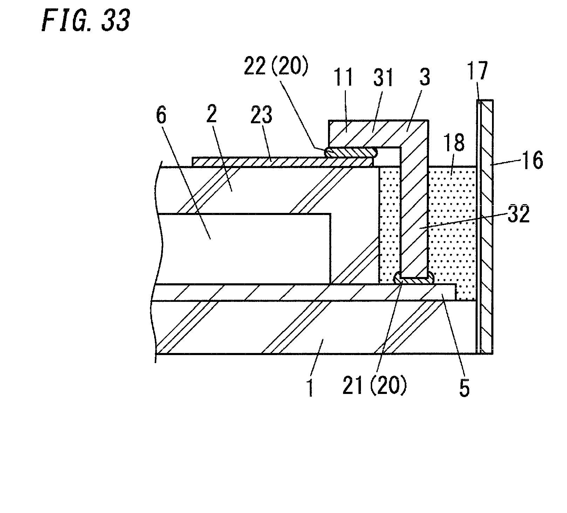

**FIG. 33** shows an example of the embodiment of the organic EL element. The same configurations as the above embodiment are designated by the same reference signs as the above embodiment and their explanations are omitted.

The organic EL element of the present specific embodiment includes the electrically insulating barrier member **16.** The configuration of the electrically insulating barrier member **16** may be the same as the above. Further, a space between the electrically insulating barrier member **16** and the enclosing member **2** is filled with resin. In **FIG. 33****,** the space filled with the resin is illustrated as a resin part **18.** The resin part **18** may be formed by curing the resin. Curing of the resin may be thermal curing or photocuring.

In the present specific embodiment, the space between the electrically insulating barrier member **16** and the enclosing member **2** is filled with the resin, and therefore the electrically conductive fixer **21** can be covered with the resin part **18.** Consequently, the electrically conductive fixer **21** can be protected from external force and moisture, and thus the electric reliability can be improved. Further, the space between the electrically insulating barrier member **16** and the enclosing member **2** is closed, and therefore intrusion of inpurities such as dust and grit into this space can be suppressed, and thus the electric reliability can be more improved. Further, the electrically insulating barrier member **16** is bonded with the resin, and therefore the electrically insulating barrier member **16** can be strongly held. Further, the space between the electrically insulating barrier member **16** and the enclosing member **2** can be filled with the resin, and therefore the part filled with the resin can be narrowed, and thus the non-light emitting region can be reduced as possible.

It is preferable that the space be filled with the resin so that the electrically conductive fixer **21** is covered with the resin. In this case, the electrically conductive fixer **21** is covered with the resin, and therefore the reliability can be improved. It is preferable that the resin be injected so as to cover a half or more of the fixed piece **32** of the electrode piece **3,** and therefore the reliability can be more improved. It is preferable that the resin be injected so as to fill the space up to near the surface of the enclosing member **2.** Consequently, the reliability can be improved and the electrically insulating barrier member **16** can be more firmly held.

The space between the electrically insulating barrier member **16** and the enclosing member **2** may be filled with the resin so that the resin extends the entire length of the space in the horizontal direction. By doing so, it is possible to improve the electric reliability of the organic EL element and adhesiveness between the electrically insulating barrier member **16** and the enclosing member **2.**

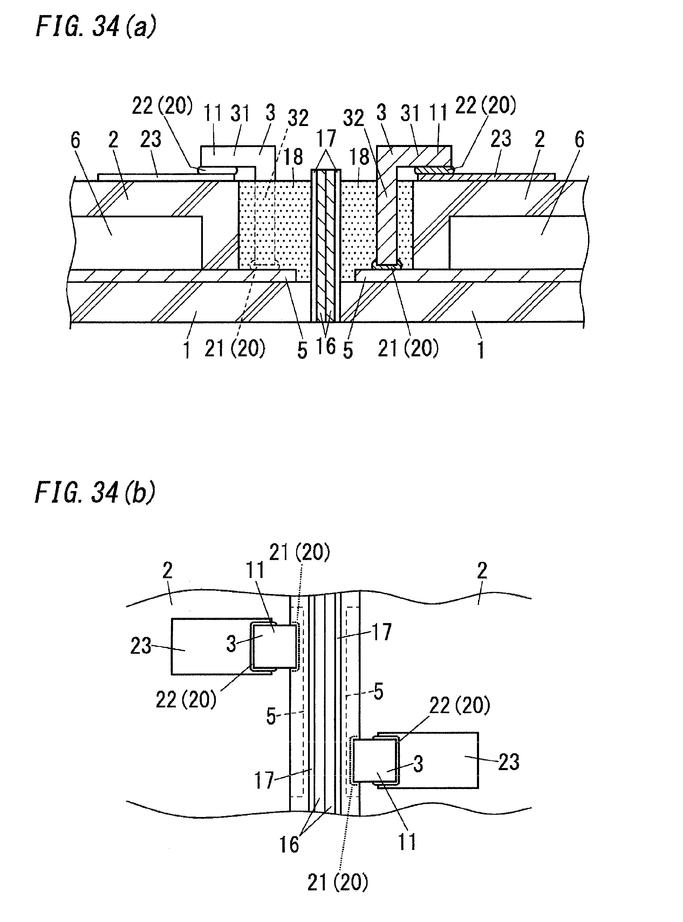

**FIG. 34** shows an example of the embodiment of the organic EL element and the illumination device. The same configurations as the above embodiment are designated by the same reference signs as the above embodiment and their explanations are omitted. **FIG. 34(a)** and **FIG. 34(b)** show a boundary portion between the organic EL elements of the illumination device, and **FIG. 34(a)** shows a section of the electrode piece **3** and its vicinity, and **FIG. 34(b)** shows a plan of the electrode piece **3** and its vicinity.

The organic EL element of the present specific embodiment includes the electrically insulating barrier member **16** in a similar manner to the specific embodiment of **FIG. 33****,** and the space between the electrically insulating barrier member **16** and the enclosing member **2** is filled with the resin. In the present specific embodiment, the electrically insulating barrier members **16** are provided to the opposite side parts of the substrate **1.** Further, in the organic EL element of the present specific embodiment, as with the embodiment described with reference to **FIG. 29****,** the positions of the electrode pieces **3** are different in the horizontal direction. Therefore, the insulating distance can be kept long, and the insulating property can be improved, and hence it is possible to obtain the element with high reliability and safety.

In the specific embodiment of **FIG. 34****,** the electrically insulating barrier member **16** is provided so that the end part **16a** does not protrude outward relative to the electrode piece **3.** The end part **16a** of this electrically insulating barrier member **16** is disposed at a position close to the surface of the enclosing member **2** facing the outside. The electrically insulating barrier member **16** does not protrude, and therefore it is possible to suppress an undesired event in which external force acts on the electrically insulating barrier member **16** and thereby the electrically insulating barrier member **16** is detached, for example. Further, when the electrically insulating barrier member **16** does not protrude, the thickness of the entire element can be decreased, and therefore the element can be thinned.

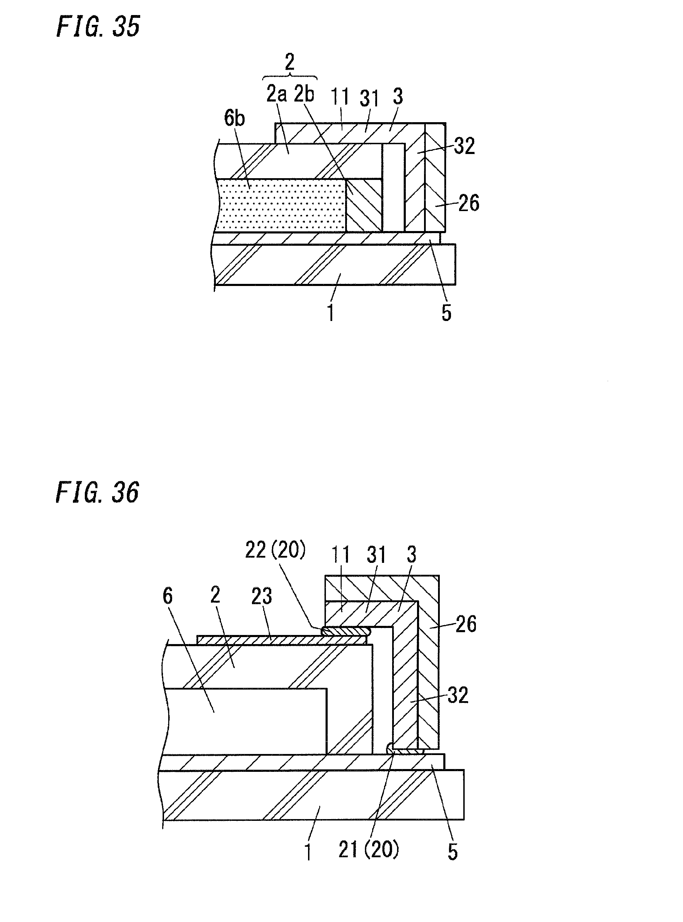

**FIG. 35** shows an example of the embodiment of the organic EL element. The same configurations as the above embodiment are designated by the same reference signs as the above embodiment and their explanations are omitted. The specific embodiment of **FIG. 35** includes an electrically insulating cover **26.** The configuration including the electrically insulating cover **26** can be used together with a configuration other than the configuration including the electrically insulating barrier member **16,** or the configuration including the electrically insulating barrier member **16.** Further, the configuration including the electrically insulating cover **26** can be used together with the configuration in which the electrode pieces **3** are arranged so as not to overlap.

In the present specific embodiment, with regard to the electrode piece **3,** at least the surface, facing the outside, of the extension part extending toward the substrate **1** is covered with the electrically insulating cover **26.** The extension part of the electrode piece **3** is covered with the electrically insulating cover **26** with the insulating property, and therefore, in a case of forming the illumination device, contact between the adjacent electrode pieces **3** can be suppressed. Further, the electrode piece **3** is covered, and thus the insulating distance can be kept longer. Accordingly, the insulating property can be more improved.

In the present specific embodiment, the extension part of the electrode piece **3** is constituted by the fixed piece **32,** and the surface of the fixed piece **32** facing the outside is covered with the electrically insulating cover **26.** In other words, the lateral surface of the electrode piece **3** is covered.

The electrically insulating cover **26** may be made of appropriate electrically insulating material such as resin, an electrically insulating sheet, an electrically insulating film, and rubber. It is preferable that the electrically insulating cover **26** be provided to the electrode piece **3** before the substrate **1** is fixed. In this case, the organic EL element can be formed by use of the electrode piece **3** attached with the electrically insulating cover **26.** By doing so, the insulating property can be easily improved. Further, in a case of using the electrically conductive paste **20,** it is possible to easily suppress the electrically conductive paste **20** from flowing out. Besides, the electrically insulating cover **26** may be provided after the electrode piece **3** is fixed to the substrate **1.**

The electrically insulating cover **26** can be formed by applying electrically insulating fluid material onto the surface of the electrode piece **3,** for example. Alternatively, the electrically insulating cover **26** can be formed by bonding electrically insulating solid material (e.g., an electrically insulating sheet) to the surface of the electrode piece **3.**

The electrically insulating cover **26** may have a thickness of 0.1 mm or more, for example. In this case, the insulating property can be improved. The above thickness means the length in a direction (lateral direction) parallel to the surface of the substrate **1** and also means the length in a direction perpendicular to the stacking direction of the organic light emitter **10.** The upper limit of the thickness of the electrically insulating cover **26** is not limited particularly, and it is preferable that the thickness of the electrically insulating cover **26** is selected so that the electrically insulating cover **26** does not protrude outward in the horizontal direction relative to the position of the end part of the substrate **1** when the organic EL element is constituted. The thickness of the electrically insulating cover **26** may be **3** mm or less, and preferably **1** mm or less, for example.

Note that, the organic EL element of the present specific embodiment is formed to have a filling and enclosing structure described with reference to **FIG. 13****.** Alternatively, the organic EL element may have a hollow structure.

**FIG. 36** shows an example of the embodiment of the organic EL element. The same configurations as the above embodiment are designated by the same reference signs as the above embodiment and their explanations are omitted. The specific embodiment of **FIG. 36** includes the electrically insulating cover **26.** The material, the production method, and the like of the electrically insulating cover **26** may be the same as those of the specific embodiment of **FIG. 35****.**

In the present specific embodiment, the entire surface, facing the outside, of the electrode piece **3** is covered with the electrically insulating cover **26.** The whole of the electrode piece **3** is covered with the electrically insulating cover **26** having the insulating property. Consequently, when the illumination device is formed, it is possible to suppress contact between the adjacent electrode piece **3.** Further, the entire surface, facing the outside, of the electrode piece **3** is covered, and therefore the insulating distance can be kept longer. Consequently, the insulating property can be more improved. Further, the electrically insulating cover **26** covers the entire electrode piece **3,** and therefore adhesiveness between the electrically insulating cover **26** and the electrode piece **3** can be improved and the electrically insulating cover **26** can be easily formed.

Note that, the organic EL element of the present specific embodiment illustrates an example obtained by applying the electrically insulating cover **26** to the specific embodiment of **FIG. 9****.** However, the electrically insulating cover **26** may be applied to another embodiment.

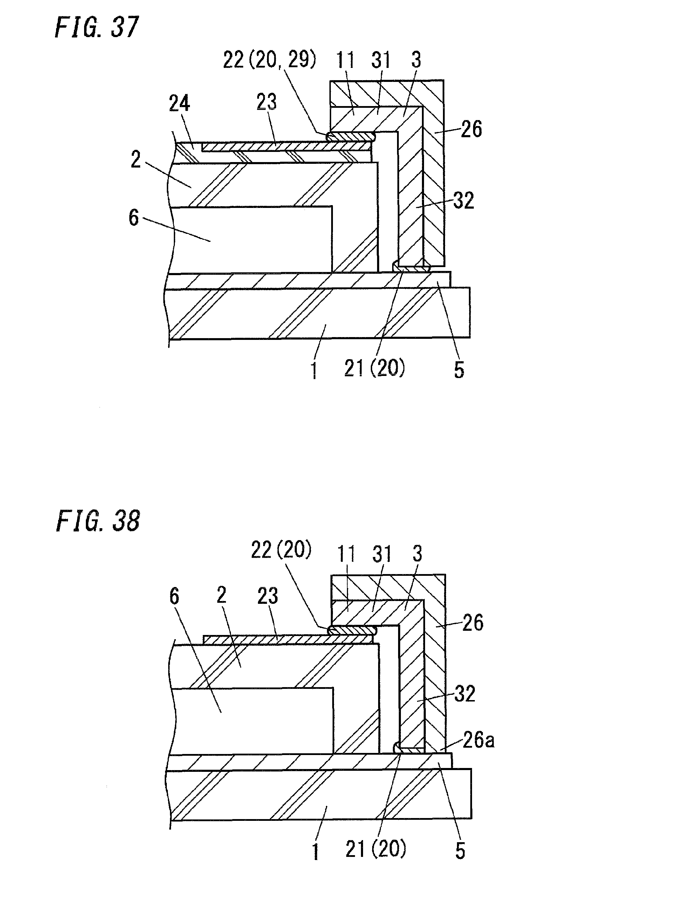

**FIG. 37** shows an example in which the electrically insulating cover **26** is applied to the specific embodiment of **FIG. 10****.** In the present specific embodiment, the organic EL element includes the wiring board **24.** Also in this case, the insulating distance can be easily ensured.

**FIG. 38** shows an example of the embodiment of the organic EL element. The same configurations as the above embodiment are designated by the same reference signs as the above embodiment and their explanations are omitted.

In the present specific embodiment, the electrically insulating cover **26** protrudes toward the substrate **1** relative to the front end of the extension part of the electrode piece **3.** In other words, the front end, close to the substrate **1,** of the electrically insulating cover **26** protrudes relative to the front end, close to the substrate **1,** of the fixed piece **32** of the electrode piece **3.** The electrically insulating cover **26** protrudes toward the substrate **1** relative to the front end of the extension part of the electrode piece **3,** and thereby can cover the side part of the electrically conductive fixer **21** made of the electrically conductive paste **20.** Therefore, the insulating distance can be easily ensured. Further, the electrically conductive paste **20** can be prevented from flowing out, and thus the insulating property can be more improved.

In **FIG. 38****,** part of the electrically insulating cover **26** which protrudes outward relative to the electrode piece **3** is illustrated as an electrically insulating protrusion **26a.**

In the present specific embodiment, it is preferable that the electrically insulating cover **26** be flexible. In a case where the electrically insulating cover **26** is flexible, the electrically insulating cover **26** can be made to deform when the electrode piece **3** is moved closer to the substrate **1,** and therefore the front end of the fixed piece **32** can be moved much closer to the extended electrode part **5.** Alternatively, the electrically insulating cover **26** may not be flexible.

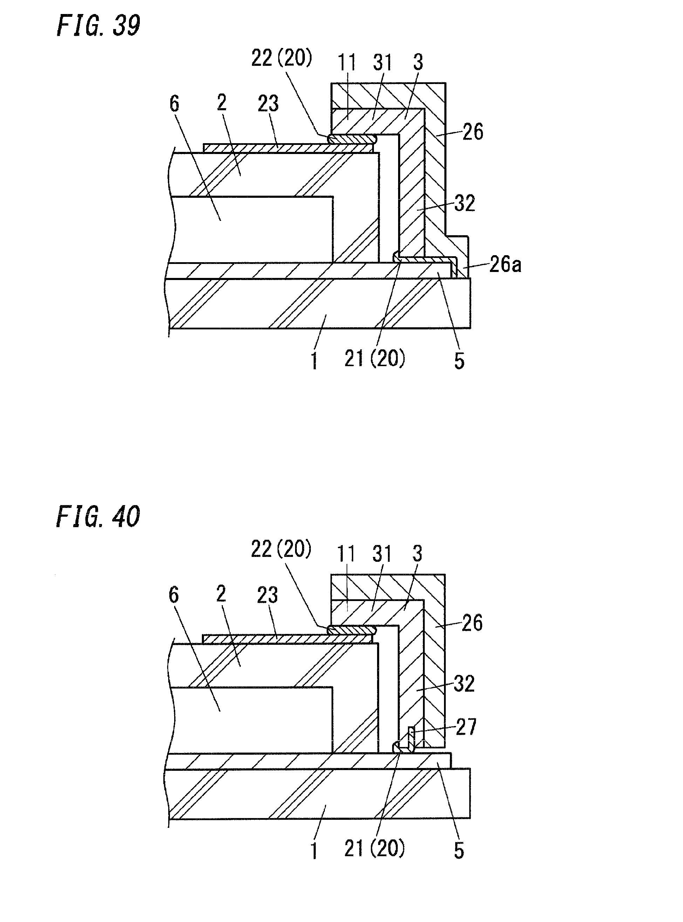

**FIG. 39** shows an example of the embodiment of the organic EL element. The same configurations as the above embodiment are designated by the same reference signs as the above embodiment and their explanations are omitted.

In the present specific embodiment, the electrically insulating protrusion **26a** of the electrically insulating cover **26** which protrudes relative to the front end of the extension part of the electrode piece **3** extends outward. When the electrically insulating protrusion **26a** extends outward, the electrically conductive paste **20** can be prevented from flowing out and therefore the insulating property can be more improved. Further, it is possible to more increase the size of the electrically conductive fixer **21** and therefore more increase the electric connectability. The electrically insulating cover **26** may extend outward by being pressed by the electrically conductive paste **20** when the electrically insulating cover **26** is in contact with the electrically conductive paste **20.** The electrically insulating cover **26** may have a bending structure.

In the specific embodiment of **FIG. 39****,** the end part, close to the substrate **1,** of the electrically insulating cover **26,** that is the electrically insulating protrusion **26a,** is in contact with the substrate **1.** When this end part is in contact with the substrate **1,** the electrically conductive paste **20** can be more prevented from flowing out.

**FIG. 40****,** **FIG. 41** and **FIG. 42** show other embodiments of the organic EL element including the electrically insulating cover **26.** In a preferable embodiment, the organic EL element includes a space **27** which is provided to the extension part of the electrode piece **3,** the electrically insulating cover **26,** or between the electrode piece 3 and the electrically insulating cover **26,** and has an opening directed to the substrate **1.** In this case, it is possible to, by use of capillarity, easily prevent the electrically conductive paste **20** from flowing into the outside. The electrically conductive fixer **21** made of the electrically conductive paste **20** may intrude into the space **27.**

The specific embodiment of **FIG. 40** includes the space **27** which is provided to the extension part of the electrode piece **3** so as to have the opening directed to the substrate **1.** In other words, the space **27** is formed in the surface, facing the substrate **1,** of the front end of the fixed piece **32** of the electrode piece **3.** This space **27** is formed by partially dividing the front end of the fixed piece **32** in the lateral direction. The electrode piece **3** includes the space **27** and consequently it is possible to, by use of capillarity, make the electrically conductive paste **20** intrude into the space **27.** Therefore, the electrically conductive paste **20** can be prevented from flowing out.

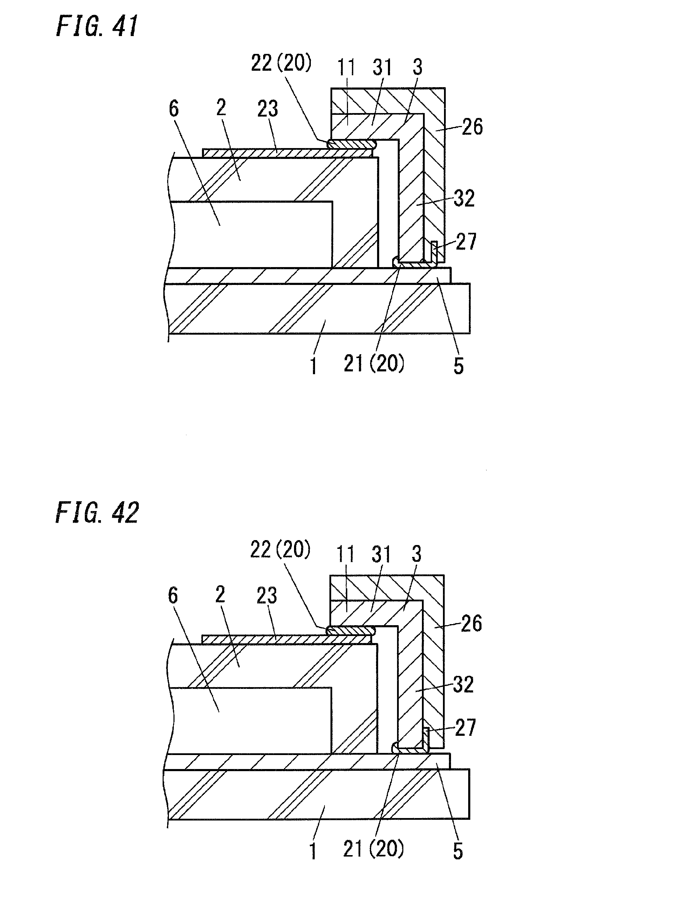

The specific embodiment of **FIG. 41** includes the space **27** which is provided to the electrically insulating cover **26** so as to have the opening directed to the substrate **1.** In other words, the space **27** is formed in the front end, facing the substrate **1,** of the electrically insulating cover **26.** This space **27** is formed by partially dividing the front end of the electrically insulating cover **26** in the lateral direction. The electrically insulating cover **26** includes the space **27** and consequently it is possible to, by use of capillarity, make the electrically conductive paste **20** intrude into the space **27.** Therefore, the electrically conductive paste **20** can be prevented from flowing out.

The specific embodiment of **FIG. 42** includes the space **27** which is provided between the electrode piece **3** and the electrically insulating cover **26** so as to have the opening directed to the substrate **1.** In other words, the space **27** is formed by spacing front end parts of the electrode piece **3** and the electrically insulating cover **26.** This space **27** may be formed by not bonding the front end parts of the electrode piece **3** and the electrically insulating cover **26.** The electrically insulating cover **26** includes the space **27** between the electrode piece **3** and the electrically insulating cover **26,** and consequently it is possible to, by use of capillarity, make the electrically conductive paste **20** intrude into the space **27.** Therefore, the electrically conductive paste **20** can be prevented from flowing out.

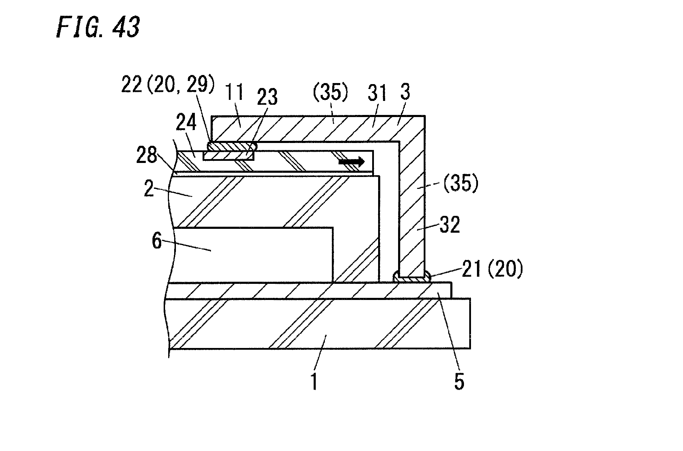

**FIG. 43** shows an example of the embodiment of the organic EL element. The same configurations as the above embodiment are designated by the same reference signs as the above embodiment and their explanations are omitted. In **FIG. 43** and subsequent figures, preferable embodiments of the organic EL element including the wiring board **24** are described.

In the above embodiment of **FIG. 10****,** the structure of allowing electrical connection with electrodes through the wiring board **24** is described. In this regard, in a case of using the wiring board **24,** thermal expansion or thermal contraction of the wiring board **24** may frequently occur. For example, when temperature rises due to heat generation by operation of the organic EL element, the wiring board **24** is likely to expand by heat. When thermal expansion occurs, tension or the like is likely to act on the electrode piece **3** and consequently contact failure of the electrode piece **3** may occur, or part formed by curing the electrically conductive paste **20** (the electrically conductive fixer **21** and/or the electrically conductive bond **22)** may be broken. Hence, it is preferable to improve the electric connectability. Especially, in the above embodiment, when the wiring board **24** is made of resin material, silicon material, a ceramic substrate, or the like, and the enclosing member **2** is made of glass, the wiring board **24** and the enclosing member **2** are made of different materials, and therefore a problem thermal expansion or contraction may be easily occur. This is because thermal expansion coefficients are different. In view of this, preferable ones of the specific embodiments including the wiring board **24** are described.

In the specific embodiment of **FIG. 43****,** as with the specific embodiment of **FIG. 10****,** the structure of allowing electrical connection with the electrodes is formed by use of the wiring board **24.** The specific embodiment of **FIG. 43** is different from the specific embodiment of **FIG. 10** in that the supported piece **31** extends inward so that the supported piece **31** is electrically connected to the interconnection electrode extension part **23** formed close to the center of the wiring board **24.** The interconnection electrode extension part **23** may include an electrode to be electrically connected to an external power source, and this electrode may be exposed on the wiring board **24** at a different position from a part connected to the supported piece **31,** and is connected to this part through a wiring circuit of the wiring board **24.** By elongating the supported piece **31,** it is possible to improve the degree of fixing of the electrode piece **3** and also improve the degree of freedom of wiring circuit design. Note that, in **FIG. 43****,** the wiring board **24** is bonded to the enclosing member **2** with bonding material, and this bonding material forms a wiring board bonding layer **28.**

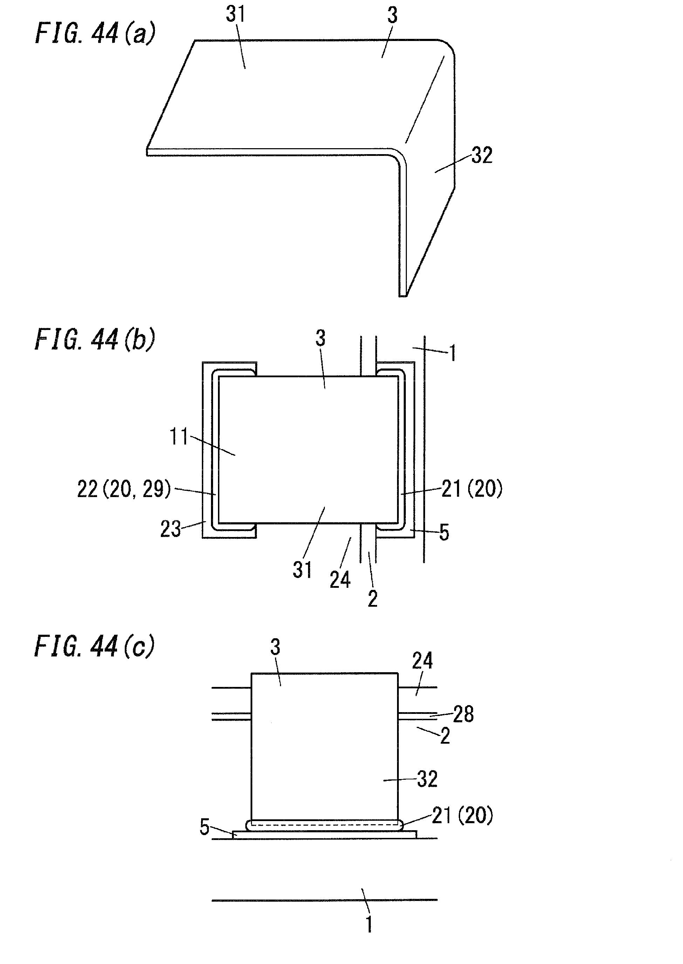

**FIG. 44(a)** shows an example of the electrode piece **3** used in the organic EL element of the specific embodiment of **FIG. 43****.** In this electrode piece **3,** the supported piece **31** and the fixed piece **32** are formed as flat pieces. **FIG. 44(b)** and **FIG. 44(c)** show the organic EL element formed by use of the electrode piece 3 of **FIG. 44(a). FIG. 44(b)** shows a structure including the electrode piece **3** and its surroundings when viewed from the wiring board **24** side in a direction perpendicular to the surface of the substrate **1.** **FIG. 44(c)** shows a structure including the electrode piece **3** and its surroundings with regard to the side part of the organic EL element when viewed in a direction parallel to the surface of the substrate **1.** In the electrode piece **3** of **FIG. 44(a)****,** when the temperature rises and thermal expansion occurs at the wiring board **24,** load acts on the electrode piece **3,** and such load may cause loss in the electric connectability. The thermal expansion may occur in a direction parallel to the surface of the substrate **1.** Therefore, the thermal expansion in the wiring board **24** may occur in an in-plane direction. In **FIG. 43****,** a direction of the thermal expansion in the wiring board 24 is indicated by a black arrow.

In view of this, it is preferable that the electrode piece 3 include a stress relaxation structure 35 for relaxing stress in a direction parallel to the surface of the substrate 1. The stress relaxation structure 35 may be a structure of allowing expansion and contraction of the electrode piece 3. In more detail, the stress relaxation structure 35 may be considered as a structure allowing change in size of the electrode piece 3 in an expansion direction with keeping the electric conductivity. The electrode piece 3 includes the stress relaxation structure 35, and therefore thermal deformation caused by thermal expansion or thermal contraction of the wiring board 24 can be absorbed, and connection failure of the electrode piece **3** can be reduced and consequently the electric reliability of the organic EL element can be improved. The modification of the electrode piece **3** may be slight modification for absorbing stress.

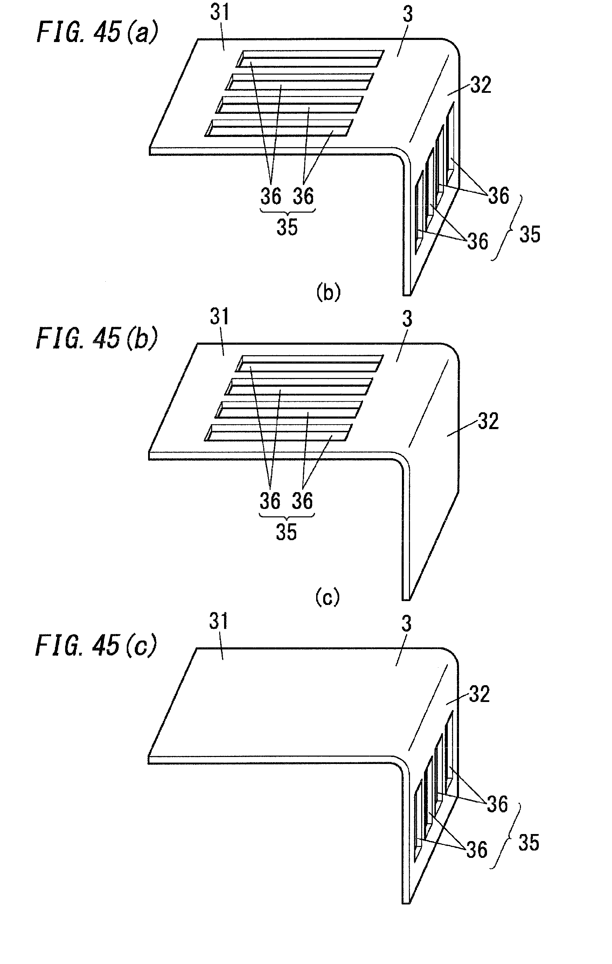

**FIG. 45(a), FIG. 45(b)** and **FIG. 45(c)** show examples of the electrode piece **3** having the stress relaxation structure **35.** In these specific embodiments, the stress relaxation structure **35** is constituted by openings **36** provided to the electrode piece 3. When the openings **36** are provided, deformation of the electrode piece **3** can be facilitated, and thus stress can be relaxed efficiently. The number of openings **36** may be one, but it is more preferable that there are a plurality of openings **36.** In this case, stress can be more relaxed. The opening **36** is provided as a hole penetrating through the electrode piece **3** in a thickness direction. It is preferable that the openings **36** be an elongated hole extending along the extending direction of the electrode piece 3. In this case, stress can be relaxed easily. In the specific embodiments of **FIG. 45****,** the openings **36,** which are elongated holes, are arranged side by side in a width direction of the electrode piece **3** at regular intervals. The opening **36** may be a hole with a slit shape.

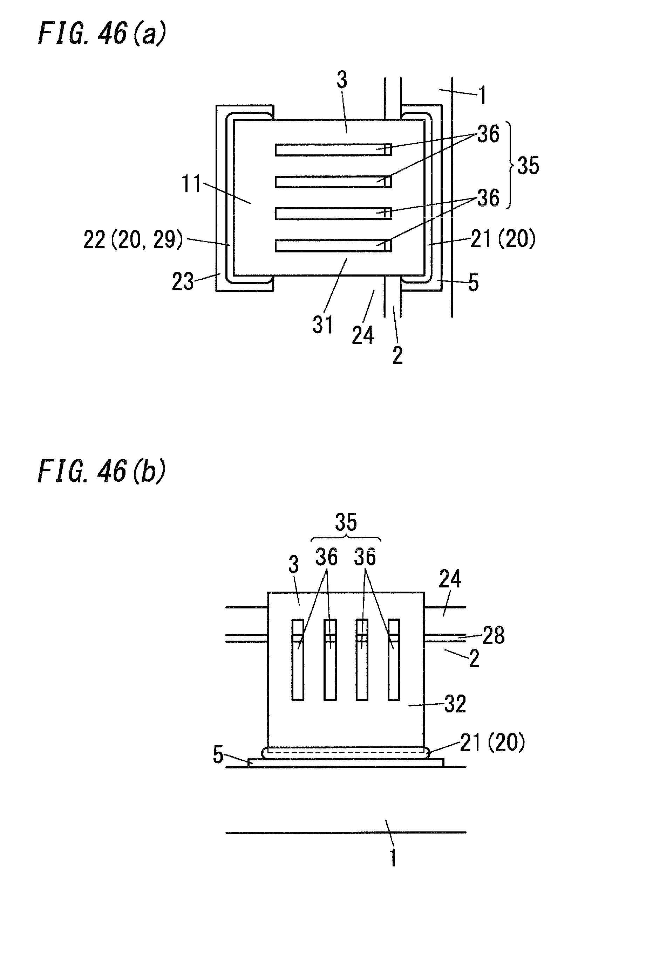

In the electrode piece **3** of **FIG. 45(a)****,** the openings **36** are provided to both the supported piece **31** and the fixed piece **32.** In this case, stress can be highly relaxed. In a case of using the electrode piece **3** of **FIG. 45(a)****,** part including the electrode piece **3** and its surroundings has a structure with a section shown in **FIG. 43****,** and therefore it is possible to obtain the organic EL element which shows a plan view illustrated in **FIG. 46(a)** and a side view illustrated in FIG. **46(b)****.**

In the electrode piece **3** of **FIG. 45(b)****,** the openings **36** are provided to the supported piece **31** but are not provided to the fixed piece **32.** In this case, slight deformation of the electrode piece **3** is allowed, and therefore stress can be relaxed. In a case of using the electrode piece **3** of **FIG. 45(b)****,** part including the electrode piece **3** and its surroundings has a structure with a section shown in **FIG. 43****,** and therefore it is possible to obtain the organic EL element which shows a plan view illustrated in **FIG. 46(a)** and a side view illustrated in **FIG. 44(c)****.**

In the electrode piece **3** of **FIG. 45(c)****,** the openings **36** are provided to the fixed piece **32** but are not provided to the supported piece **31.** In this case, slight deformation of the electrode piece **3** is allowed, and therefore stress can be relaxed. In a case of using the electrode piece **3** of **FIG. 45(c)****,** part including the electrode piece **3** and its surroundings has a structure with a section shown in **FIG. 43****,** and therefore it is possible to obtain the organic EL element which shows a plan view illustrated in **FIG. 44(b)** and a side view illustrated in **FIG. 46(b)****.**

The specific embodiment of **FIG. 45(a)** includes deformation regions of the electrode piece **3** more than the specific embodiments of **FIG. 45(b)** and **FIG. 45(c)****,** and therefore gives an advantage of more improving deformation and contraction properties. In contrast, in FIG. 45(b) and FIG. 45(c), the openings 36 are provided to only one piece, and therefore there is an advantage that the production can be facilitated and the strength of the electrode piece 3 can be improved. Further, in FIG. 45(c), the supported piece 31 does not include openings, and therefore in a process of attaching the electrode piece 3, the supported piece 31 can be easily bonded to the wiring board 24, and consequently the production can be facilitated.

In each of the electrode pieces 3 of FIG. 45, the four openings 36 are provided to one piece which is the supported piece 31 or the fixed piece 32. The number of openings 36 is not limited thereto, and may be one, or two or three, or five or more. Note that, it is preferable that the opening **36** be not formed at the boundary portion between the supported piece **31** and the fixed piece **32.** By doing so, it is possible to suppress a decrease in the strength of the electrode piece **3.**

The openings **36** can be formed by cutting out, by punching, a metal plate constituting the electrode piece **3,** for example. Alternatively, in a process of bending the electrode piece **3,** the electrode piece **3** may be punched with molding.

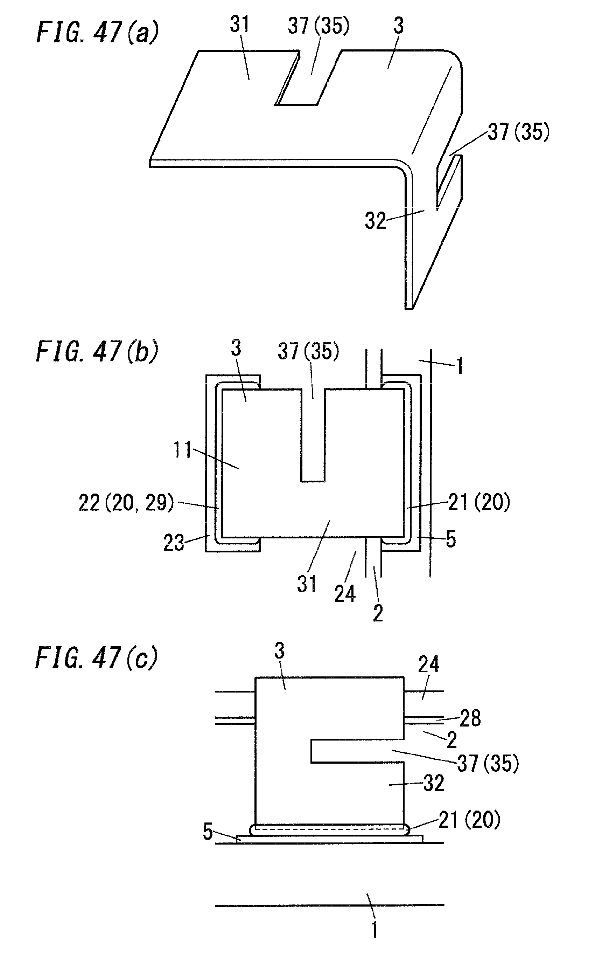

**FIG. 47(a)** shows another example of the electrode piece **3** including the stress relaxation structure **35.** **FIG. 47(b)** and **FIG. 47(c)** show a structure including the electrode piece **3** and its surroundings of the organic EL element formed by use of the electrode piece **3** of **FIG. 47(a). FIG. 47(b)** is a plan view and **FIG. 47(c)** is a side view.

In the present specific embodiment, the stress relaxation structure **35** is constituted by a cut-out **37** provided to the electrode piece **3.** The cut-out **37** is formed as a slit obtained by cutting out along the width direction of the electrode piece **3** (direction perpendicular to the extending direction). When the cut-out **37** are provided, deformation of the electrode piece **3** can be facilitated, and thus stress can be relaxed efficiently. Note that, the present specific embodiment has the same sectional structure as that of **FIG. 43****.**

In the electrode piece **3** of **FIG. 47(a)****, one** cut-out **37** is provided for each of the supported piece **31** and the fixed piece **32.** The cut-out **37** may be provided to either the supported piece **31** or the fixed piece **32.** Also in this case, slight deformation of the electrode piece **3** is allowed, and therefore stress can be relaxed. The cut-out **37** is provided by dividing the side part (end part in a direction perpendicular to the extending direction) of the electrode piece **3,** and thus the electrode piece **3** is more easily deformed in the extending direction. Therefore, a deformation absorbing property can be improved, and the electric reliability of the organic EL element can be improved.

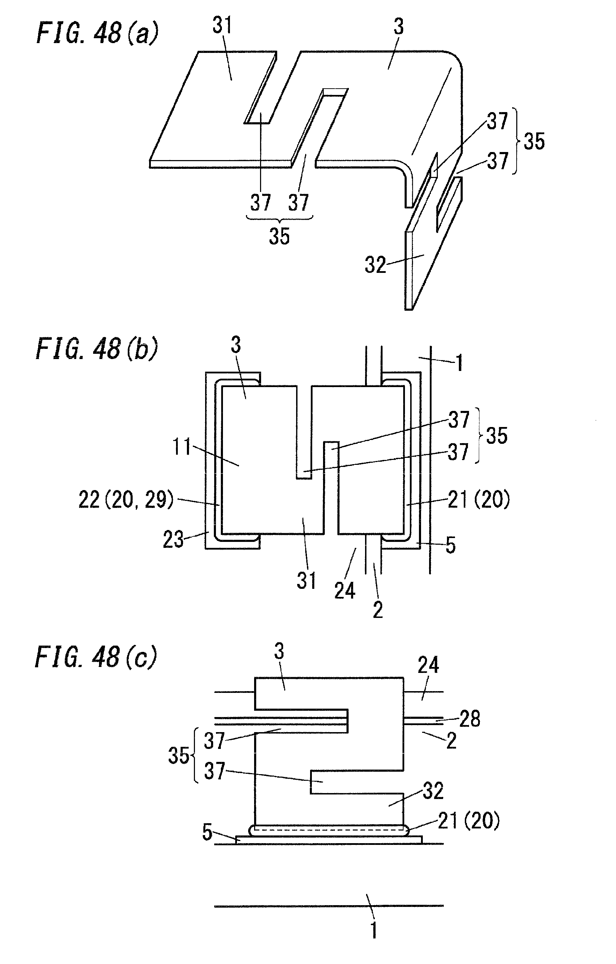

**FIG. 48(a)** shows another example of the electrode piece **3** including the stress relaxation structure 35. **FIG. 48(b)** and **FIG. 48(c)** shows a structure including the electrode piece **3** and its surroundings of the organic EL element formed by use of the electrode piece **3** of **FIG. 48(a). FIG. 48(b)** is a plan view and **FIG. 48(c)** is a side view.

In the present specific embodiment, the stress relaxation structure **35** is constituted by a plurality of cut-outs **37** provided to the electrode piece **3.** Further, the plurality of cut-outs **37** are provided so that the electrode piece **3** includes an S-shaped part. Also in the present specific embodiment, the cut-out **37** is formed as a slit obtained by cutting out along the width direction of the electrode piece **3** (direction perpendicular to the extending direction). When the cut-out **37** is provided, deformation of the electrode piece **3** can be facilitated, and thus stress can be relaxed efficiently. Further, the electrode piece **3** includes the S-shaped part, and therefore deformation in the extending direction can be facilitated and an effect of relaxing stress can be more improved. This is because elasticity of a part with a spring shape is improved to make deformation easy by forming cut-outs at opposite ends in the width direction instead of forming a cut-out at one of the opposite ends.

The number of cut-outs **37** provided to the electrode piece **3** may be one, or two or more. When a plurality of cut-outs **37** is provided, stress can be more relaxed. Further, in a case of providing a plurality of cut-outs **37,** when the plurality of cut-outs **37** are provided so as to form an S-shaped part like **FIG. 48(a)****,** the deformation absorption property can be improved efficiently. A plurality of cut-outs may be provided at one end. Note that, when three or more cut-outs **37** are provided for one piece (the supported piece **31** and/or the fixed piece **32),** it is preferable that the opposite ends of the electrode piece **3** in the width direction be cut out alternately. In this case, the electrode piece **3** is zigzag. The electrode piece 3 may have such a shape that two or more S-shaped parts are connected.

In the electrode piece **3** of **FIG. 48(a)****,** a set of two cut-outs **37** is provided for each of the supported piece **31** and the fixed piece **32.** The cut-out **37** may be provided to either the supported piece **31** or the fixed piece **32.** Also in this case, slight deformation of the electrode piece **3** is allowed, and therefore stress can be relaxed.

The cut-out **37** can be formed by cutting out, by punching, a metal plate constituting the electrode piece **3,** for example. Alternatively, in a process of bending the electrode piece **3,** the electrode piece **3** may be punched with molding.

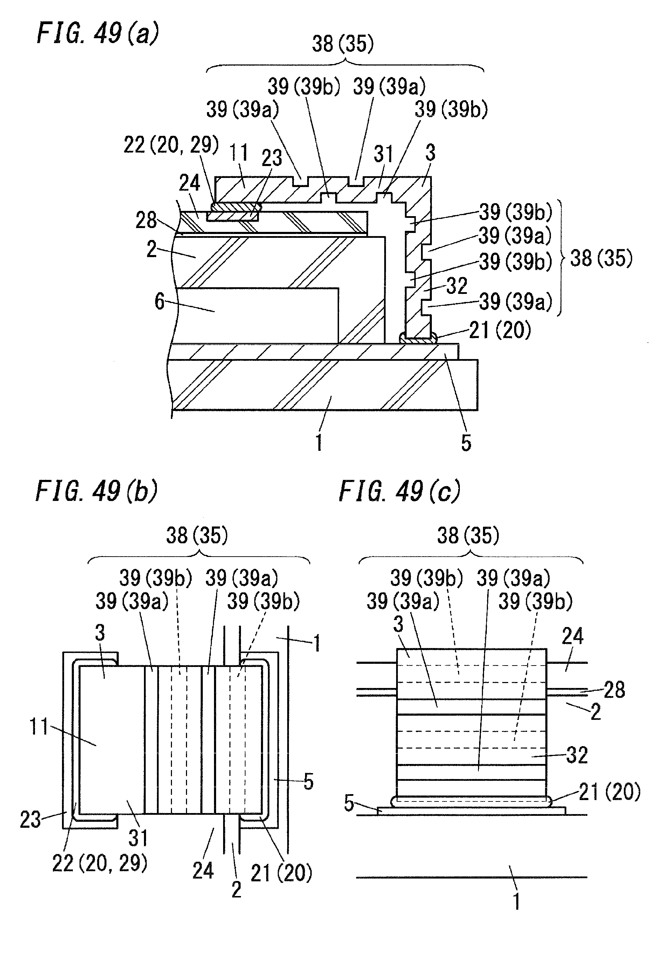

**FIG. 49** shows the organic EL element formed by use of another example of the electrode piece **3** including the stress relaxation structure **35,** and **FIG. 49(a)** is a sectional view, and **FIG. 49(b)** is a plan view, and **FIG. 49(c)** is a side view. In the present specific embodiment, the stress relaxation structure **35** is constituted by a wavy structure **38** provided to the electrode piece **3.** When the wavy structure **38** is provided, deformation of the electrode piece **3** can be facilitated, and thus stress can be relaxed efficiently. Further, when the electrode piece **3** is wavy, one or more parts with an S-shaped section are formed, and therefore deformation in the extending direction can be facilitated and an effect of relaxing stress can be more improved. The electrode piece 3 becomes corrugated, and deformable in the extending direction.

In the present specific embodiment, the wavy structure **38** is constituted by a plurality of recesses **39** which have a slit like shape formed by cutting in the thickness direction so as to extend the entire length in the width direction. The plurality of recesses **39** include an external recess **39a** formed by setting back the surface, facing the outside, of the electrode piece **3,** and an internal recess **39b** formed by setting back the surface, facing the inside, of the electrode piece **3.** The external recesses **39a** and the internal recesses **39b** are arranged alternately in the extending direction. In this case, the electrode piece **3** includes recesses and protrusions. In **FIG. 49(b)** and **FIG. 49(c)****,** the recesses **39** which are concealed are illustrated by broken lines.

The wavy structure **38** may be provided to either the supported piece **31** or the fixed piece **32.** Also in this case, slight deformation of the electrode piece **3** is allowed, and therefore stress can be relaxed. However, it is preferable that the wavy structure **38** be provided to each of the supported piece **31** and the fixed piece **32.** In this case, deformation can be facilitated.

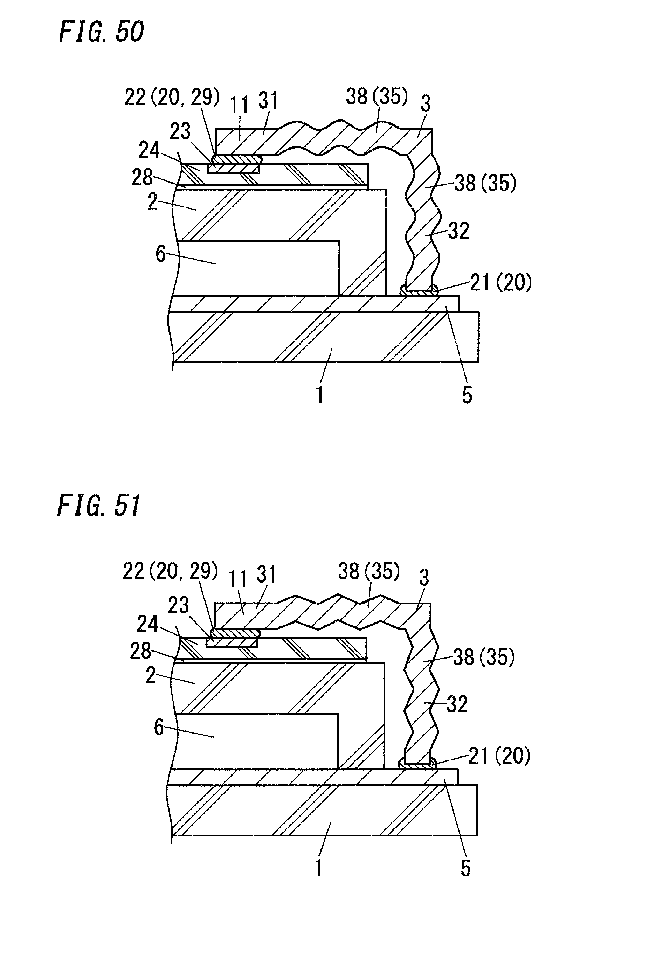

**FIG. 50** shows another example of the organic EL element formed by use of the electrode piece **3** including the stress relaxation structure **35** constituted by the wavy structure **38.** In the present specific embodiment, the wavy structure **38** is formed by shaping a metal piece constituting the electrode piece **3** into a curved wave proceeding in the extending direction. In the present specific embodiment, for example, the wavy structure **38** can be easily provided to the electrode piece **3** by press working. When the wavy structure **38** is provided, deformation of the electrode piece **3** can be facilitated, and thus stress can be relaxed efficiently. The wavy structure **38** may be provided to either the supported piece **31** or the fixed piece **32.** One of wave-like parts constituting the wavy structure **38** may have a semicircular section.

**FIG. 51** shows another example of the organic EL element formed by use of the electrode piece **3** including the stress relaxation structure **35** constituted by the wavy structure **38.** In the present specific embodiment, the wavy structure **38** is formed by shaping a metal piece constituting the electrode piece **3** into a sawtooth wave proceeding in the extending direction. In the present specific embodiment, for example, the wavy structure **38** can be easily provided to the electrode piece **3** by press working. When the wavy structure **38** is provided, deformation of the electrode piece **3** can be facilitated, and thus stress can be relaxed efficiently. The wavy structure **38** may be provided to either the supported piece **31** or the fixed piece **32.** One of wave-like parts constituting the wavy structure **38** may have a triangular section.

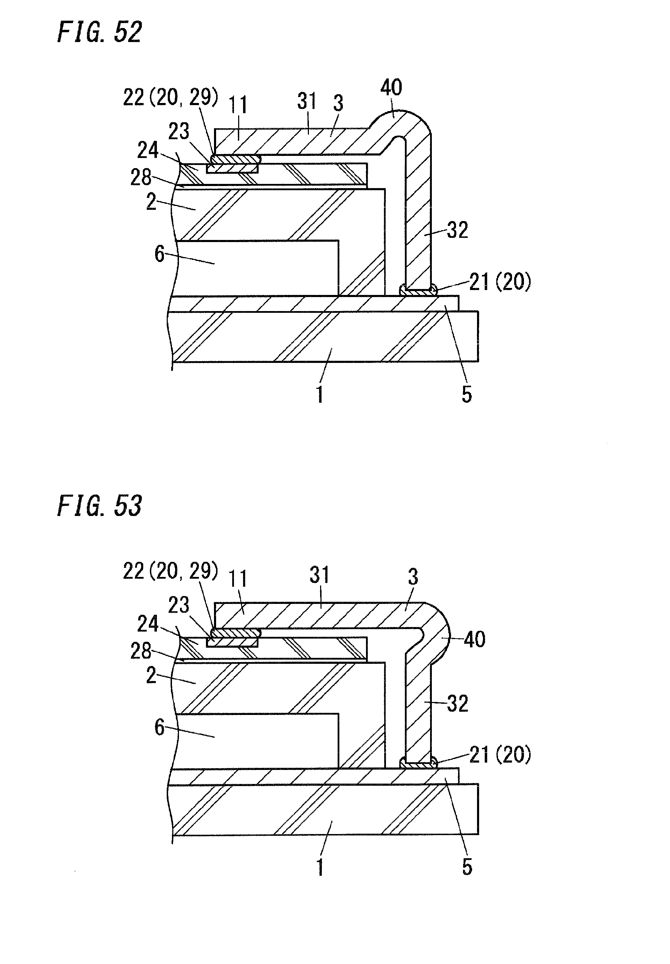

**FIG. 52** and **FIG. 53** each show another example of the organic EL element formed by use of the electrode piece **3** including the stress relaxation structure **35** constituted by the wavy structure **38.** In each of these present specific embodiments, the stress relaxation structure **35** is realized by a bend **40** which is part of the electrode piece **3** and defines a border between a part along a direction normal to the surface of the substrate **1** and a part along a direction parallel to the surface of the substrate **1** and protrudes outward from the surface of the electrode piece **3.** In other words, the bend **40** which is a boundary portion between the fixed piece **32** and the supported piece **31** protrudes outward. The bend **40** protrudes outward, and therefore this bend **40** absorbs deformation and the electrode piece **3** can be slightly deformed as a whole. Consequently, stress can be relaxed. Note that, by protruding the bend **40,** a protrusion is formed on the electrode piece **3.**

In the specific embodiment of **FIG. 52****,** the bend **40** protrudes in an opposite direction from a direction toward the substrate **1.** In the specific embodiment of **FIG. 53****,** the bend **40** protrudes from the side part. In these specific embodiments, the stress relaxation structure **35** can be easily formed by bending the electrode piece **3.** In the specific embodiment of **FIG. 52****,** the bend **40** does not protrude from the side part, and therefore the specific embodiment of **FIG. 52** is of advantage to decrease the non-light emitting region. Further, the specific embodiment of **FIG. 52** is of advantage to increase the insulating distance between the adjacent organic EL elements. In contrast, in the specific embodiment of **FIG. 53****,** the electrode piece **3** does not protrude from the opposite surface (rear surface) from the light emitting surface, and therefore the specific embodiment of **FIG. 52** is of advantage to thinning.

Besides, an aspect in which the stress relaxation structure **35** is provided to the electrode piece **3** is effective even in a case of the organic EL element devoid of the wiring board **24.** Further, the electrode piece **3** including the stress relaxation structure **35** can be used in each of the above specific embodiments without the wiring board **24.** In this case, there is an advantage in a case of bonding the electrode piece **3** to the enclosing member **2.** Further, there is a more advantage in a case of bonding the electrode piece **3** by use of the electrically conductive paste **20** (at least one of the electrically conductive fixer **21** and the electrically conductive bond **22** is formed). When the stress relaxation structure **35** is provided, a difference in thermal contraction between the enclosing member **2** made of glass or the like and the electrode piece **3** constituted by a metal piece can be absorbed. This is because there is a difference in thermal contraction between a glass plate and a metal piece. Therefore, the electric connectability can be improved. However, stress may increase when the wiring board **24** is provided, and therefore the stress relaxation structure **35** is considered as being of advantage when the wiring board **24** is provided.

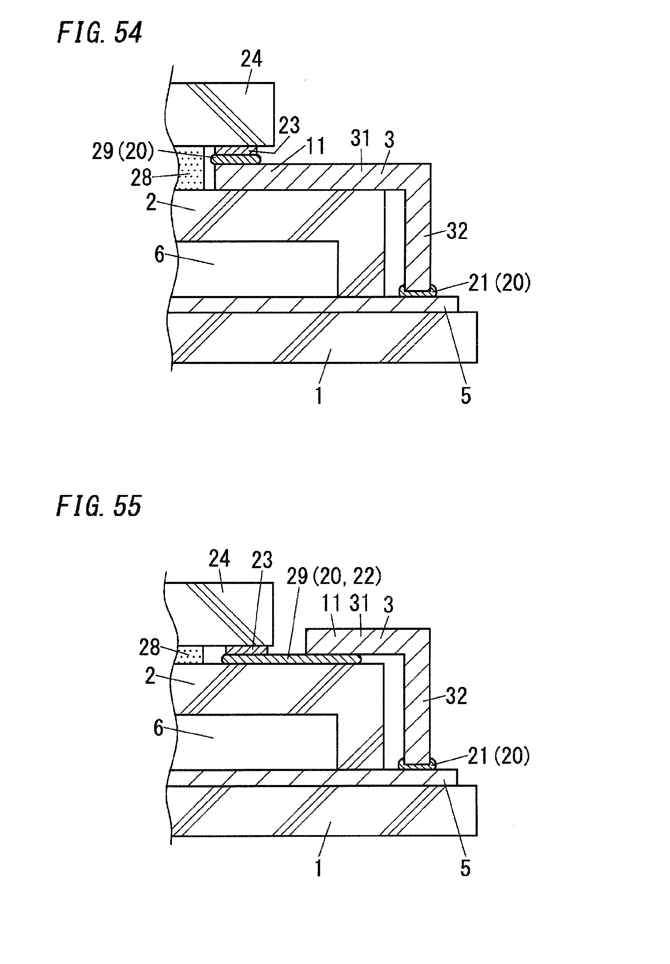

**FIG. 54** shows an example of the embodiment of the organic EL element. The same configurations as the above embodiment are designated by the same reference signs as the above embodiment and their explanations are omitted. The following explanation with reference to **FIG. 54** is made to another aspect capable of suppressing connection failure of the electrode piece **3** which would otherwise occur due to thermal expansion of the wiring board **24.** In the present specific embodiment, as with the specific embodiment of **FIG. 10****,** the structure of allowing electrical connection with electrodes is formed by use of the wiring board **24.**

In the present specific embodiment, the interconnection electrode extension part **23** is provided to the surface of the wiring board **24** facing the enclosing member **2.** The interconnection electrode extension part **23** is disposed to a position of overlapping the enclosing member **2** in a plan view. In the present specific embodiment, the electrode piece **3** and the interconnection electrode extension part **23** are interconnected at the surface facing the enclosing member **2** which is not likely to suffer from warp due to thermal expansion. Therefore, an amount of deformation caused by thermal expansion can be reduced and the connection reliability can be improved. In more detail, the wiring board **24** is bonded to the enclosing member **2** with the wiring board bonding layer **28.** In view of comparison in a thermal expansion amount between the outside facing surface and the inside facing surface of the wiring board **24,** the inside facing surface which is a surface to be bonded to the enclosing member **2** shows a less thermal expansion amount. Therefore, by making electric connection with the electrode piece **3** at the surface of the wiring board **24** which is more unlikely to be deformed, breakage of electrical connection due to the thermal expansion is suppressed, and the connection reliability can be improved.

In the specific embodiment of **FIG. 54****,** the wiring board bonding layer **28** acts as a spacer for forming a space for accommodating the electrode piece **3.** A region on which the surface of the wiring board **24** facing the enclosing member **2** is exposed is formed more outward than the wiring board bonding layer **28** is, and the interconnection electrode extension part **23** is provided to this region. The interconnection electrode extension part **23** may be flush with the surface of the body of the wiring board **24.**

It is preferable that the interconnection electrode extension part **23** be electrically connected to the electrode piece **3** with the electrically conductive connector **29** made of electrically conductive material. In this case, the connection reliability can be improved. In the present specific embodiment, the interconnection electrode extension part **23** and the supported piece **31** of the electrode piece **3** are interconnected with the electrically conductive connector **29** made of the electrically conductive paste **20.** The electrically conductive connector **29** may be provided between the enclosing member **2** and the electrode piece **3** so as to be used as the electrically conductive bond **22** having a function of bonding the electrode piece **3** to the enclosing member **2.**

In the present specific embodiment, the interconnection electrode **11** and the interconnection electrode extension part **23** overlap in a plan view. Therefore, the electric connectability can be improved.

**FIG. 55** shows an example of the embodiment of the organic EL element. The same configurations as the above embodiment are designated by the same reference signs as the above embodiment and their explanations are omitted.

In the present specific embodiment, the wiring board **24** is disposed more inward than the electrode piece **3** in a plan view. The interconnection electrode extension part **23** is provided to the surface of the wiring board **24** facing the enclosing member **2.** Further, the interconnection electrode extension part **23** and the electrode piece **3** are electrically connected with the electrically conductive connector **29** made of the electrically conductive paste **20.** The electrically conductive connector **29** is formed to extend along the surface of the enclosing member **2,** and intrudes into a space between the wiring board **24** and the enclosing member **2** and a space between the supported piece **31** and the enclosing member **2.** The electrically conductive connector **29** is also used as the electrically conductive bond **22** for bonding the electrode piece **3** to the enclosing member **2.**

In the present specific embodiment, the electrode piece 3 and the interconnection electrode extension part **23** are interconnected at the surface facing the enclosing member **2** which is not likely to suffer from warp due to thermal expansion. Therefore, deformation caused by thermal expansion can be absorbed and the connection reliability can be improved.

In the present specific embodiment, as shown in **FIG. 55****,** the interconnection electrode extension part **23** and the electrode piece **3** do not overlap in a plan view. The interconnection electrode extension part **23** is disposed more inward than the electrode piece **3** in a plan view. Further, the wiring board **24** and the electrode piece **3** do not overlap in a plan view. The electrode piece **3** and the wiring board **24** do not overlap in a thickness direction and therefore thinning can be achieved.

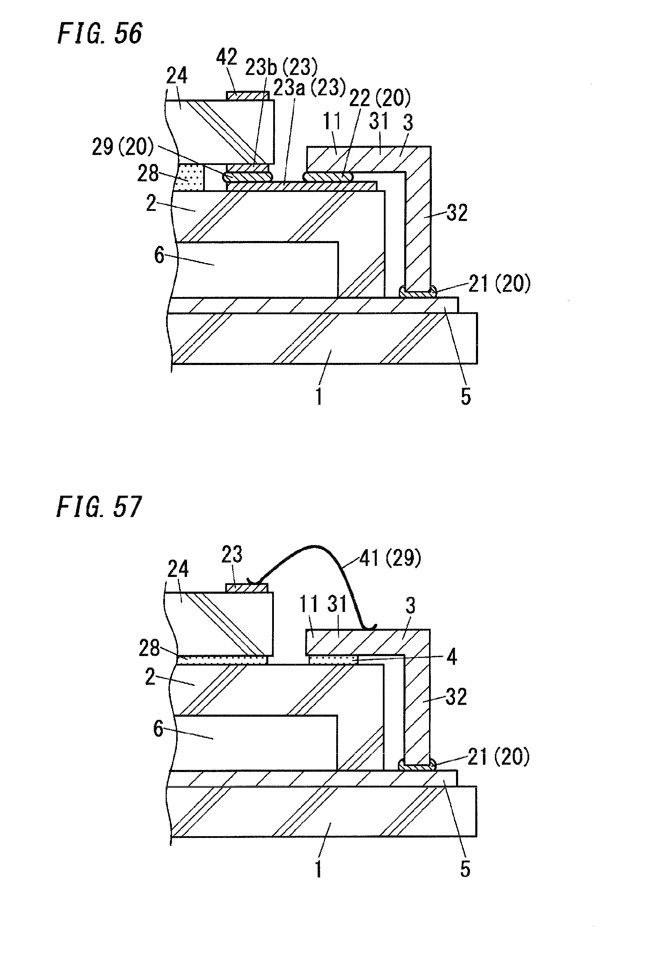

**FIG. 56** shows an example of the embodiment of the organic EL element. The same configurations as the above embodiment are designated by the same reference signs as the above embodiment and their explanations are omitted.

In the present specific embodiment, the wiring board **24** is disposed more inward than the electrode piece **3** in a plan view. Further, the interconnection electrode extension part **23** is constituted by a first interconnection electrode extension part **23a** provided to the surface of the enclosing member 2 and a second interconnection electrode extension part **23b** provided to the surface of the wiring board **24** facing the enclosing member **2.** The first interconnection electrode extension part **23a** and the second interconnection electrode extension part **23b** are electrically interconnected with the electrically conductive connector **29** made of the electrically conductive paste **20.** The electrode piece **3** is bonded to the first interconnection electrode extension part **23a** formed on the surface of the enclosing member **2** with the electrically conductive bond **22.**

In the present specific embodiment, the electrode piece **3** and the interconnection electrode extension part **23** are interconnected at the surface facing the enclosing member **2** which is not likely to suffer from warp due to thermal expansion. Therefore, deformation caused by thermal expansion can be absorbed and the connection reliability can be improved.

In the present specific embodiment, as shown in **FIG. 56****,** the interconnection electrode extension part **23** and the electrode piece **3** do not overlap in a plan view. The interconnection electrode extension part **23** is disposed more inward than the electrode piece **3** in a plan view. Further, the wiring board **24** and the electrode piece **3** do not overlap in a plan view. The electrode piece **3** and the wiring board **24** do not overlap in a thickness direction and therefore thinning can be achieved. Further, electrical connection can be made by use of the first interconnection electrode extension part **23a** formed on the surface of the enclosing member **2,** and therefore the structure of allowing electrical connection with electrodes can be easily formed and the connection reliability can be improved. Note that, the first interconnection electrode extension part **23a** may be made of plating or the like.

Note that, an electrode layer **42** is formed on the opposite surface of the wiring board **24** from the enclosing member **2.** The electrode layer **42** is electrically connected to the interconnection electrode extension part **23** with an internal wiring structure of the wiring board **24.** Therefore, connection with an external power source can be done by the electrode layer **42.**

**FIG. 57** shows an example of the embodiment of the organic EL element. The same configurations as the above embodiment are designated by the same reference signs as the above embodiment and their explanations are omitted.

The specific embodiment of **FIG. 57** includes the wiring board **24** on the surface of the enclosing member **2,** and the interconnection electrode extension part **23** is provided to the surface of the wiring board **24.** In the present specific embodiment, the interconnection electrode extension part **23** is provided to the opposite surface of the wiring board **24** from the substrate **1.** The interconnection electrode extension part **23** may be provided to the surface of the wiring board **24** facing the enclosing member **2.** However, in the present specific embodiment, when the interconnection electrode extension part **23** is provided to the opposite surface from the substrate **1,** wiring connection can be facilitated. The wiring board **24** is disposed more inward than the enclosing member **2** in a plan view. The electrode piece **3** is bonded to the enclosing member **2.** Further, the electrode piece **3** and the interconnection electrode extension part **23** are electrically interconnected with a flexible electric conductor **41** constituting the electrically conductive connector **29.** The flexible electric conductor **41** is made of flexible electrically conductive material. Connection is made by the flexible electric conductor **41,** and therefore when the thermal expansion occurs, stress can be absorbed and relaxed by deformation of the flexible electric conductor **41.** Consequently, the electric reliability can be improved. Note that, the electrode piece **3** is bonded with the electrode piece supporter **4** which is formed as a result of curing of bonding material. However, the electrode piece **3** may be bonded with the electrically conductive paste **20.**

It is preferable that the flexible electric conductor **41** be an electrically conductive linear material. For example, the flexible electric conductor **41** may be a wire. In a case of using the wire, electrical connection with high connectability can be achieved easily. Connection between the electrode piece **3** and the wire and between the interconnection electrode extension part **23** and the wire can be achieved by use of wire bonding or ribbon bonding.

### Reference Signs List

- **1**: Substrate
- **1a**: Stepped Part
- **2**: Enclosing Member
- **3**: Electrode Piece
- **4**: Electrode Piece Supporter
- **5**: Extended Electrode Part
- **6**: Enclosed Space
- **7**: First Electrode
- **8**: Organic Light Emitting Layer
- **9**: Second Electrode
- **10**: Organic Light Emitter
- **11**: Interconnection Electrode
- **12**: Terminal
- **13**: Protrusion
- **14**: Elastic Member
- **15**: Housing
- **16**: Electrically Insulating Barrier Member
- **17**: Bonding Layer
- **18**: Resin Part
- **20**: Electrically Conductive Paste
- **21**: Electrically Conductive Fixer
- **22**: Electrically Conductive Bond
- **23**: Interconnection Electrode Extension Part
- **24**: Wiring Board
- **25**: Electrically Insulating Wall
- **26**: Electrically Insulating Cover
- **26a**: Electrically Insulating Protrusion
- **27**: Space
- **28**: Wiring Board Bonding Layer
- **29**: Electrically Conductive Connector
- **31**: Supported Piece
- **32**: Fixed Piece
- **33**: Face Contact Piece
- **34**: Terminal Piece
- **35**: Stress Relaxation Structure
- **36**: Opening
- **37**: Cut-out
- **38**: Wavy Structure
- **39**: Recess
- **40**: Bend
- **41**: Flexible Electric Conductor
- **100**: Lighting Panel

## Claims

1. An organic electroluminescence element, comprising:
a substrate with a surface;
an organic light emitter which is formed on the surface of the substrate and includes a first electrode, an organic light emitting layer, and a second electrode in this order from the substrate; and
an enclosing member which is bonded to the substrate to enclose the organic light emitter by covering the organic light emitter,
the organic electroluminescence element further comprising:
an extended electrode part which is electrically connected to at least one of the first electrode and the second electrode and extends outward across the enclosing member so as to be on a surface of an end part of the substrate; and
at least one electrode piece which serves as an interconnection electrode and is provided on an opposite side of the enclosing member from the substrate, and
the at least one electrode piece including an extension part fixed to the extended electrode part so that the at least one electrode piece is electrically connected to the extended electrode part.

2. The organic electroluminescence element according to claim **1,** wherein:
a plurality of the electrode pieces provided to opposite end parts of the substrate; and
the plurality of electrode pieces are arranged in different positions in a horizontal direction in a plan view.

3. The organic electroluminescence element according to claim **1** or **2,** wherein:
an electrically insulating barrier member is provided to a side part of the substrate; and
the electrically insulating barrier member protrudes in a direction normal to the surface of the substrate relative to the extended electrode part.

4. The organic electroluminescence element according to claim **3,** wherein
the electrically insulating barrier member does not protrude in a direction normal to the surface of the substrate with regard to an opposite face of the substrate from a face to which the enclosing member is bonded.

5. The organic electroluminescence element according to claim **3** or **4,** wherein
a plurality of the electrode pieces are provided to a plurality of end parts of the substrate; and
the electrically insulating barrier member is provided to a side part of the substrate at a position of the end part with regard to half or more of the plurality of end parts of the substrate.

6. The organic electroluminescence element according to claim **3** or **4,** wherein
a plurality of the electrode pieces are provided to a plurality of end parts of the substrate; and
the electrically insulating barrier member is provided to a side part of the substrate corresponding to a position of the end part with regard to all of the plurality of end parts of the substrate.

7. The organic electroluminescence element according to any one of claims **3** to **6,** wherein
a space between the electrically insulating barrier member and the enclosing member is filled with resin.

8. The organic electroluminescence element according to any one of claims **3** to **7,** wherein
the electrically insulating barrier member protrudes in a direction normal to the surface of the substrate more than the at least one electrode piece.

9. The organic electroluminescence element according to any one of claims **1** to **8,** wherein
at least an outside surface of the extension part of the at least one electrode piece which extends towards the substrate is covered with an electrically insulating cover.

10. The organic electroluminescence element according to claim **9,** wherein
the electrically insulating cover has a thickness of 0.1 mm or more.

11. The organic electroluminescence element according to claim **9** or **10,** wherein
the electrically insulating cover protrudes towards the substrate relative to a front end of the extension part of the at least one electrode piece.

12. The organic electroluminescence element according to any one of claims **9** to **11,** further comprising a space which is provided to the extension part of the at least one electrode piece, the electrically insulating cover, or between the at least one electrode piece and the electrically insulating cover, and has an opening directed to the substrate.

13. The organic electroluminescence element according to any one of claims **9** to **12,** wherein
an electrically insulating protrusion of the electrically insulating cover which protrudes relative to a front end of the extension part of the at least one electrode piece extends outward.

14. The organic electroluminescence element according to any one of claims **1** to **13,** wherein
the extension part of the at least one electrode piece is fixed to the extended electrode part so as to be pressed against the extended electrode part.

15. The organic electroluminescence element according to any one of claims **1** to **14,** wherein
the extension part of the at least one electrode piece is fixed to the extended electrode part by an electrically conductive fixer made of electrically conductive paste.

16. The organic electroluminescence element according to claim **15,** wherein
the electrically conductive fixer is formed so as to be in contact with a surface of the extension part of the at least one electrode piece close to the enclosing member.

17. The organic electroluminescence element according to claim **15** or **16,** wherein
the electrically conductive fixer is formed so as to be in contact with a side face of the enclosing member.

18. The organic electroluminescence element according to any one of claims **15** to **17,** wherein
the at least one electrode piece is fixed to the enclosing member by an electrically conductive bond made of electrically conductive paste.

19. The organic electroluminescence element according to claim **18,** wherein
the electrically conductive fixer and the electrically conductive bond are interconnected.

20. The organic electroluminescence element according to claim **18** or **19,** wherein:
an interconnection electrode extension part is provided to a surface of the enclosing member; and
the at least one electrode piece is bonded to the interconnection electrode extension part by the electrically conductive bond.

21. The organic electroluminescence element according to any one of claims **15** to **20,** further comprising a wiring board on a surface of the enclosing member,
an interconnection electrode extension part being provided to a surface of the wiring board, and
the at least one electrode piece being electrically connected to the interconnection electrode extension part by an electrically conductive connector.

22. The organic electroluminescence element according to claim **21,** wherein:
the interconnection electrode extension part is provided to a surface of the wiring board close to the enclosing member; and
the interconnection electrode extension part is disposed in a position overlapping the enclosing member in a plan view.

23. The organic electroluminescence element according to claim **21** or **22,** wherein
the interconnection electrode extension part is disposed more inward than the at least one electrode piece in a plan view.

24. The organic electroluminescence element according to any one of claims **21** to **23,** wherein
the at least one electrode piece and the interconnection electrode extension part are electrically interconnected by a flexible electric conductor constituting the electrically conductive connector.

25. The organic electroluminescence element according to any one of claims **15** to **24,** wherein
an electrically insulating wall with electrically insulating properties is provided outside the extended electrode part with regard to the substrate.

26. The organic electroluminescence element according to claim **25,** wherein:
a stepped part is formed at a boundary part between the surface and a side face of the substrate so as to be positioned more outward than the extended electrode part;
the electrically insulating wall is formed in contact with a surface of the stepped part; and
the electrically conductive fixer is in contact with the electrically insulating wall.

27. The organic electroluminescence element according to any one of claims **1** to **26,** wherein
the at least one electrode piece has a stress relaxation structure for relaxing stress in a direction parallel to the surface of the substrate.

28. The organic electroluminescence element according to claim **27,** wherein
the stress relaxation structure is realized by an opening provided to the at least one electrode piece.

29. The organic electroluminescence element according to claim **27,** wherein
the stress relaxation structure is realized by a cut-out provided to the at least one electrode piece.

30. The organic electroluminescence element according to claim **27,** wherein:
the stress relaxation structure is realized by a plurality of cut-outs provided to the at least one electrode piece; and
the plurality of cut-outs are provided so that the at least one electrode piece includes an S-shaped part.

31. The organic electroluminescence element according to claim **27,** wherein:
the stress relaxation structure is realized by a wavy structure provided to the at least one electrode piece.

32. The organic electroluminescence element according to claim **27,** wherein
the stress relaxation structure is realized by a bend which is part of the at least one electrode piece and defines a border between a part along a direction normal to the surface of the substrate and a part along a direction parallel to the surface of the substrate and protrudes outward from a surface of the at least one electrode piece.

33. The organic electroluminescence element according to any one of claims **1** to **32,** wherein
the at least one electrode piece is formed so as to bend to be in contact with a surface and a side face of the enclosing member.

34. The organic electroluminescence element according to any one of claims **1** to **33,** wherein
the at least one electrode piece includes a terminal protruding outward relative to a position at which the at least one electrode piece is fixed to the extended electrode part.

35. The organic electroluminescence element according to any one of claims **1** to **34,** wherein
the at least one electrode piece and the extended electrode part are connected by crushing a plurality of protrusions with electrically conductive properties at a boundary part therebetween.

36. The organic electroluminescence element according to any one of claims **1** to **34,** wherein
the at least one electrode piece and the extended electrode part are connected with an elastic member with electrically conductive properties being compressed at or near a boundary part therebetween.

37. The organic electroluminescence element according to any one of claims **1** to **36,** wherein
the at least one electrode piece is formed as a single part.

38. The organic electroluminescence element according to any one of claims **1** to **37,** wherein
the at least one electrode piece is bonded to an opposite surface of the enclosing member from the substrate.

39. The organic electroluminescence element according to any one of claims **1** to **38,** wherein
the at least one electrode piece is fixed by being supported by an electrode piece supporter provided to an opposite surface of the enclosing member from the substrate.

40. The organic electroluminescence element according to any one of claims **1** to **39,** wherein:
the at least one electrode piece has a plate spring structure; and
an extension part of the at least one electrode piece is pressed against the extended electrode part by force caused by the plate spring structure.

41. An illumination device comprising the organic electroluminescence element according to any one of claims **1** to **40.**
